# EUROPEAN PATENT APPLICATION

(11) **EP 4 685 562 A1**
(43) Date of publication of application: **28.01.2026**
(21) Application number: 25188644.6
(22) Date of filing: 10.07.2025
(51) Int. Cl.: G03F 7/09

(54) **COMPOSITION FOR FORMING ORGANIC FILM, METHOD FOR FORMING ORGANIC FILM, AND PATTERNING PROCESS**

(30) Priority: 22.07.2024 JP 2024117069
(71) Applicant: SHIN-ETSU CHEMICAL CO., LTD., Tokyo 1000005 (JP)
(72) Inventor: Iwamori, Shohei, Niigata (JP); Kobayashi, Naoki, Niigata (JP); Kori, Daisuke, Niigata (JP)
(74) Representative: Schicker, Silvia

(57) **Abstract**

Provided is a composition for forming an organic film which has both embedding and planarization properties, and a method for forming an organic film and a patterning process using the composition. A composition for forming an organic film, containing: (A) an aromatic ring-containing resin; (B) a polymer containing a repeating unit containing a β-diketone structure represented by the following formula (1): 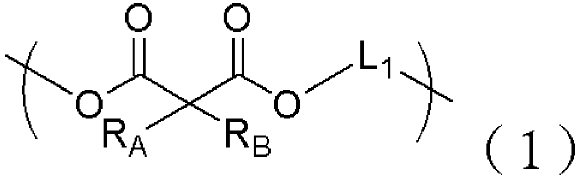 wherein L₁ is a saturated or unsaturated linear or branched divalent hydrocarbon group having 2 to 20 carbon atoms, R_{A} and R_{B} each are a hydrogen atom, a substituted or unsubstituted linear alkyl group having 1 to 20 carbon atoms, a substituted or unsubstituted branched or cyclic alkyl group having 3 to 20 carbon atoms, a substituted or unsubstituted aliphatic unsaturated hydrocarbon group having 2 to 20 carbon atoms and containing one or more double or triple bonds, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen group; and
(C) a solvent.

## Description

### TECHNICAL FIELD

The present invention relates to a composition for forming an organic film for forming an organic film for a multilayer resist for microprocessing in the manufacture of a semiconductor device or the like or an organic film for planarization in the manufacture of a semiconductor device or the like, a method for forming an organic film using the composition, and a patterning process using the composition.

### BACKGROUND ART

The high performance of the processing performance of semiconductor devices has been led by the miniaturization of the pattern dimensions by the shortening of the wavelength of the light source in the lithography technique. However, the sensitivity of short wavelengths has been declined since the ArF light source has been used, and high performance techniques in place of miniaturization are required. Thus, the development of techniques that can improve the performance of semiconductor devices by three-dimensionalizing the structure of the semiconductor devices and placing transistors at higher densities is progressing. In substrates of semiconductor devices having such a three-dimensional structure, a deeper and thinner structure is formed as a circuit pattern than prior substrates, so that a lithography technique optimized for the formation of a planar structure so far cannot have a practical process margin. Thus, it is necessary to secure the process margin by applying a material that can planarize the substrate on which the three-dimensional structure is formed to form a flat surface, and then patterning on the flat surface with a lithography technique.

As a technique that can form such a flat surface, many methods for forming a planarization film with a spin-coated organic film are already known (Patent Documents 1 to 5). However, an organic film formed of such a material is not always applied to all the patterns of substrates for manufacturing semiconductor devices. In addition, although the addition of a thermal decomposable polyacetal or the like has also been proposed (Patent Document 6), there is a concern that the thermal decomposition may induce shrinkage of the film, causing film formation failure and deterioration of embedding property. Furthermore, as a method of planarization, a method of planarizing by a chemical mechanical polishing (CMP) process after embedding unevenness on a substrate has been put into practical use (Patent Document 7), but CMP is a high-cost process. Under such circumstances, there is a need for a method for highly planarizing a substrate for manufacturing a semiconductor device at a low cost using an organic film.

### CITATION LIST

### PATENT LITERATURE

Patent Document 1: JP 2005-292528 A
Patent Document 2: JP 2008-65081 A
Patent Document 3: JP 2008-242492 A
Patent Document 4: JP 2014-24831 A
Patent Document 5: JP 2014-219559 A
Patent Document 6: WO 2008/026468 A1
Patent Document 7: JP 2004-335873 A

### SUMMARY OF INVENTION

### TECHNICAL PROBLEM

The present invention has been made in view of the foregoing, and an object of the present invention is to provide a composition for forming an organic film which has both advanced embedding and planarization properties, and a patterning process using the composition.

### SOLUTION TO PROBLEM

To solve the above problem, the present invention provides a composition for forming an organic film, containing:
(A) an aromatic ring-containing resin;
(B) a polymer containing a repeating unit containing a β-diketone structure represented by the following formula (1): 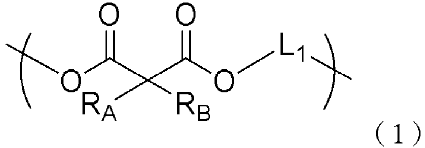 wherein L₁ is a saturated or unsaturated, linear or branched divalent hydrocarbon group having 2 to 20 carbon atoms, where the hydrocarbon group may be interrupted one or more times by an atom selected from oxygen, nitrogen and sulfur, R_{A} and R_{B} are the same or different from each other and each are a hydrogen atom, a substituted or unsubstituted linear alkyl group having 1 to 20 carbon atoms, a substituted or unsubstituted branched or cyclic alkyl group having 3 to 20 carbon atoms, a substituted or unsubstituted aliphatic unsaturated hydrocarbon group having 2 to 20 carbon atoms and containing one or more double or triple bonds, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen group; and
(C) a solvent.

When the composition contains an aromatic ring-containing resin such as (A), etching resistance and processing resistance are good. The polymer containing the β-diketone structure of (B) in a repeating unit can have fluidity by appropriately selecting the structure indicated by L₁ contained in the polymer main chain and embed uneven patterns after spin-coating. The fluidity is enhanced by heat, thus, when baked at a high temperature, the polymer flows more and can further improve the flatness of uneven surfaces. With conventional polyethylene and polyethylene glycol, there are concerns about solvent solubility, poor compatibility with the main resin, and poor film formation due to sublimation. However, with the polymer containing the β-diketone structure, the solubility and compatibility failures can be eliminated and the sublimation can be suppressed by the interaction of the main polymer. In addition, the β-diketone structure and L₁ are difficult to cause thermal decomposition, and the sublimation of low molecular weight molecules by thermal decomposition can be suppressed, thus it is possible to provide a composition for forming an organic film having excellent film-forming property.

It is preferable that the (A) aromatic ring-containing resin contains hydrogen at a position in diaryl methylene or hydrogen at a position in trityl.

When the (A) aromatic ring-containing resin contains hydrogen at a position in diaryl methylene or hydrogen at a position in trityl, the inclusion of these as a partial structure causes an oxidative coupling reaction with dehydrogenation due to heat, and the film can be cured by a crosslinking reaction.

Furthermore, it is preferable that an aromatic ring in the (A) aromatic ring-containing resin contains a hydroxy group as a substituent.

When the aromatic ring in the (A) aromatic ring-containing resin contains a hydroxy group as a substituent, not only oxidation coupling is promoted, but also a dehydration reaction between the hydroxy groups occurs, so that thermal curing occurs more effectively, and the composition capable of forming a film having a high density of crosslinking groups and high processing resistance is obtained. Furthermore, when the hydroxy group is contained, the interaction of the hydroxy group with the β-diketone structure of (B) becomes stronger, thus a composition that is difficult to sublimate when baked and capable of forming a film with excellent film-forming property is obtained.

It is preferable that the (A) aromatic ring-containing resin is a resin containing any one selected from polymers having a repeating unit represented by the following formula (P-1) or (P-2) and compounds represented by any of formulae (P-3) to (P-6): 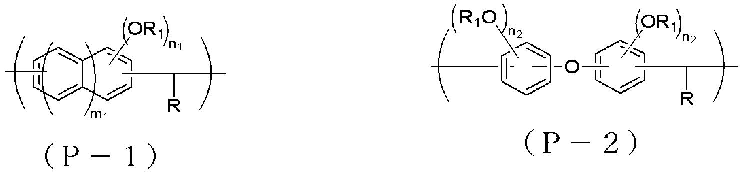 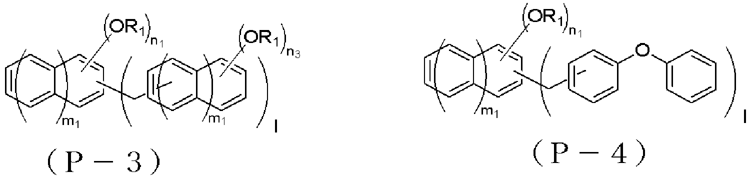 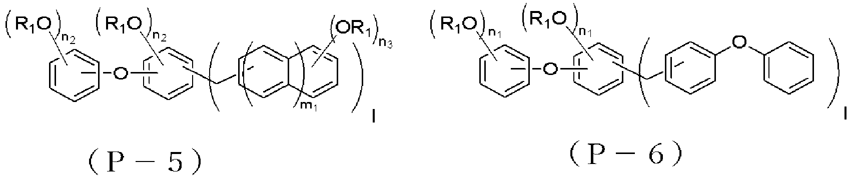 wherein R is a hydrogen atom or a substituted or unsubstituted benzene ring or naphthalene ring; R₁ is a hydrogen atom or a saturated or unsaturated hydrocarbon group having 1 to 20 carbon atoms; m₁ is an integer of 0 or 1; n₁ is an integer from 1 to 4; n₂ is an integer of 1 or 2; n₃ is an integer from 0 to 2; and l is an integer from 5 to 20, provided that l represents a charge ratio.

When the (A) aromatic ring-containing resin has a structure represented by the following formula (P-1) to (P-6), it has excellent thermal curability because it contains hydrogen at the position in diaryl methylene or hydrogen at the position in trityl, and when R₁ is hydrogen, it can be densely crosslinked because it contains a hydroxy group, and the interaction of a hydroxy group with a β-diketone structure of (B) works stronger, thereby a composition capable of forming a film with excellent film-forming property is obtained.

In the formula (1), it is preferable that R_{A} and R_{B} each are a hydrogen atom, a substituted or unsubstituted linear alkyl group having 1 to 20 carbon atoms, a substituted or unsubstituted branched or cyclic alkyl group having 3 to 20 carbon atoms, or a substituted or unsubstituted aliphatic unsaturated hydrocarbon group having 2 to 20 carbon atoms and containing one or more double or triple bonds.

In the formula (1), it is preferable that R_{A} and R_{B} each are a hydrogen atom.

When R_{A} and R_{B} each are a hydrogen atom, a substituted or unsubstituted linear alkyl group having 1 to 20 carbon atoms, a substituted or unsubstituted branched or cyclic alkyl group having 3 to 20 carbon atoms, or a substituted or unsubstituted aliphatic unsaturated hydrocarbon group having 2 to 20 carbon atoms and containing one or more double or triple bonds in the formula (1), a more fluid structure is obtained, and the flatness by thermal flow during embedding of an uneven substrate or baking at high temperature is enhanced. In addition, it is more preferable when R_{A} and R_{B} each are a hydrogen atom because the management of the raw materials is easier.

In the formula (1), it is preferable that L₁ is a saturated or unsaturated linear or branched hydrocarbon group having 2 to 20 carbon atoms and containing no heteroatoms.

When L₁ is a saturated or unsaturated linear or branched hydrocarbon group having 2 to 20 carbon atoms and containing no heteroatoms in the formula (1), the bonding cleavage due to heat is less likely to occur and sublimation can be suppressed, thus a film having more excellent film-forming property is obtained. From the viewpoint of the availability of raw materials, it is preferable that L₁ is a linear hydrocarbon group having 2 to 20 carbon atoms.

It is preferable that the composition contains 0.5 to 30 parts by mass of the (B) polymer containing a repeating unit containing a β-diketone structure based on 100 parts by mass of the (A) aromatic ring-containing resin.

When the composition contains 0.5 to 30 parts by mass of the (B) polymer containing a repeating unit containing a β-diketone structure based on 100 parts by mass of the (A) aromatic ring-containing resin, only the planarization property can be improved without impairing the processing resistance or etching resistance of the (A) aromatic ring-containing resin. It is more preferable that the composition contains 0.5 to 15 parts by mass of the (B) based on 100 parts by mass of the (A).

It is preferable that the (C) solvent in the composition for forming an organic film is a mixture of a solvent having a high boiling point and a solvent having a low boiling point.

With such a mixture of solvents, there is no risk that the volatilization during baking (heat treatment) becomes too fast, so that sufficient thermal fluidity can be obtained at the time of film formation, and an organic film with excellent embedding/planarization properties can be formed.

It is preferable that the composition for forming an organic film further contains one or more of (D) a crosslinking agent and (E) a surfactant.

The present invention provides a method for forming an organic film that functions as an organic flat film used in a process for manufacturing a semiconductor device, including: spin-coating a substrate to be processed with the composition for forming an organic film described above; and heat-treating the substrate coated with the composition for forming an organic film at a temperature of 100°C or higher and 600°C or lower for a period of time of 10 to 600 seconds to form a cured film.

By heat-treating under such conditions, it is possible to promote planarization by thermal flow and crosslinking reaction, and an organic film without mixing with the film formed as the upper layer can be formed.

The present invention also provides a method for forming an organic film that functions as an organic flat film used in a process for manufacturing a semiconductor device, including: spin-coating a substrate to be processed with the composition for forming an organic film described above; and heat-treating the substrate coated with the composition for forming an organic film in an atmosphere having an oxygen concentration of 0.1% or more and 21% or less to form a cured film.

By baking in an oxygen atmosphere in this way, it is possible to form a sufficiently cured organic film.

It is also preferable that the substrate to be processed is a substrate to be processed having a structure or step with a height of 30 nm or more.

The composition for forming an organic film of the present invention is particularly useful in forming a flat organic film on such a substrate to be processed because the composition has excellent embedding/planarization properties.

The present invention also provides a patterning process including: forming an organic film on a body to be processed using the composition for forming an organic film described above; forming a resist middle layer film on the organic film using a resist middle layer film material containing a silicon atom; forming a resist upper layer film on the resist middle layer film using a resist upper layer film material including a photoresist composition; forming a circuit pattern on the resist upper layer film; transferring a pattern by etching to the resist middle layer film using the resist upper layer film on which the circuit pattern is formed as a mask; transferring a pattern by etching to the organic film using the resist middle layer film on which the pattern is transferred as a mask; and further transferring a pattern by etching to the body to be processed using the organic film on which the pattern is transferred as a mask.

The present invention also provides a patterning process including: forming an organic film on a body to be processed using the composition for forming an organic film described above; forming a resist middle layer film on the organic film using a resist middle layer film material containing a silicon atom; forming an organic anti-reflection film on the resist middle layer film; forming a resist upper layer film on the organic anti-reflection film using a resist upper layer film material including a photoresist composition; forming a circuit pattern on the resist upper layer film; transferring a pattern by etching to the organic anti-reflection film and the resist middle layer film using the resist upper layer film on which the circuit pattern is formed as a mask; transferring a pattern by etching to the organic film using the resist middle layer film on which the pattern is transferred as a mask; and further transferring a pattern by etching to the body to be processed using the organic film on which the pattern is transferred as a mask.

The present invention also provides a patterning process including: forming an organic film on a body to be processed using the composition for forming an organic film described above; forming an inorganic hard mask selected from a silicon oxide film, a silicon nitride film, and a silicon oxide nitride film on the organic film; forming a resist upper layer film on the inorganic hard mask using a resist upper layer film material including a photoresist composition; forming a circuit pattern on the resist upper layer film; transferring a pattern by etching to the inorganic hard mask using the resist upper layer film on which the circuit pattern is formed as a mask; transferring a pattern by etching to the organic film using the inorganic hard mask on which the pattern is transferred as a mask; and further transferring a pattern by etching to the body to be processed using the organic film on which the pattern is transferred as a mask.

The present invention also provides a patterning process including: forming an organic film on a body to be processed using the composition for forming an organic film described above; forming an inorganic hard mask selected from a silicon oxide film, a silicon nitride film, and a silicon oxide nitride film on the organic film; forming an organic anti-reflection film on the inorganic hard mask; forming a resist upper layer film on the organic anti-reflection film using a resist upper layer film material including a photoresist composition; forming a circuit pattern on the resist upper layer film; transferring a pattern by etching to the organic anti-reflection film and the inorganic hard mask using the resist upper layer film on which the circuit pattern is formed as a mask; transferring a pattern by etching to the organic film using the inorganic hard mask on which the pattern is transferred as a mask; and further transferring a pattern by etching to the body to be processed using the organic film on which the pattern is transferred as a mask.

In this way, the composition for forming an organic film of the present invention can be suitably used for various patterning processes such as a three-layer resist process using a resist middle layer film containing a silicon atom or an inorganic hard mask, and a four-layer resist process using an organic anti-reflection film in addition to them. With such a patterning process of the present invention, a circuit pattern of a resist upper layer film can be transferred and formed on a body to be processed with high accuracy.

It is also preferable that the inorganic hard mask is formed by a CVD method or an ALD method.

In the patterning process of the present invention, for example, an inorganic hard mask can be formed in such a way.

### ADVANTAGEOUS EFFECTS OF INVENTION

As described above, in the present invention, a composition for forming an organic film having advanced embedding/planarization properties can be provided. In addition, such a composition for forming an organic film of the present invention not only has excellent embedding/planarization properties, but also can be excellent in other properties such as heat resistance or etching resistance. Thus, the composition for forming an organic film of the present invention is extremely useful, for example, as an organic film material used in a multi-layer resist process such as a two-layer resist process, a three-layer resist process using a silicon-containing resist middle layer film or an inorganic hard mask, or a four-layer resist process using a silicon-containing resist middle layer film or an inorganic hard mask and an organic anti-reflection film, or a planarization material for manufacturing semiconductor devices. In addition, with the method for forming an organic film of the present invention, it is possible to form a very flat organic film with sufficient organic solvent resistance on a substrate to be processed. With such a patterning process of the present invention, a fine pattern can be formed on a body to be processed with high accuracy by a multi-layer resist process.

### BRIEF DESCRIPTION OF DRAWINGS

FIG. 1 is an illustrative diagram of an example of the patterning process of the present invention by a three-layer resist process; and
FIG. 2 is an illustrative diagram of evaluation methods for embedding property and planarization property.

### DESCRIPTION OF EMBODIMENTS

As described above, there has been a need to develop a composition for forming an organic film having advanced embedding/planarization properties, and a compound for forming an organic film useful for the composition.

In general, when forming an organic film, a compound for forming an organic film is dissolved in an organic solvent to form a composition, and then the composition is applied to a substrate on which a structure of a semiconductor device, wiring, or the like is formed, and baked to form an organic film. Immediately after application of the composition, a coating film is formed along the shape of the structure on the substrate. Then, upon baking the coating film, most of the organic solvent evaporates before curing, and an organic film is formed with the compound for forming an organic film remaining on the substrate. The present inventors have conceived that, if the compound for forming an organic film remaining on the substrate has sufficient thermal fluidity, the uneven shape immediately after the application could be planarized by thermal flow to form a flat film.

The present inventors have further investigated and considered that, if (B) a polymer of a specific structure having a β-diketone structure in a repeating unit is added to the general composition of (A) an aromatic ring-containing resin and (C) a solvent, it is easy to remain in the film due to the interaction between the β-diketone structure and the (A) aromatic ring-containing resin, and if a hydrocarbon group is contained in the repeating unit, it becomes a structure that is easy to thermally flow, so that a film with excellent planarization property can be formed, and have completed the present invention.

It should be noted that the (B) polymer containing a repeating unit containing a β-diketone structure of the present invention is a polyester in which the β-diketone structure constitutes the polymer main chain. There have been no known examples of using a polyester having such a structure in a composition for an organic film used for lithography or the like.

That is, the present invention is a composition for forming an organic film, containing:
(A) an aromatic ring-containing resin;
(B) a polymer containing a repeating unit containing a β-diketone structure represented by the following formula (1): 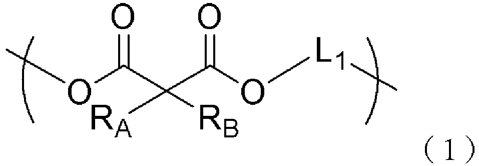 wherein L₁ is a saturated or unsaturated, linear or branched divalent hydrocarbon group having 2 to 20 carbon atoms, where the hydrocarbon group may be interrupted one or more times by an atom selected from oxygen, nitrogen and sulfur, R_{A} and R_{B} are the same or different from each other and each are a hydrogen atom, a substituted or unsubstituted linear alkyl group having 1 to 20 carbon atoms, a substituted or unsubstituted branched or cyclic alkyl group having 3 to 20 carbon atoms, a substituted or unsubstituted aliphatic unsaturated hydrocarbon group having 2 to 20 carbon atoms and containing one or more double or triple bonds, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen group; and
(C) a solvent.

Hereinafter, the present invention will be described in detail, but the present invention is not limited thereto.

Hereinafter, the essential components of the composition for forming an organic film of the present invention will be described in order of (B) a polymer containing a β-diketone structure in a repeating unit, (A) an aromatic ring-containing resin, and (C) a solvent.

### [(B) Polymer containing β-diketone structure in repeating unit]

The (B) polymer containing a β-diketone structure in a repeating unit of the present invention is a polymer represented by the following formula (1): 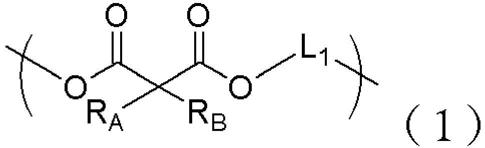 wherein L₁ is a saturated or unsaturated, linear or branched divalent hydrocarbon group having 2 to 20 carbon atoms, where the hydrocarbon group may be interrupted one or more times by an atom selected from oxygen, nitrogen and sulfur, R_{A} and R_{B} are the same or different from each other and each are a hydrogen atom, a substituted or unsubstituted linear alkyl group having 1 to 20 carbon atoms, a substituted or unsubstituted branched or cyclic alkyl group having 3 to 20 carbon atoms, a substituted or unsubstituted aliphatic unsaturated hydrocarbon group having 2 to 20 carbon atoms and containing one or more double or triple bonds, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen group.

In the formula (1), L₁ is a saturated or unsaturated, linear or branched divalent hydrocarbon group having 2 to 20 carbon atoms, where the hydrocarbon group may be interrupted one or more times by an atom selected from oxygen, nitrogen and sulfur.

Specific examples of L₁ include, but are not limited to, the following: 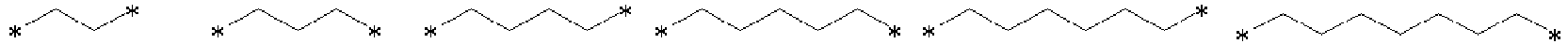 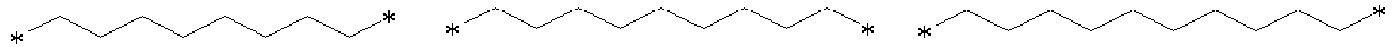 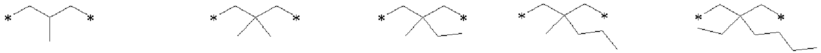 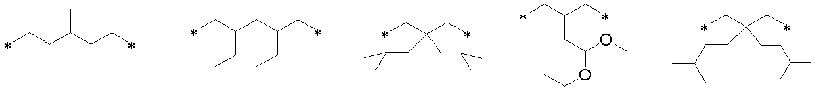 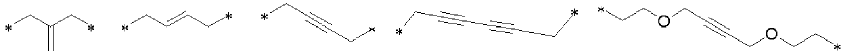 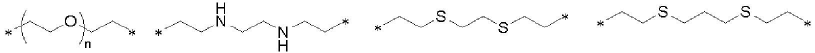 wherein * is an attachment point to an oxygen atom, and n is an integer from 1 to 10.

In view of the thermal stability, L₁ is preferably a hydrocarbon group that is not interrupted by a heteroatom, and more preferably is a linear hydrocarbon group in view of the thermal fluidity. From the viewpoint of the availability of raw materials, it is preferable that L₁ is a linear hydrocarbon group having 2 to 20 carbon atoms.

In the formula (1), R_{A} and R_{B} are the same or different from each other and each are a hydrogen atom, a substituted or unsubstituted linear alkyl group having 1 to 20 carbon atoms, a substituted or unsubstituted branched or cyclic alkyl group having 3 to 20 carbon atoms, a substituted or unsubstituted aliphatic unsaturated hydrocarbon group having 2 to 20 carbon atoms and containing one or more double or triple bonds, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen group.

Specific examples of the substituted or unsubstituted linear alkyl group having 1 to 20 carbon atoms represented by R_{A} and R_{B} include a methyl group, an ethyl group, a propyl group, a butyl group, a pentyl group, and an octyl group. Specific examples of the substituted or unsubstituted branched alkyl groups having 3 to 20 carbon atoms include an isopropyl group, an isobutyl group, and an isopentyl group. Specific examples of the cyclic alkyl group having 3 to 20 carbon atoms include cyclohexane, cyclopentyl, and methylcyclohexyl. Specific examples of the substituted or unsubstituted aliphatic unsaturated hydrocarbon group having 2 to 20 carbon atoms and containing one or more double or triple bonds include an allyl group and a propargyl group. Specific examples of the substituted or unsubstituted heteroalkyl group having 1 to 30 carbon atoms include an alkyl groups that may be interrupted one or more times by an atom selected from oxygen, nitrogen and sulfur. Specific examples of the substituted or unsubstituted aryl group having 6 to 30 carbon atoms include a phenyl group or a tolyl group. The substituents represented by R_{A} and R_{B} are not limited to these specific examples.

Specific examples of R_{A} and R_{B} also include the following structures:

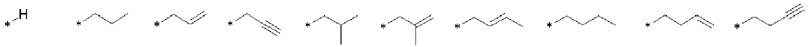

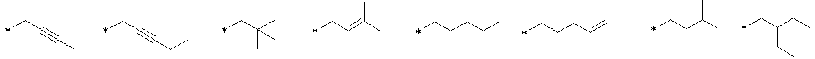

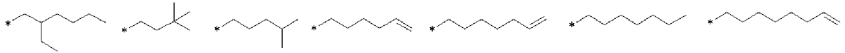

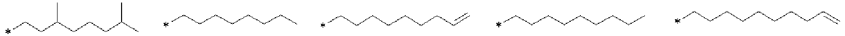

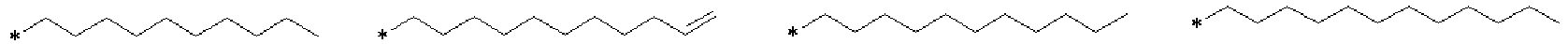

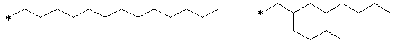

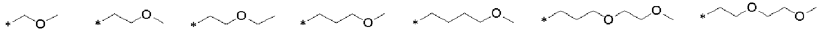

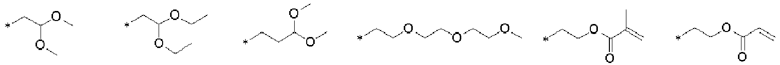

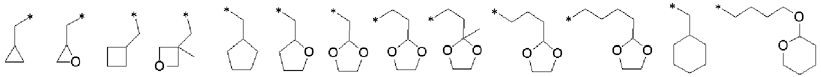

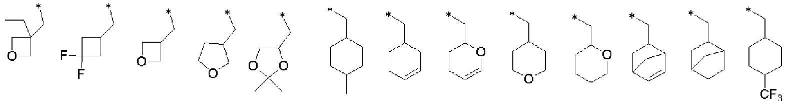

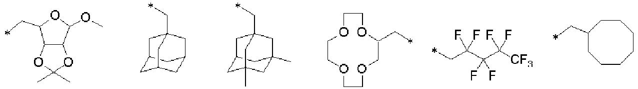

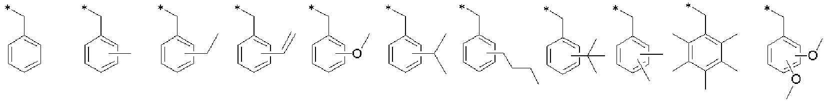

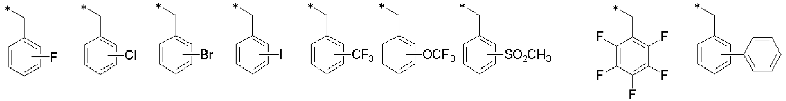

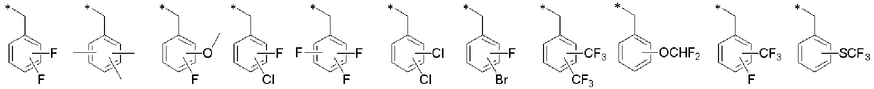

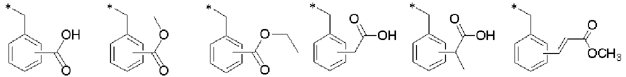

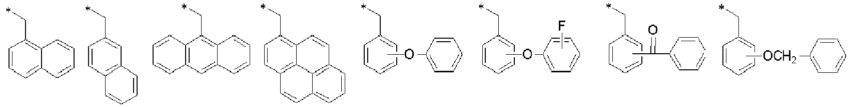

In view of the thermal fluidity, R_{A} and R_{B} each are preferably a hydrogen atom, a substituted or unsubstituted alkyl group having 1 to 20 carbon atoms, and a substituted or unsubstituted branched or cyclic alkyl groups having 3 to 20 carbon atoms. It is more preferably a hydrogen atom from the viewpoint of the availability of raw materials.

The weight average molecular weight Mw of the (B) polymer containing a repeating unit containing a β-diketone structure in terms of polystyrene by gel permeation chromatography is preferably 1,000 or more and 20,000 or less. When the weight average molecular weight Mw is in such a range, a polymer is difficult to sublimate at high temperatures, contributes to improving the flatness by thermal flow without causing film formation failures, and further has good solvent solubility.

From the viewpoint of processing resistance and etching resistance, it is preferable that the composition contains 0.5 to 50 parts by mass, more preferably 0.5 to 30 parts by mass, of the (B) polymer containing a β-diketone structure in a repeating unit based on 100 parts by mass of the (A) aromatic ring-containing resin.

### [Method for Producing Polymer (B)]

The polymer (B) having a repeating unit represented by formula (1) is a so-called polyester. The polymer can be obtained by a dehydration condensation reaction between a diol containing the structure of L₁ and a biscarboxylic acid having R_{A} and R_{B} as a partial structure, an acid halide or acid anhydride corresponding to the biscarboxylic acid, an ester exchange with a biscarboxylic acid ester, and the like. Examples of reaction formulae for dehydration condensation, acid halide, and ester exchange are shown below. These can be selected appropriately in consideration of the stability of the raw materials used, or the like. The amount of diol used at this time is preferably 0.8 to 1.2 equivalents based on the biscarboxylic acid or the biscarboxylic acid derivative, and more preferably 0.9 to 1.1 equivalents from the viewpoint of the molecular weight of the resulting polymer and reducing unreacted raw materials.

In the following formulae, R_{A}, R_{B}, and L₁ are the same as above, X₁ is a halogen atom, and R'' is an alkyl group having 1 to 5 carbon atoms.

### [Dehydration condensation]

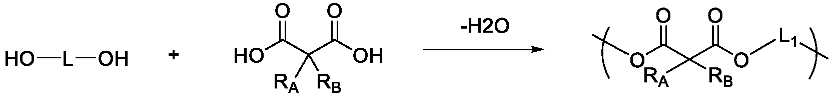

### [Ester exchange]

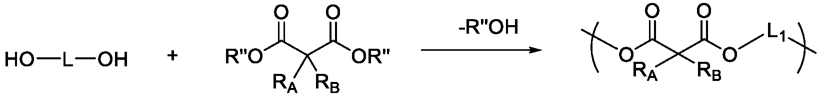

### [Acid halide]

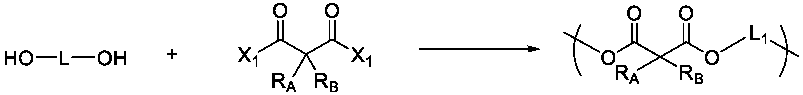

When the polymer (B) is produced using the dehydration condensation or ester exchange as described above, it can be obtained by reacting a diol and a biscarboxylic acid or an ester compound corresponding to the biscarboxylic acid in the absence or presence of a catalyst while removing water or alcohol produced.

The reaction can be carried out without a catalyst if the reaction proceeds, but the reaction can also be carried out with a catalyst. Examples of the catalyst include metal hydroxides such as sodium hydroxide or potassium hydroxide; alkali metal or alkaline earth metal carbonates such as sodium carbonate, potassium carbonate, or cesium carbonate; amines such as imidazole or benzotriazole; phosphines such as triphenylphosphine; quaternary ammonium salts such as tetraalkyl ammonium halide including tetraethyl ammonium chloride and tetraethyl ammonium bromide, and benzyl trialkyl ammonium chloride such as benzyl trimethyl ammonium chloride and benzyl triethyl ammonium chloride; quaternary phosphonium salts such as benzyl triphenyl phosphonium chloride; aluminum compounds such as trialkyl aluminum; tin compounds such as tin chloride and tin carboxylates; and titanium compounds such as titanium alkoxides. The amount of the catalyst used can be selected from a range of 0.001 to 1.0 moles, preferably 0.003 to 0.3 moles, and more preferably 0.005 to 0.1 moles, per 1.0 mole of a total amount of diols and bis-dicarboxylic acids.

The reaction may be carried out without a solvent, but may be carried out with a solvent to reduce the viscosity of the polymer obtained. The solvent is not particularly limited as long as it is inert in the above reaction, and examples include aromatic solvents such as benzene, toluene, and xylene, acetonitrile, dimethyl sulfoxide, N,N-dimethylformamide, N-methylpyrrolidone, diphenyl sulfone, diphenyl ether, trichlorobiphenyl, trichlorobenzene, and dichlorobenzene. These can be used singly or in combination. These solvents can be used in a range of 0 to 2,000 parts by mass based on 100 parts by mass of the reaction raw materials. The reaction temperature is preferably from -50°C to about a boiling point of the solvent, and more preferably from 100°C to 150°C. The reaction time is appropriately selected from 0.1 to 100 hours. It is preferable that the reaction is carried out while removing water or alcohol generated due to the reaction from the system.

When the polymer (B) is produced using an acid halide as described above, it can be obtained by reacting with an acid halide corresponding to the biscarboxylic acid, such as an acid chloride, in the presence of a base catalyst.

Examples of the base catalyst used include amines. Specific examples include tertiary amines such as trimethylamine, triethylamine, tripropylamine, diisopropylethylamine, tributylamine, tripentylamine, and trihexylamine; aliphatic amines having an aromatic ring such as N,N-dimethylaniline, phenyl dimethylamine, diphenylmethylamine, and triphenylamine; cyclic aliphatic amines such as 1-methylpyrrolidine, 1-methylpiperidine, and 4-methylmorpholine; amidines such as 1,8-diazabicyclo[5.4.0]-7-undecene and 1,5-diazabicyclo[4.3.0]-5-nonene; guanidines such as guanidine, 1,1,3,3-tetramethylguanidine, and 1,2,3-triphenylguanidine; aromatic amines such as 1-methylpyrrole, pyridine, 2-methylpyridine, 3-methylpyridine, 4-methylpyridine, 2,6-dimethylpyridine, and N,N-dimethyl-5-aminopyridine; and quaternary ammonium salts such as tetramethyl ammonium hydroxide and tetraethyl ammonium hydroxide. These can be used singly or in combination of two or more. The amount of the catalysts used ranges from 0.1 to 20 moles, preferably from 0.2 to 10 moles, based on the number of moles of the acid halide of the raw material.

The solvent used at this time is not particularly limited as long as it is inert in the above reaction, and examples include ether-based solvents such as diethyl ether, tetrahydrofuran, and dioxane; aromatic solvents such as benzene, toluene, and xylene, acetonitrile, dimethyl sulfoxide, N,N-dimethylformamide, N-methylpyrrolidone, and water. These can be used singly or in combination. These solvents can be used in a range of 0 to 2,000 parts by mass based on 100 parts by mass of the reaction raw materials. The reaction temperature is preferably from -50°C to about a boiling point of the solvent, and more preferably from room temperature to 150°C. The reaction time is appropriately selected from 0.1 to 100 hours.

After the reaction using the dehydration condensation, ester exchange and acid halide described above is completed, a method for increasing the temperature of the reaction vessel to 130-230°C and removing volatiles at about 1-50 mmHg, a method for precipitating the polymer by adding a suitable poor solvent or water, a method for partitioning, and the like can be applied to remove unreacted raw materials, catalysts, and the like present in the system. Those methods can be applied according to the properties of the raw materials used and the resulting reaction product. The obtained polymer may be diluted into an organic solvent, and then finally recovered by washing via liquid-liquid extraction.

The organic solvent used at this time is not particularly limited as long as it can dissolve the compound and separates into two layers when mixed with water. Examples include hydrocarbons such as hexane, heptane, benzene, toluene, and xylene, esters such as ethyl acetate, n-butyl acetate, and propylene glycol methyl ether acetate, ketones such as methyl ethyl ketone, methyl amyl ketone, cyclohexanone, and methyl isobutyl ketone, ethers such as diethyl ether, diisopropyl ether, methyl-tert-butyl ether, and ethyl cyclopentyl methyl ether, and chlorine-based solvents such as methylene chloride, chloroform, dichloroethane, and trichloroethylene, and mixtures of these. As the washing water used at this time, those generally referred to as deionized water or ultrapure water may be used. It is preferable that the washing is performed one or more times because the purification effect is good. It is economical when the washing is performed 10 or less times. Preferably the washing is performed about 1 to 5 times.

The washing may be performed with a basic aqueous solution to remove unreacted raw materials or acidic components in the system during washing via liquid-liquid extraction. Specific examples of the base include hydroxides of alkali metals, carbonates of alkali metals, hydroxides of alkaline earth metals, carbonates of alkaline earth metals, ammonia, and organic ammonium.

The washing may also be performed with an acidic aqueous solution to remove unreacted raw materials, metal impurities or base components in the system during washing via liquid-liquid extraction. Specific examples of the acid include inorganic acids such as hydrochloric acid, hydrobromic acid, sulfuric acid, nitric acid, phosphoric acid, and heteropoly acid, and organic acids such as oxalic acid, trifluoroacetic acid, methanesulfonic acid, benzenesulfonic acid, p-toluenesulfonic acid, and trifluoromethanesulfonic acid.

The washing via liquid-liquid extraction may be performed with either one of the basic aqueous solution and acidic aqueous solution, but can also be performed in combination. The washing via liquid-liquid extraction is preferably performed in the order of the basic aqueous solution and the acidic aqueous solution from the viewpoint of removing metal impurities.

After washing via liquid-liquid extraction with the above basic aqueous solution and acid aqueous solution, washing with neutral water may follow. The washing may be performed one or more times, and preferably about 1 to 5 times. As the neutral water, the deionized water and ultrapure water described above may be used. It is preferable that the washing is performed one or more times because the purification effect is good. It is economical when the washing is performed 10 or less times. Preferably the washing is performed about 1 to 5 times.

The reaction product after liquid-liquid extraction can also be recovered as a powder by concentrating and drying or crystallizing the solvent under reduced pressure or normal pressure. However, to improve the operability during the preparation of an organic film material, it is also possible to leave the reaction product in a solution state at an appropriate concentration. The concentration at this time is preferably 0.1 to 50% by mass, and more preferably 0.5 to 30% by mass. With such a concentration, the operability is good because the viscosity is difficult to be high, and it is economical because the amount of solvent is not excessive.

The solvent at this time is not particularly limited as long as it can dissolve the compound. Specific examples include ketones such as cyclohexanone and methyl-2-amylketone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether, esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono tert-butyl ether acetate. These can be used singly or in combination of two or more.

The polymer solution is preferably subjected to filter filtration. By performing filter filtration, it is possible to remove foreign substances or gels that can cause film formation failure, which is effective in view of quality stabilization.

Examples of the material of the filter used for the filter filtration include materials such as fluorocarbon-based, cellulose-based, nylon-based, polyester-based, and hydrocarbon-based materials, but in the filtration step of the chemical amplification resist composition, it is preferable that the filter is formed of a fluorocarbon-based material called Teflon(R), a hydrocarbon-based material such as polyethylene or polypropylene, or nylon. The pore size of the filter can be suitably selected according to the target cleanliness, but is preferably 100 nm or less, more preferably 20 nm or less. One kind of these filters may be used singly, or a plurality of filters may be used in combination. In the filtration method, the solution may be filtered once, but it is more preferable the solution is circulated and subjected to multiple filtration. The filtration step can be performed in any order and number of times in the production process of the polymer solution, but it is preferable that the reaction solution after the polymerization reaction, the polymer solution, or both are filtered.

### [Another Method for Producing Polymer (B)]

As another method for producing the polymer (B), there is a method including [STEP 1] of obtaining a polymer by changing, in obtaining the polymer (B) described above, a biscarboxylic acid, a biscarboxylic acid ester, or a halide of a biscarboxylic acid, which is the raw material, to a malonic acid derivative, and then [STEP 2] of subjecting the obtained polymer to an addition reaction with a halide, mesylate, tosylate or the like having R_{A} and R_{B} as a partial structure in the presence of a base catalyst. When both R_{A} and R_{B} each are hydrogen, the reaction may be terminated in [STEP 1]. In the following formulae, X represents a halide, mesylate, or tosylate, and R_{A}, R_{B}, and L₁ are the same as described above.

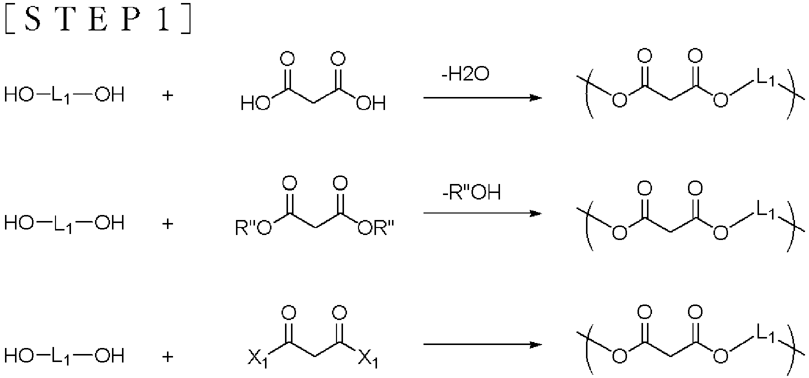

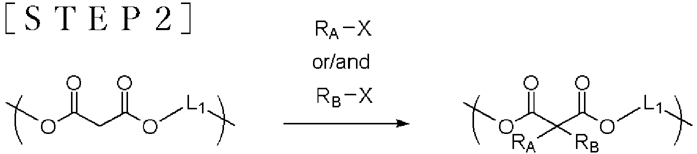

When the above reaction method is used, in terms of the reaction selectivity, there are two reaction sites for the repeating units of the polymer. Thus, when R_{A} and R_{B} are completely introduced as substituents with the reaction rate of 100%, the following three types are obtained when R_{A} ≠ R_{B}, and one type is obtained when R_{A} = R_{B} = R'. When the reaction rate is less than 100%, a polymer containing repeating units with plural combinations can be obtained as shown below. When R_{A} ≠ R_{g}, the following six types can be obtained, and when R_{A} = R_{B} = R', two types can be obtained. The reaction rate for the entire reaction sites can be controlled by adjusting the overall charge ratio, and one or more substituents corresponding to R_{A} and R_{B} can be used in combination according to the required performance. For example, when the substitution rate in the repeating unit of the polymer is set to 100, and the proportion substituted with R_{A}, R_{B} is defined as "a" and the proportion unmodified as an hydrogen atom is defined as "b", 0 ≤ a + b ≤ 100 is satisfied, and preferably 0.5 < b ≤ 1.0, more preferably 0.7 ≤ b ≤ 1.0, is satisfied. At this time, it becomes a polymer containing the repeating units shown below according to the relationship between R_{A} and R_{B}.

### [When reaction rate = 100%]

RA ≠ RB 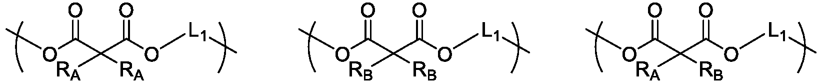
RA = RB= R'

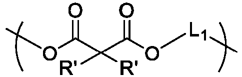

### [When reaction rate < 100%]

RA ≠ RB 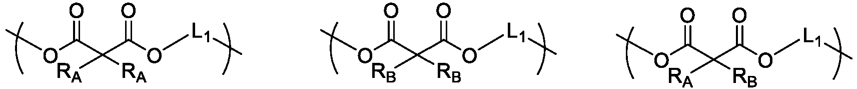 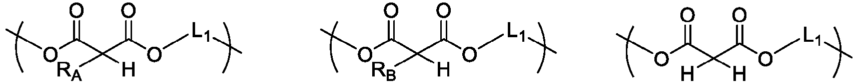
RA = RB= R'

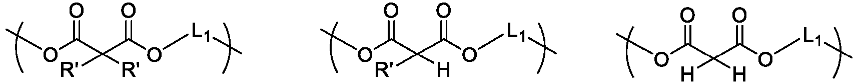

As a method for obtaining the polymer, for the polymerization of STEP 1, the method described in [Method for Producing Polymer (B)] above can be applied only by changing the biscarboxylic acid, which is a raw material of the (B), to the corresponding malonic acid. The polymer obtained in STEP 1 can be used for the addition reaction of STEP 2.

Examples of the base catalyst used in the substitution reaction of STEP 2 include inorganic base compounds such as sodium bicarbonate, sodium carbonate, potassium carbonate, calcium carbonate, cesium carbonate, sodium hydroxide, potassium hydroxide, sodium hydride, and potassium phosphate, and organic amine compounds such as triethylamine, pyridine, and N-methyl morpholine. These may be used singly or in combination of two or more. The amount of these catalysts ranges from 0.1 to 2.5 moles, preferably from 0.2 to 2.0 moles, based on the number of moles of α-hydrogen in the raw materials.

The solvent used at this time is not particularly limited as long as it is an inert solvent in the above reaction. Examples include ether-based solvents such as diethyl ether, tetrahydrofuran, and dioxane, aromatic solvents such as benzene, toluene, and xylene, acetonitrile, dimethyl sulfoxide, N,N-dimethylformamide, N-methylpyrrolidone, and water. These can be used singly or in combination. These solvents can be used in a range of 0 to 2,000 parts by mass based on 100 parts by mass of the reaction raw materials. The reaction temperature is preferably from -50°C to about a boiling point of the solvent, and more preferably from room temperature to 150°C. The reaction time is appropriately selected from 0.1 to 100 hours.

Examples of the reaction method include a method of charging a polymer obtained in STEP 1, a halide, mesylate or tosylate having R_{A} and R_{B} as a partial structure, and a catalyst in bulk, a method of dispersing or dissolving a polymer obtained in STEP 1 and a halide, mesylate or tosylate having R_{A} and R_{B} as a partial structure, followed by bulk addition of a catalyst or dilution with a solvent and dropwise addition of a catalyst, and a method of dispersing or dissolving a catalyst, followed by bulk addition or dilution with a solvent and dropwise addition of a polymer obtained in STEP 1 and a halide, mesylate or tosylate having R_{A} and R_{B} as substituents.

After the reaction is completed, a step of washing via liquid-liquid extraction, a step of filtration, or the like described in the [Method for Producing Polymer (B)] above can be added.

In the production of the polymer used for the composition for forming an organic film obtained by these methods, it is possible to obtain the polymer according to the required performance by combining the structure and introduction ratio of R_{A} and R_{B} in the polymer, and further the polymer production method according to the required performance. For example, those having a side chain structure that contributes to improving the planarization property and those having a fluorine-containing substituent and the like for controlling surface tension and changing surface activity ability can be optionally used in combination.

### [(A) Aromatic ring-containing resin]

The (A) aromatic ring-containing resin is not particularly limited as long as it is a polymer containing an aromatic ring, and examples thereof include a Novolac resin, a polyether resin, a polyester resin, a polystyrene resin, and a polymethacrylate resin. The Novolac resin refers to a resin that can be synthesized by subjecting an aromatic ring-containing compound and an aldehyde compound, a compound having a benzyl alcohol unit, or the like to an acid or base condition, and condensing these compounds. The polyether resin or polyester resin refers to a resin containing an ether or ester in the repeating unit. The polystyrene resin and the polymethacrylate resin are resins in which a monomer having a styrene structure and a methacrylic(acrylic) structure, respectively, is polymerized by radical polymerization.

The (A) aromatic ring-containing resin of the present invention also encompasses compounds having a structure in which a plurality of aromatic compounds are bonded, in addition to the above-described polymer having a repeating unit of a particular structure. The compounds having a structure in which a polymer having a repeating unit and a plurality of aromatic compounds are bound are described below.

Examples of the aromatic ring include not only benzene ring-condensed structures such as a benzene ring, a naphthalene ring, an anthracene ring, a phenanthrene ring, a pyrene ring, a chrysene ring, a benzopyrene ring, and a coronene ring, but also a heterocycle such as pyrrole, pyridine, furan, and thiophene. Further examples of the aromatic ring include those in which a plurality of aromatic rings such as biphenyl, diaryl ether, fluorene, and the like are bonded via a hydrocarbon, an ether, an ester, or the like.

Examples of the (A) aromatic ring-containing resin used in the present invention can include resins containing the following structures described in JP 2012-001687 A and JP 2012-077295 A.

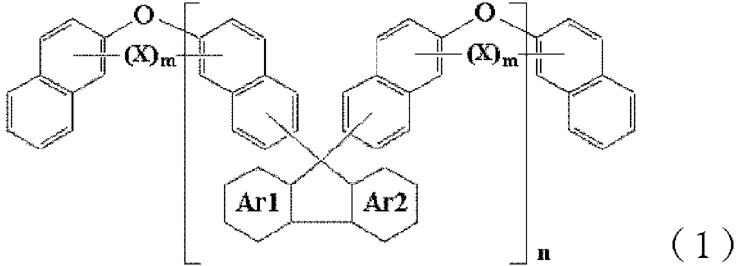

In the formula (1), the ring structures Ar1 and Ar2 each represent a benzene ring or a naphthalene ring. X represents a single bond or an alkylene group having 1 to 20 carbon atoms. m represents 0 or 1. n represents any natural number with which the molecular weight is 100,000 or less. The symbols in the formula are applied only in this formula. 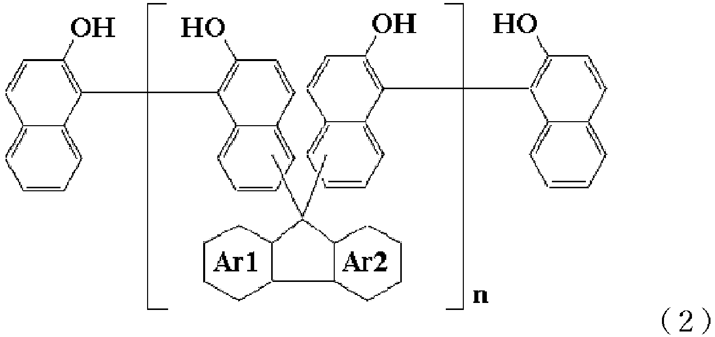 In the formula (2), the ring structures Ar1 and Ar2 each represent a benzene ring or a naphthalene ring. n represents any natural number with which the weight average molecular weight in terms of polystyrene by gel permeation chromatography is 100,000 or less. The symbols in the formula are applied only in this formula.

Further examples of the (A) aromatic ring-containing resin used in the present invention can include resins containing the following structures described in JP 2004-264710 A, JP 2005-043471 A, JP 2005-250434 A, JP 2007-293294 A, and JP 2008-065303 A.

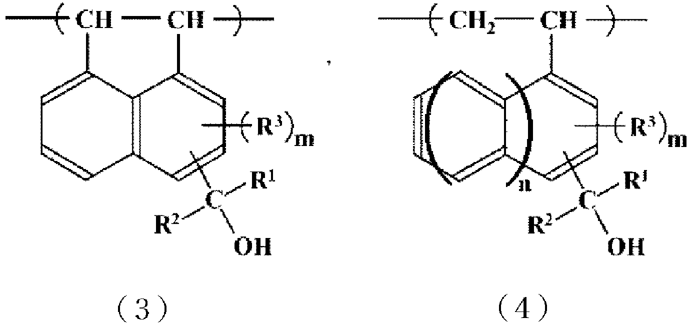

In the formulae (3) and (4), R¹ and R² each represent a hydrogen atom, an alkyl group having 1 to 3 carbon atoms, or an aryl group, R³ represents an alkyl group having 1 to 3 carbon atoms, a vinyl group, an allyl group, and an optionally substituted aryl group, n represents 0 or 1, and m represents 0, 1 or 2. The symbols in the formula are applied only in this formula. 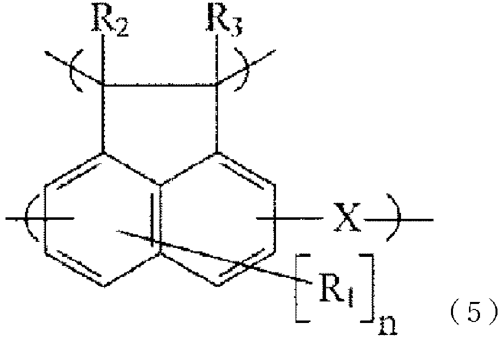 In the formula (5), R₁ is a monovalent atom or group other than a hydrogen atom, and n is an integer from 0 to 4, provided that, when n is 2 to 4, a plurality of R₁ may be the same or different. R₂ and R₃ are each independently a monovalent atom or group. X is a divalent group. The symbols in the formula are applied only in this formula. 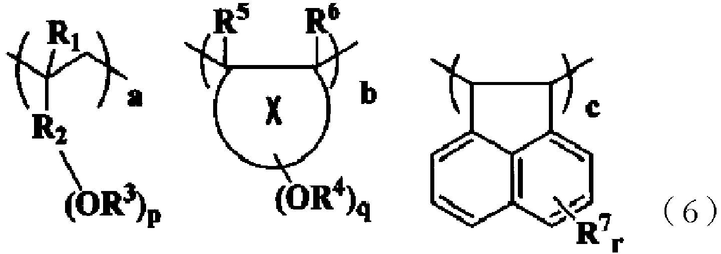 In the formula (6), R₁ is a hydrogen atom or a methyl group. R₂ is a single bond, a linear, branched, or cyclic alkylene group having 1 to 20 carbon atoms, or an arylene group having 6 to 10 carbon atoms, and may have ether, ester, lactone, or amide. R³ and R⁴ each are a hydrogen atom or a glycidyl group. X represents a polymer of a hydrocarbon containing an indene skeleton, a cycloolefin having 3 to 10 carbon atoms, or a maleimide, which may have ether, ester, lactone, or carboxylic acid anhydride. R⁵ and R⁶ each are a hydrogen atom, a fluorine atom, a methyl group, or a trifluoromethyl group. R⁷ is a hydrogen atom, a linear, branched, or cyclic alkyl group having 1 to 6 carbon atoms, a hydroxy group, or an alkoxycarbonyl group. p and q each are an integer from 1 to 4. r is an integer from 0 to 4. a, b, and c satisfy 0.5 ≤ a + b + c ≤ 1, 0 ≤ a ≤ 0.8, 0 ≤ b ≤ 0.8, 0.1 ≤ a + b ≤ 0.8, and 0.1 ≤ c ≤ 0.8. The symbols in the formula are applied only in this formula. 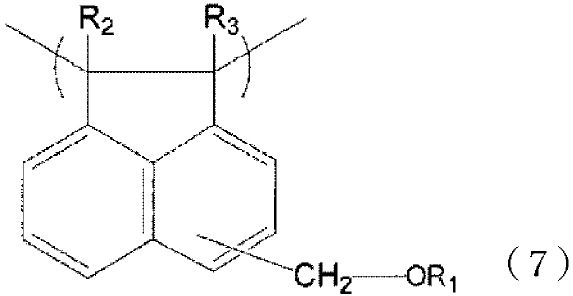 In the formula (7), R₁ represents a hydrogen atom or a monovalent organic group, and R₂ and R₃ each independently represent a monovalent atom or a monovalent organic group. The symbols in the formula are applied only in this formula.

Specific examples of the (A) aromatic ring-containing resin used in the present invention can include resins containing the following structures described in JP 2004-205685 A, JP 2007-171895 A, and JP 2009-014816 A.

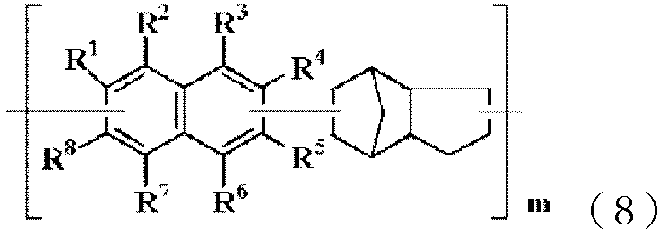

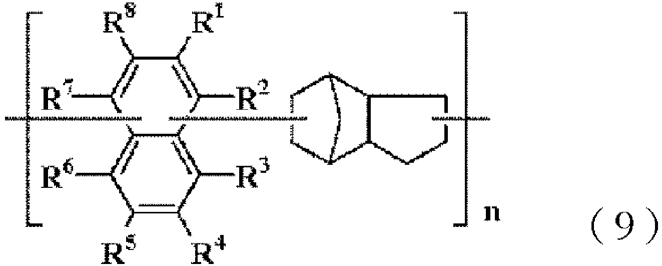

In the formulae (8) and (9), R¹ to R⁸ are each independently a hydrogen atom, a hydroxy group, an optionally substituted alkyl group having 1 to 6 carbon atoms, an optionally substituted alkoxy group having 1 to 6 carbon atoms, an optionally substituted alkoxycarboxyl group having 2 to 6 carbon atoms, an optionally substituted aryl group having 6 to 10 carbon atoms, a hydroxyalkyl group having 1 to 6 carbon atoms, an isocyanate group, or a glycidyl group. m and n each are a positive integer. The symbols in the formula are applied only in this formula. 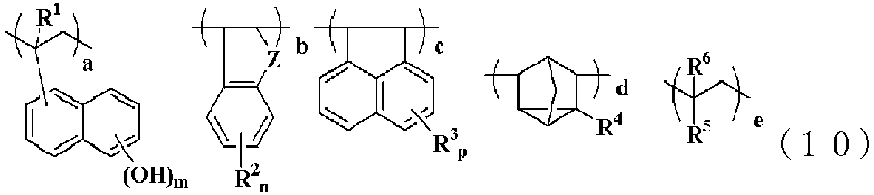 In the formula (10), R¹ and R⁶ each are a hydrogen atom or a methyl group. R², R³, and R⁴ each are a hydrogen atom, an alkyl group having 1 to 4 carbon atoms, an alkoxy group, a hydroxy group, an acetoxy group, or an alkoxycarbonyl group, or an aryl group having 6 to 10 carbon atoms, and R⁵ is a fused polycyclic hydrocarbon group having 13 to 30 carbon atoms, -O-R⁷, -C(=O)-O-R⁷, -O-C(=O)-R⁷, or -C(=O)-NR⁸-R⁷, m is 1 or 2, n is an integer from 0 to 4, and p is an integer from 0 to 6. R⁷ is an organic group having 7 to 30 carbon atoms, and R⁸ is a hydrogen atom or a hydrocarbon group having 1 to 6 carbon atoms. Z is a methylene group, -O-, -S-, or - NH-. a, b, c, d, and e satisfy 0 < a < 1.0, 0 ≤ b ≤ 0.8, 0 ≤ c ≤ 0.8, 0 ≤ d ≤ 0.8, 0 ≤ e ≤ 0.8, 0 < b + c + d + e < 1.0. The symbols in the formula are applied only in this formula. 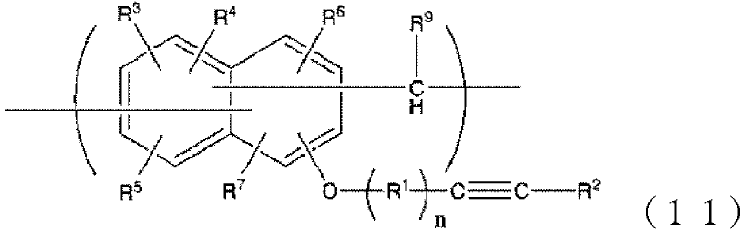 In the formula (11), n represents 0 or 1. R¹ represents an optionally substituted methylene group, an optionally substituted alkylene group having 2 to 20 carbon atoms, or an optionally substituted arylene group having 6 to 20 carbon atoms. R² represents a hydrogen atom, an optionally substituted alkyl group having 1 to 20 carbon atoms, or an optionally substituted aryl group having 6 to 20 carbon atoms. R³ to R⁷ each independently represent a hydroxy group, an optionally substituted alkyl group having 1 to 6 carbon atoms, an optionally substituted alkoxy group having 1 to 6 carbon atoms, an optionally substituted alkoxycarboxyl group having 2 to 10 carbon atoms, an optionally substituted aryl group having 6 to 14 carbon atoms, or an optionally substituted glycidyl ether group having 2 to 6 carbon atoms. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. The symbols in the formula are applied only in this formula.

Examples of the formula (11) include the following resins.

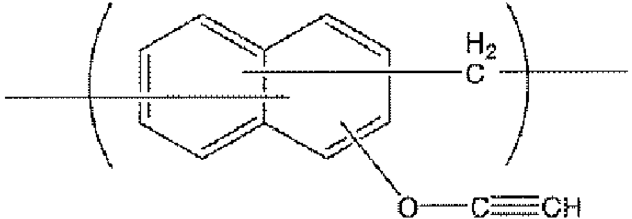

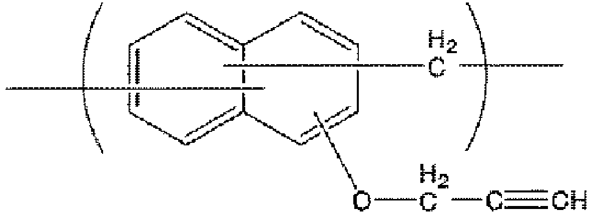

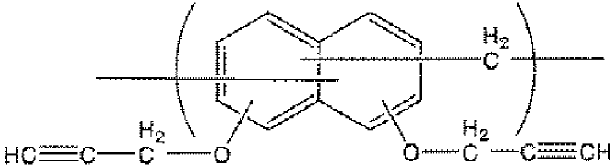

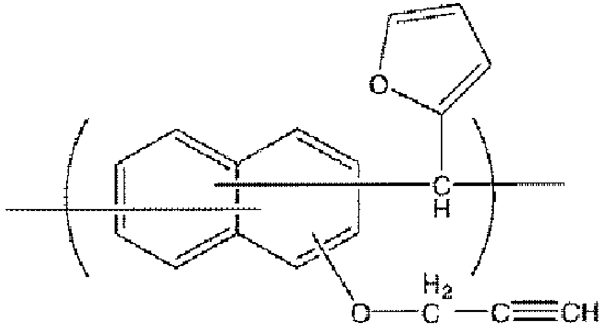

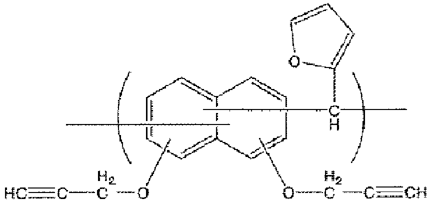

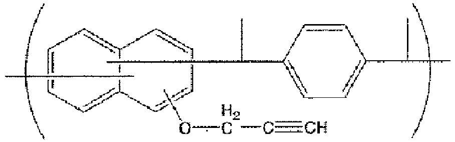

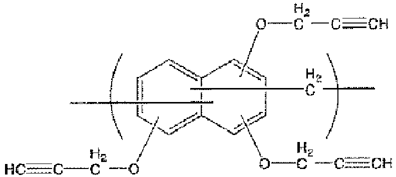

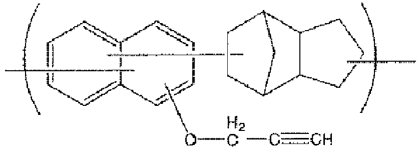

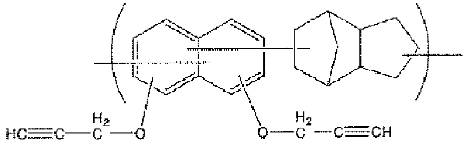

Specific examples of the (A) aromatic ring-containing resin used in the present invention can include resins containing the following structures described in JP 2007-199653 A, JP 2008-274250 A, and JP 2010-122656 A.

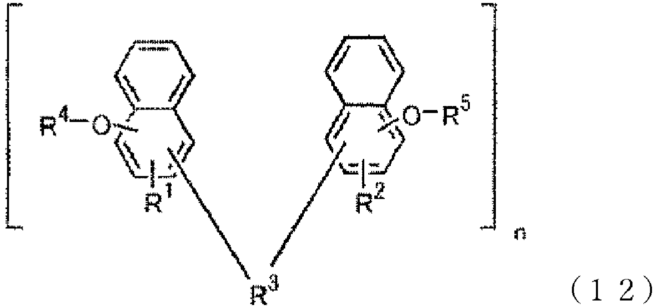

In the formula (12), R¹ and R² are the same or different and each independently a hydrogen atom, a linear, branched, cyclic alkyl group having 1 to 10 carbon atoms, an aryl group having 6 to 10 carbon atoms, or an alkenyl group having 2 to 10 carbon atoms, and R³ is a single bond or an alkylene group having a linear, branched, or cyclic structure having 1 to 30 carbon atoms, and may have a bridged cyclic hydrocarbon group, a double bond, a heteroatom, or an aromatic group having 6 to 30 carbon atoms, and R⁴ and R⁵ are each independently a hydrogen atom or a glycidyl group, and n is an integer from 1 to 4. The symbols in the formula are applied only in this formula.

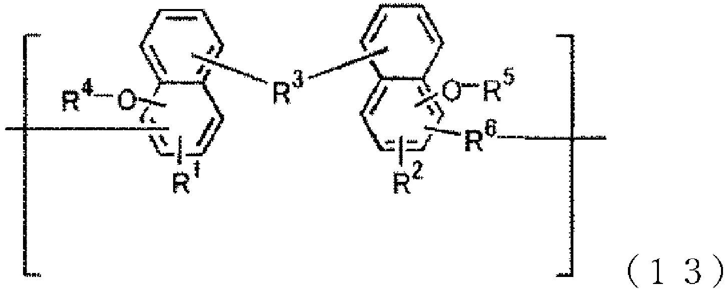

In the formula (13), R¹ and R² are the same or different and each independently a hydrogen atom, a linear, branched, cyclic alkyl group having 1 to 10 carbon atoms, an aryl group having 6 to 10 carbon atoms, or an alkenyl group having 2 to 10 carbon atoms, R³ is a single bond or an alkylene group having a linear, branched, or cyclic structure having 1 to 30 carbon atoms, and may have a bridged cyclic hydrocarbon group, a double bond, a heteroatom, or an aromatic group having 6 to 30 carbon atoms, R⁴ and R⁵ are each independently a hydrogen atom or a glycidyl group, and R⁶ is a single bond or a linear or branched alkylene group having 1 to 10 carbon atoms. The symbols in the formula are applied only in this formula.

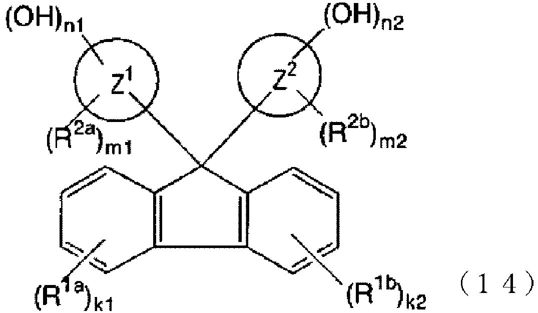

In the formula (14), ring Z¹ and ring Z² each represent a fused polycyclic aromatic hydrocarbon ring, and R^{1a}, R^{1b}, R^{2a}, and R^{2b} represent the same or different substituents. k1 and k2 are the same or different and each represent an integer of 0 or 1 to 4, m1 and m2 each represent an integer of 0 or 1 or more, and n1 and n2 each represent an integer of 0 or 1 or more, provided that n1 + n2 ≥ 1. The symbols in the formula are applied only in this formula. 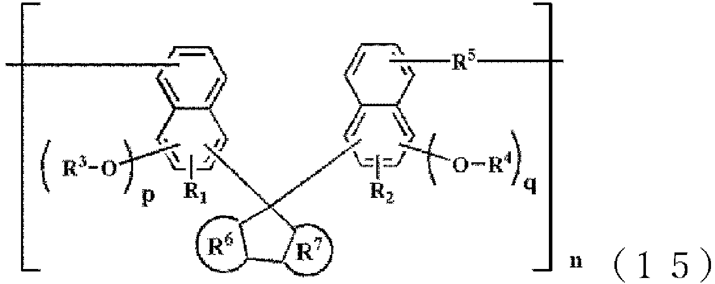 In the formula (15), R₁ and R₂ are the same or different and each are a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each are a hydrogen atom or a glycidyl group, R⁵ is a single bond, or a linear or branched alkylene group having 1 to 10 carbon atoms, and R⁶ and R⁷ each are a benzene ring and a naphthalene ring. p and q each are an integer of 1 or 2. n is 0 < n ≤ 1. The symbols in the formula are applied only in this formula.

Examples of the formula (15) include the following resins.

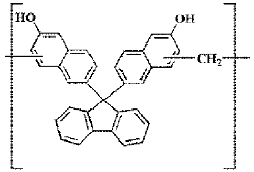

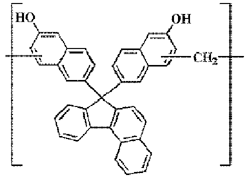

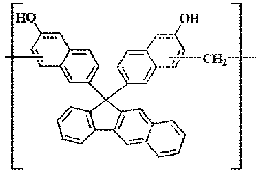

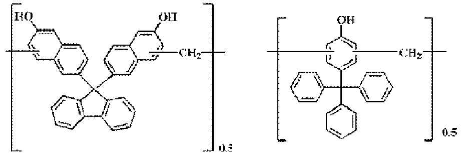

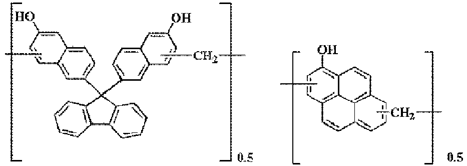

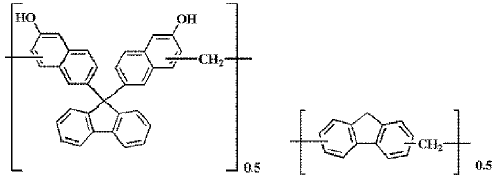

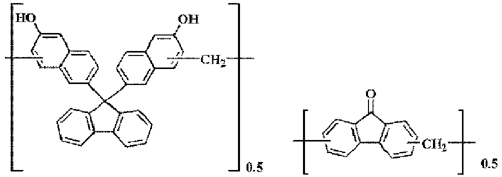

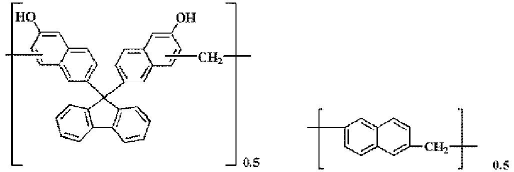

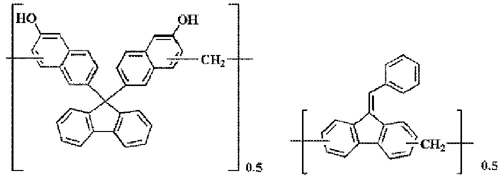

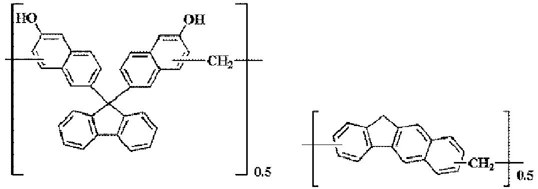

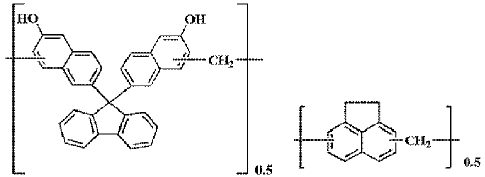

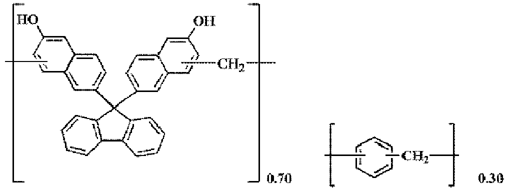

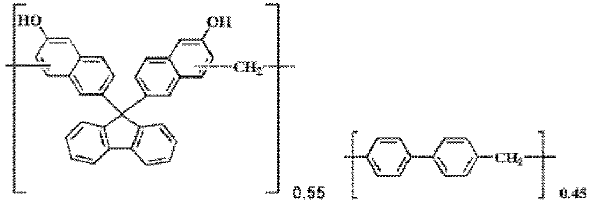

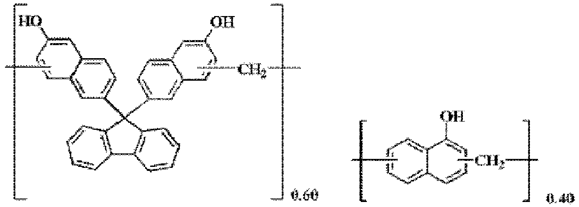

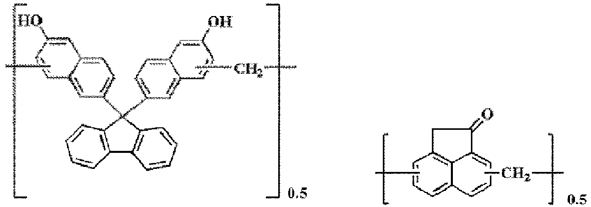

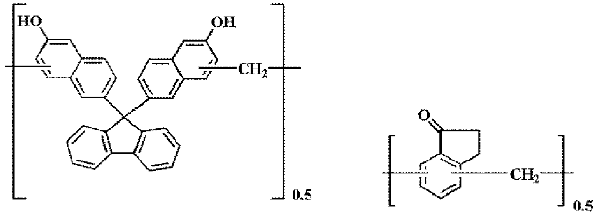

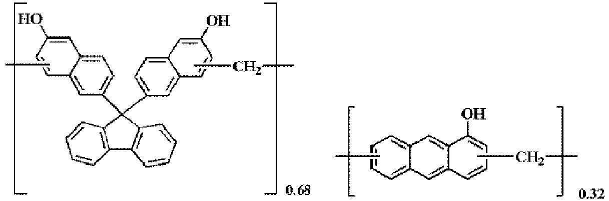

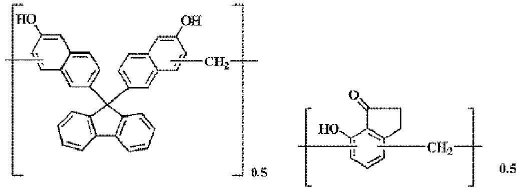

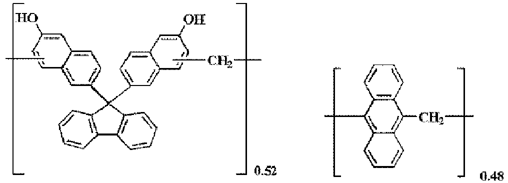

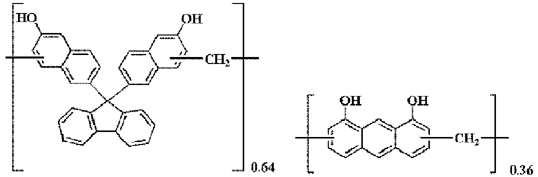

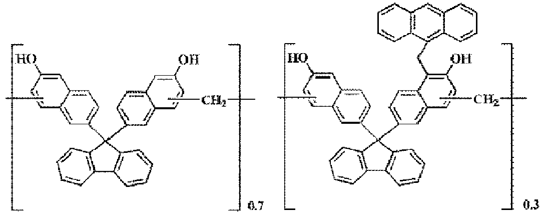

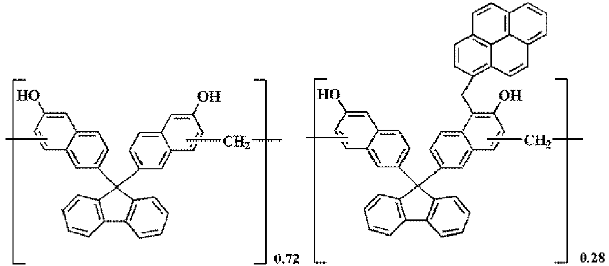

Specific examples of the (A) aromatic ring-containing resin used in the present invention can include resins containing the following structures described in JP 2012-214720 A.

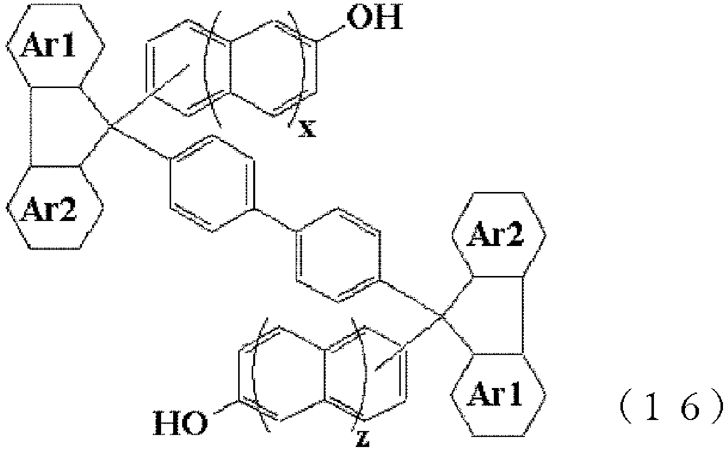

In the formula (16), the ring structures Ar1 and Ar2 each represent a benzene ring or a naphthalene ring. x and z each independently represent 0 or 1. The symbols in the formula are applied only in this formula.

Specific examples of the (A) aromatic ring-containing resin used in the present invention can include resins described in JP 2014-29435 A.

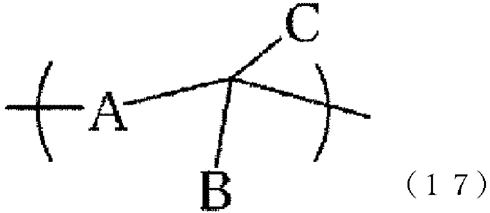

In the formula (17), A represents a structure having carbazole, B represents a structure having an aromatic ring, and C represents a hydrogen atom and a structure having an alkyl group or an aromatic ring, and B and C may form a ring with each other. One to four carboxyl groups or salts thereof or carboxylic acid ester groups are contained in a combined structure of A, B, and C. The symbols in the formula are applied only in this formula.

Examples of the (A) aromatic ring-containing resin used in the present invention include a polymer containing the unit structure represented by the following formula (18) and the unit structure represented by the following formula (19) described in WO 2012/077640 A1, in which the ratio of the unit structure represented by the formula (18) and the unit structure represented by the formula (19) is 3 to 97 : 97 to 3 in a molar ratio.

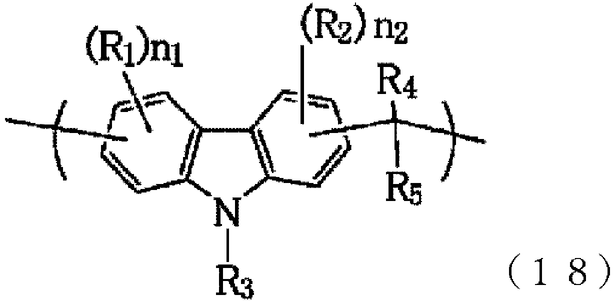

In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of these groups which may include an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of these groups which may include an ether bond, a ketone bond, or an ester bond. R₄ represents a hydrogen atom, or an aryl group having 6 to 40 carbon atoms or heterocyclic group which may be substituted with a halogen atom, a nitro group, an amino group or a hydroxy group, and R₅ represents a hydrogen atom, or an alkyl group having 1 to 10 carbon atoms, aryl group having 6 to 40 carbon atoms, or heterocyclic group which may be substituted with a halogen atom, a nitro group, an amino group or a hydroxy group, and R₄ and R₅ may form a ring with each other. n1 and n2 each represent an integer from 1 to 3. The symbols in the formula are applied only in this formula.

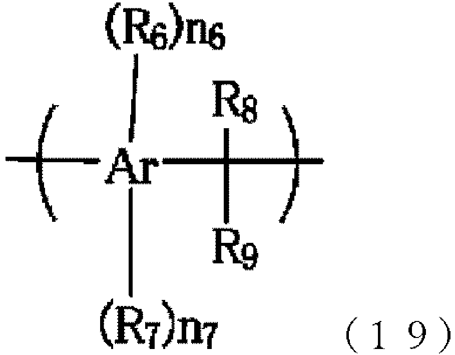

In the formula (19), Ar represents an aromatic ring group having 6 to 20 carbon atoms, R₆ represents a hydroxy group, R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of these groups which may include an ether bond, a ketone bond, or an ester bond. R₈ represents a hydrogen atom, or an aryl group having 6 to 40 carbon atoms or heterocyclic group which may be substituted with a halogen atom, a nitro group, an amino group or a hydroxy group, and R₉ represents a hydrogen atom, or an alkyl group having 1 to 10 carbon atoms, aryl group having 6 to 40 carbon atoms, or heterocyclic group which may be substituted with a halogen atom, a nitro group, an amino group or a hydroxy group, and R₈ and R₉ may form a ring with each other. n6 represents an integer from 1 to p, and n7 represents an integer from p - n6, where p represents the maximum number that can be substituted in the aromatic ring group Ar. The symbols in the formula are applied only in this formula.

Examples of the (A) aromatic ring-containing resin used in the present invention can include a polymer containing a unit structure represented by the following formula (20) described in WO 2010/147155 A1.

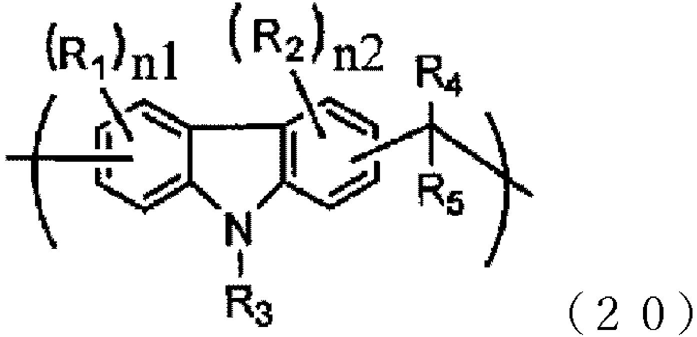

In the formula (20), R₁ and R₂ each are selected from the group consisting of a hydrogen atom, a halogen group, a nitro group, an amino group, a hydroxy group, an alkyl group having 1 to 10 carbon atoms, an alkenyl group having 2 to 10 carbon atoms, an aryl group having 6 to 40 carbon atoms, and a combination thereof, where the alkyl group, the alkenyl group, or the aryl group represents a group that may include an ether bond, a ketone bond, or an ester bond; R₃ is selected from the group consisting of a hydrogen atom, an alkyl group having 1 to 10 carbon atoms, an alkenyl group having 2 to 10 carbon atoms, an aryl group having 6 to 40 carbon atoms, and a combination thereof, where the alkyl group, the alkenyl group, or the aryl group represents a group that may include an ether bond, a ketone bond, or an ester bond; R₄ represents an aryl group having 6 to 40 carbon atoms or heterocyclic group which may be substituted with a halogen atom, a nitro group, an amino group or a hydroxy group, and R₅ represents a hydrogen atom, or an alkyl group having 1 to 10 carbon atoms, aryl group having 6 to 40 carbon atoms, or heterocyclic group which may be substituted with a halogen atom, a nitro group, an amino group or a hydroxy group, and R₄ and R₅ may form a ring together with the carbon atom to which they are attached, and n1 and n2 each are an integer from 1 to 3, respectively. The symbols in the formula are applied only in this formula.

Examples of the (A) aromatic ring-containing resin used in the present invention include a Novolac resin obtained by reacting one or more of the phenols such as phenol, cresol, xylenol, catechol, resorcinol, hydroquinone, pyrogallol, hydroxyquinol, and phloroglucinol with one or more of the aldehyde sources such as formaldehyde, paraformaldehyde, and trioxane using an acid catalyst, and a resin containing a repeating unit structure represented by the following formula (21) described in WO 2012/176767 A1.

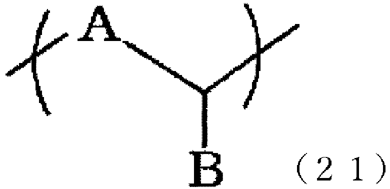

In the formula (21), A represents a hydroxy-group substituted phenylene group derived from a polyhydroxybenzene, and B represents a monovalent fused aromatic hydrocarbon ring group fused with 2 to 6 benzene rings. The symbols in the formula are applied only in this formula.

Examples of the (A) aromatic ring-containing resin used in the present invention can include resins in which a Novolac resin having a fluorine or tetrahydrospiroinden structure described in JP 2005-128509 A, JP 2006-259249 A, JP 2006-259482 A, JP 2006-293298 A, and JP 2007-316282 A has a repeating unit structure represented by the following formula (22-1) or (22-2) :

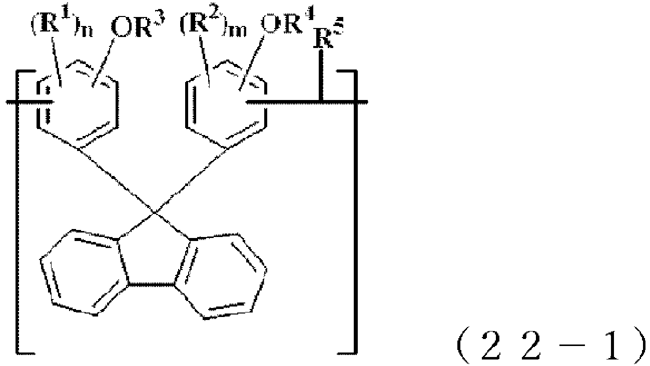

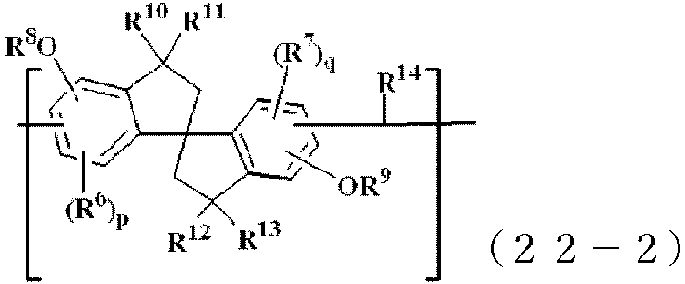

In the formulae (22-1) and (22-2), R¹, R², R⁶, and R⁷ are each independently a hydrogen atom, a linear, branched, or cyclic alkyl group having 1 to 10 carbon atoms, an aryl group having 6 to 10 carbon atoms, an allyl group, or a halogen atom, R³, R⁴, R⁸, and R⁹ are each independently a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group, and R⁵ and R¹⁴ are each independently a hydrogen atom, a linear, branched, or cyclic alkyl group having 1 to 10 carbon atoms, or an aryl group having 6 to 10 carbon atoms. n, m, p, and q each are an integer from 1 to 3**.** R¹⁰ to R¹³ are each independently a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. The symbols in the formula are applied only in this formula.

Examples of the (A) aromatic ring-containing resin used in the present invention can include a reaction product obtained by the method described in JP 2012-145897 A. More specific examples include a polymer obtained by condensing one or more compounds represented by the following formulae (23-1) and/or (23-2) with one or more compounds represented by the following formulae (24-1) and/or (24-2) and/or their equivalents.

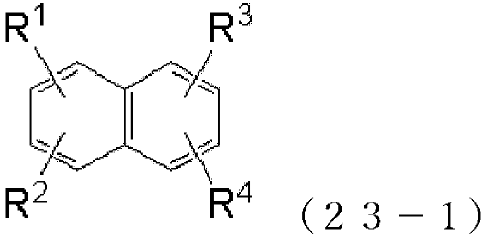

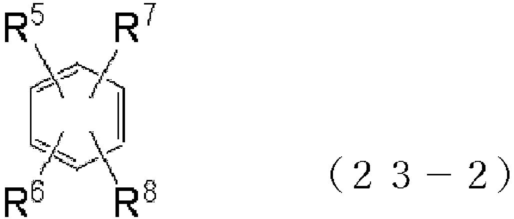

In the formulae (23-1) and (23-2), R¹ to R⁸ are each independently a hydrogen atom, a halogen atom, a hydroxy group, an isocyanato group, a glycidyloxy group, a carboxyl group, an amino group, an alkoxy group having 1 to 30 carbon atoms, an alkoxycarbonyl group having 1 to 30 carbon atoms, an alkanoyloxy group having 1 to 30 carbon atoms, and a saturated or unsaturated organic group having 1 to 30 carbon atoms that may be substituted. In addition, two substituents each optionally selected from R¹ to R⁴ or R⁵ to R⁸ may be bonded in the molecule to form a cyclic substituent. The symbols in the formula are applied only in this formula. 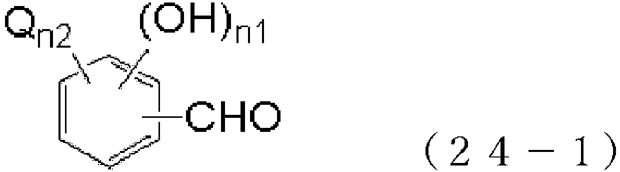 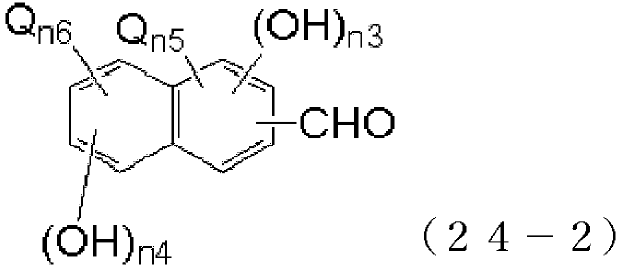 In the formulae (24-1) and (24-2), Q is an organic group having 1 to 30 carbon atoms that may be substituted, and two Qs optionally selected in the molecule may be bonded to form a cyclic substituent, and n1 to n6 are the number of each substituent, and n1 to n6 = 0, 1, or 2. In the formula (24-1), hydroxybenzaldehyde is excluded, and in the formula (24-2), the relationships of 0 ≤ n3 + n5 ≤ 3, 0 ≤ n4 + n6 ≤ 4, and 1 ≤ n3 + n4 ≤ 4 are satisfied. The symbols in the formula are applied only in this formula.

Examples can also include a polymer obtained by condensing one or more compounds represented by the following formulae (23-1) and/or (23-2) with one or more compounds represented by the following formulae (24-1) and/or (24-2) and/or their equivalents, and one or more compounds represented by the following formula (25):

Y-CHO (25)

In the formula (25), Y is a hydrogen atom or a monovalent organic group having 30 or less carbon atoms that may have a substituent, and the formula (25) is different from the formulae (24-1) and (24-2). The symbols in the formula are applied only in this formula.

Examples of the (A) aromatic ring-containing resin used in the present invention can include a compound containing the following structure described in JP 2017-119671 A:

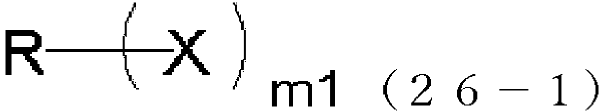

In the formula (26-1), R is a single bond or an organic group having 1 to 50 carbon atoms, X is a group represented by the following formula (26-2), and m1 is an integer satisfying 2 ≤ m1 ≤ 10. The symbols in the formula are applied only in this formula. 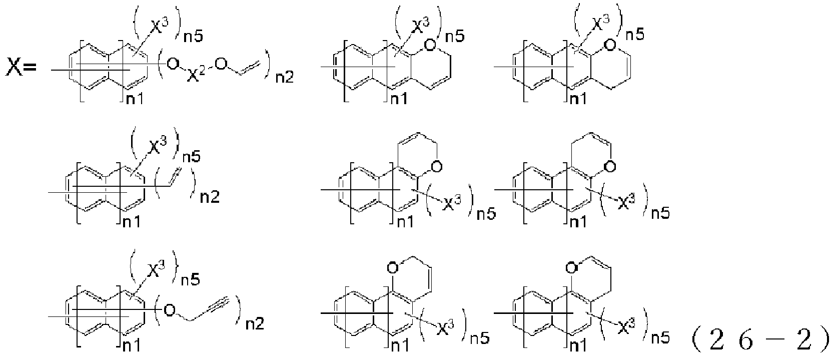
wherein X² is a divalent organic group having 1 to 10 carbon atoms, n1 is 0 or 1, n2 is 1 or 2, X³ is a group represented by the following formula (26-3), and n5 is 0, 1 or 2. The symbols in the formula are applied only in this formula: 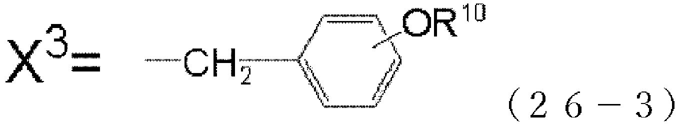
wherein R¹⁰ is a hydrogen atom or a saturated or unsaturated hydrocarbon group having 1 to 10 carbon atoms, and the hydrogen atom on the benzene ring in the formula may be substituted with a methyl group or a methoxy group. The symbols in the formula are applied only in this formula.

Examples of the compound containing the above structure include the following compounds:

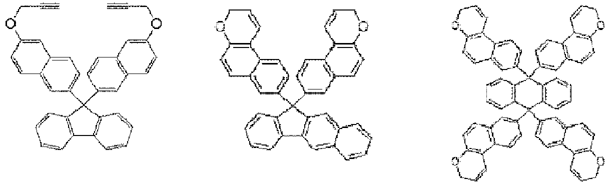

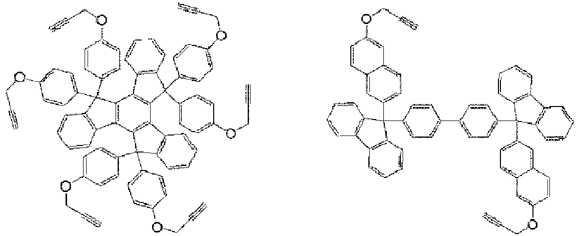

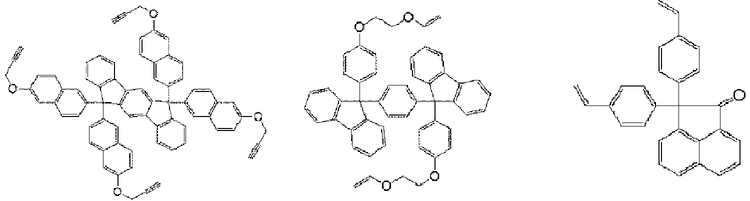

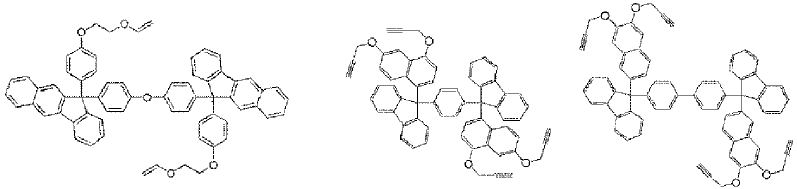

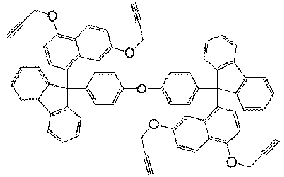

Examples of the (A) aromatic ring-containing resin used in the present invention can include a polymer having a repeating unit represented by the following formula (27-1) described in JP 2019-044022 A:

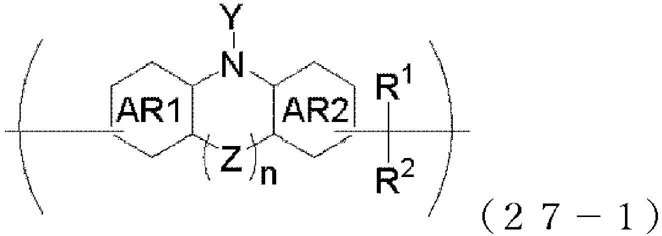

In the formula (27-1), AR1 and AR2 each are a benzene ring or naphthalene ring that may have a substituent, R¹ and R² are each independently a hydrogen atom or an organic group having 1 to 30 carbon atoms, and when R¹ and R² each are an organic group, R¹ and R² may form a cyclic organic group by binding in the molecule. n is 0 or 1, and when n = 0, AR1 and AR2 do not form a bridge structure between the aromatic rings of AR1 and AR2 via Z, and when n = 1, AR1 and AR2 form a bridge structure between the aromatic rings of AR1 and AR2 via Z, and Z is either a single bond or the following formula (27-2). Y is a group represented by the following formula (27-3). The symbols in the formula are applied only in this formula. 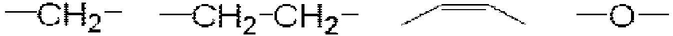 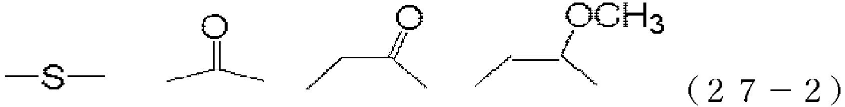 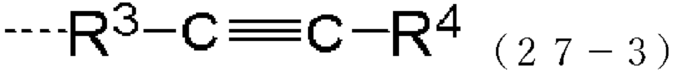 wherein R³ is a single bond or a divalent organic group having 1 to 20 carbon atoms, R⁴ is a hydrogen atom or a monovalent organic group having 1 to 20 carbon atoms, and the dashed line indicates a bonding hand. The symbols in the formula are applied only in this formula.

Examples of the polymer having the repeating unit represented by the formula (27-1) include the following polymers:

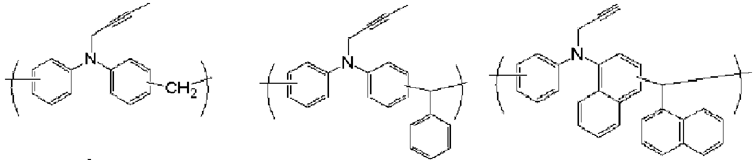

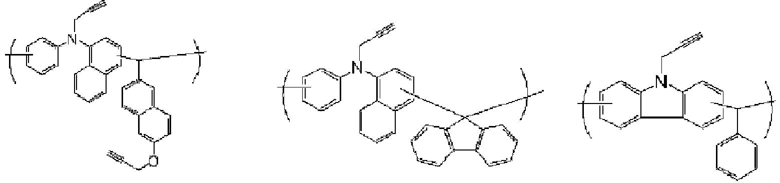

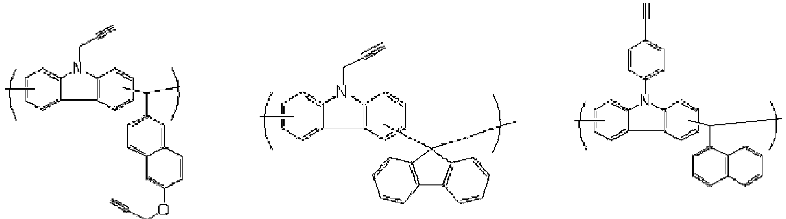

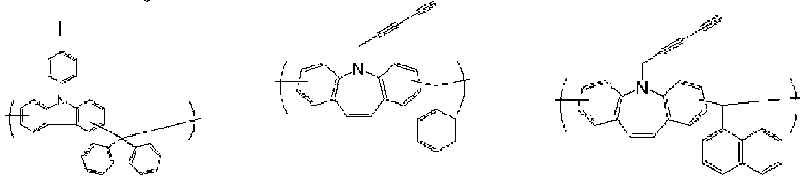

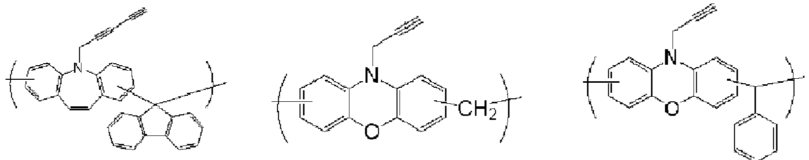

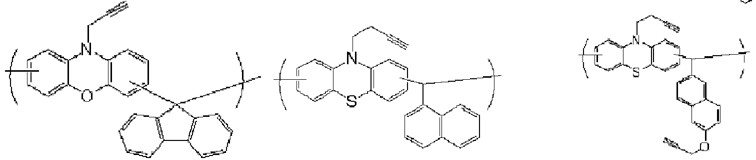

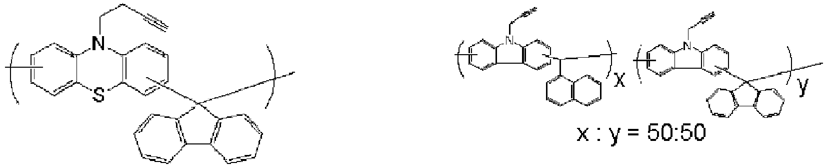

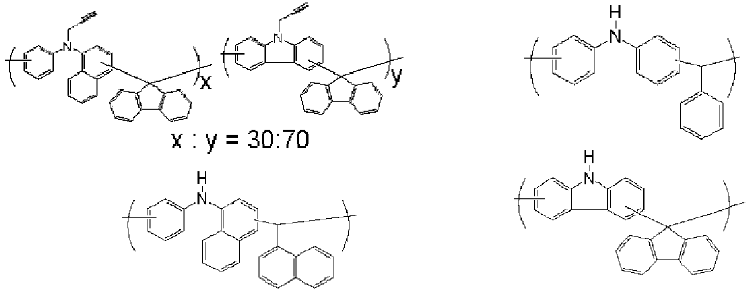

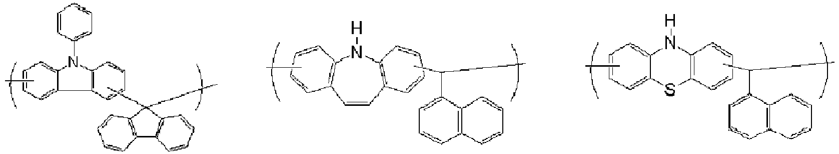

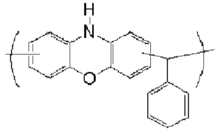

As the aromatic ring-containing resin, only one resin may be used singly, and a plurality of resins having different structures may be used in combination. By using a plurality of aromatic ring-containing resins in combination, the crystallinity is suppressed compared to when a single resin is used, thereby it can be expected that the thermal fluidity is improved and the flatness is further improved.

It is preferable that the (A) aromatic ring-containing resin contains hydrogen at a position in diaryl methylene or hydrogen at a position in trityl from the viewpoint of thermal curability.

The hydrogen atom at a position in diaryl methylene refers to the remaining hydrogen atoms in the structure in which two hydrogen atoms of methane are replaced with an aryl group as shown in the following formula. The hydrogen atom at a position in trityl refers to the remaining hydrogen atom in the structure in which three hydrogen atoms of methane are replaced with an aryl group. The inclusion of these as a partial structure causes an oxidative coupling reaction with dehydrogenation due to heat, and the film can be cured by a crosslinking reaction. The following formula, as a specific example, uses a phenyl group as the aryl group, but the aryl group is not limited thereto.

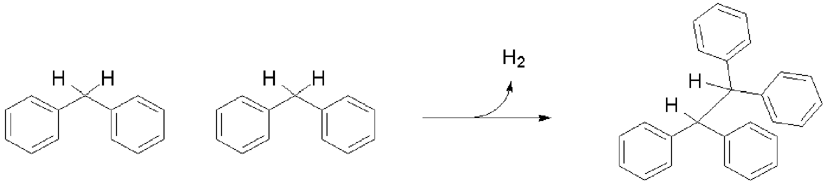

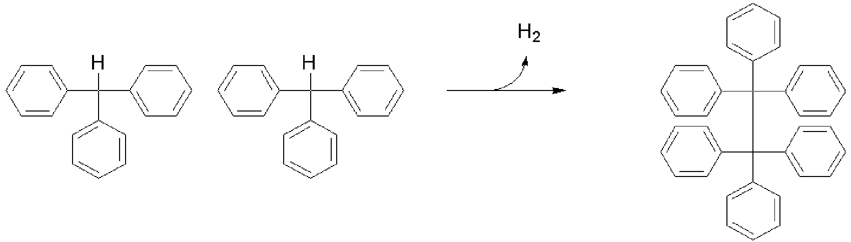

Example of the substituent of the aromatic ring in the (A) aromatic ring-containing resin can include various substituents such as a hydroxy group, an ether group, a carboxy group, a ketone group, an amino group, an alkylamino group, a halogen group, an alkyl group, an alkenyl group, and an alkynyl group, and there is no particular limitation on the substituent that can be used.

When the (A) aromatic ring-containing resin contains a hydroxy group as a substituent, not only the oxidation coupling described above occurs easily, but also a dehydration reaction by the hydroxy groups each other occurs, thus it is possible to form a film having a high density of the crosslinking group and an excellent processing resistance. In addition, since the hydroxy group strongly interacts with the β-diketone structure of (B), the sublimation of the (B) polymer containing the β-diketone structure can be suppressed, and a film having excellent film-forming property can be provided.

It is preferable that the (A) aromatic ring-containing resin is a resin containing any one selected from polymers having a repeating unit represented by the following formula (P-1) or (P-2) and compounds represented by any of formulae (P-3) to (P-6):

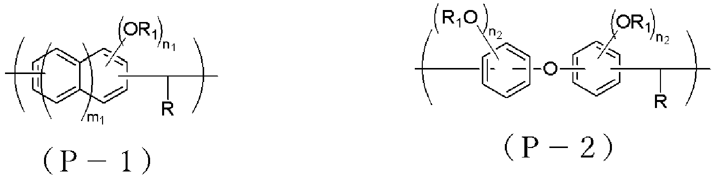

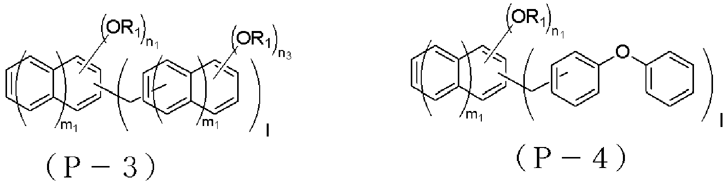

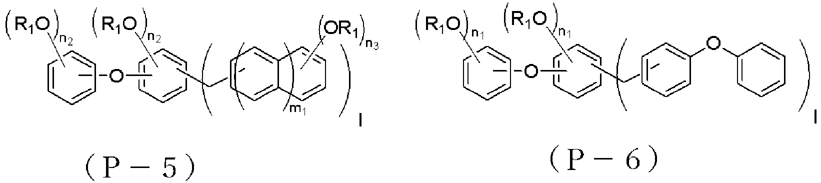

In the formulae (P-1) and (P-2), R is a hydrogen atom or a substituted or unsubstituted benzene ring or naphthalene ring. In (P-1) to (P-6), R1 is a hydrogen atom or a saturated or unsaturated hydrocarbon group having 1 to 20 carbon atoms; in (P-1), (P-3), (P-4) and (P-5), m1 is an integer of 0 or 1; in (P-1), (P-3), (P-4) and (P-6), n1 is an integer from 1 to 4; in (P-2) and (P-5), n2 is an integer of 1 or 2; in (P-3) and (P-5), n3 is an integer from 0 to 2; and in (P-3) to (P-6), l is an integer from 5 to 20, provided that l represents a charge ratio.

In the formulae (P-1) to (P-2), R is a hydrogen atom or a substituted or unsubstituted benzene ring or naphthalene ring, and it is preferable that R is a hydrogen atom or a substituted or unsubstituted benzene ring from the viewpoint of availability of raw materials. In addition, in the case that R is a benzene ring, it is preferable to have the following structure from the viewpoint of thermal curability.

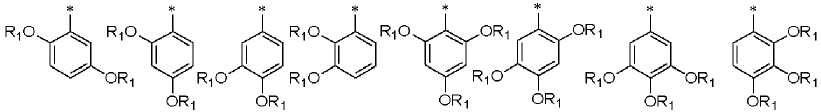

In the formulae, * is the binding portion with the methylene moiety, and R₁ is the same as R₁ of formulae (P-1) to (P-6) described above.

In (P-1) to (P-6), R₁ is a hydrogen atom or a saturated or unsaturated hydrocarbon group having 1 to 20 carbon atoms, but it is preferably a hydrogen atom from the viewpoint of suppressing sublimation due to interaction with the polymer (B) containing a β-diketone structure in a repeating unit, preferably a hydrogen atom or a hydrocarbon group containing an unsaturated bond from the viewpoint of curability with the single resin, and preferably a long-chain saturated hydrocarbon group from the viewpoint of thermal fluidity with the single resin.

In (P-1) to (P-6), specific examples of R₁ other than a hydrogen atom include, but are not limited to, the following structures: 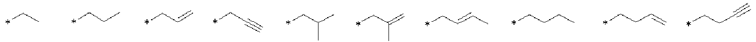 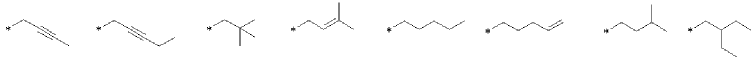 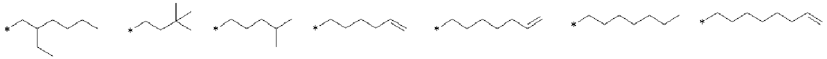 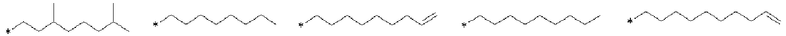 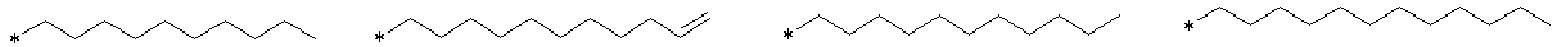 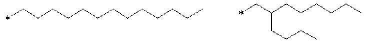 wherein * is an attachment point to the oxygen atom.

### [Method for producing aromatic ring-containing resins (P-1) to (P-2)]

For formulae (P-1) to (P-2), a condensation reaction (STEP 1) is performed using a compound (X) containing an aromatic ring containing a hydroxy group as a substituent, formaldehyde or a benzene ring or naphthalene ring containing an aldehyde as a substituent (Y), and a catalyst. Then, when R₁ is partially etherified as a hydrocarbon group, the resin can be synthesized by etherification (STEP 2) of the obtained condensate with an alkyl halide, alkyl tosylate, or alkyl mesylate (Z) using a catalyst. However, the resin may be finished without the reaction of STEP 2 as one in which all R₁ are hydroxy groups. When the reaction of STEP 2 is carried out, the charge ratio of (Z) used is 0.1 to 0.9 equivalents, more preferably 0.3 to 0.7 equivalents, per 1 equivalent of a hydroxy group. R, R₁, n₁, and m₁ are the same as above, and X represents a halogen group, a mesyl group, or a tosyl group. The reaction formula is described using (P-1) as an example for convenience.

### (STEP 1)

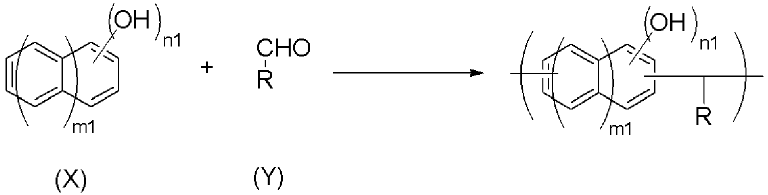

### (STEP 2)

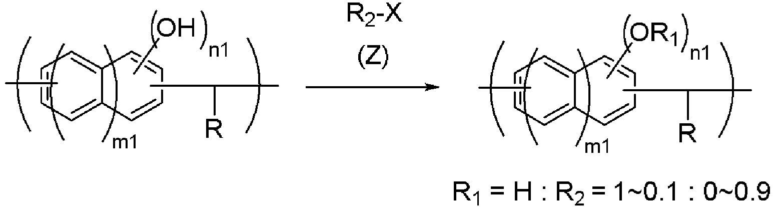

The condensation reaction using (X), (Y), and a catalyst as described above can usually be carried out at room temperature or under cooling or heating as necessary, using an acid or base as a catalyst without a solvent or in a solvent. Examples of the solvent used include alcohols such as methanol, ethanol, isopropyl alcohol, butanol, ethylene glycol, propylene glycol, diethylene glycol, glycerol, methyl cellosolve, ethyl cellosolve, butyl cellosolve, and propylene glycol monomethyl ether; ethers such as diethyl ether, dibutyl ether, diethylene glycol diethyl ether, diethylene glycol dimethyl ether, tetrahydrofuran, and 1,4-dioxane; chlorine-based solvents such as methylene chloride, chloroform, dichloroethane, and trichloroethylene; hydrocarbons such as hexane, heptane, benzene, toluene, xylene, and cumene; nitriles such as acetonitrile; ketones such as acetone, ethyl methyl ketone, and isobutyl methyl ketone; esters such as ethyl acetate, n-butyl acetate, and propylene glycol methyl ether acetate; lactones such as γ-butyrolactone; and non-protonic polar solvents such as dimethyl sulfoxide, N,N-dimethylformamide, N-methyl-2-pyrrolidone, and hexamethylphosphoric triamide. These can be used singly or in combination of two or more. These solvents can be used in the range of 0 to 3,000 parts by mass based on 100 parts by mass of the reaction raw materials.

Examples of the acid catalyst used can include inorganic acids such as hydrochloric acid, hydrobromic acid, sulfuric acid, nitric acid, phosphoric acid, and heteropoly acid; organic acids such as oxalic acid, trifluoroacetic acid, methanesulfonic acid, benzenesulfonic acid, p-toluenesulfonic acid, and trifluoromethanesulfonic acid; and Lewis acids such as aluminum trichloride, aluminum ethoxide, aluminum isopropoxide, boron trifluoride, boron trichloride, boron tribromide, tin tetrachloride, tin tetrabromide, dibutyltin dichloride, dibutyltin dimethoxide, dibutyltin oxide, titanium tetrachloride, titanium tetrabromide, titanium (IV) methoxide, titanium (IV) ethoxide, titanium (IV) isopropoxide, and titanium oxide (IV). Examples of the base catalyst used can include inorganic bases such as sodium hydroxide, potassium hydroxide, barium hydroxide, sodium carbonate, sodium bicarbonate, potassium carbonate, lithium hydride, sodium hydride, potassium hydride, and calcium hydride; alkyl metals such as methyl lithium, n-butyl lithium, methyl magnesium chloride, and ethyl magnesium bromide; alkoxides such as sodium methoxide, sodium ethoxide, and potassium t-butoxide; and organic bases such as triethylamine, diisopropylethylamine, N,N-dimethylaniline, pyridine, and 4-dimethylaminopyridine. The amount used thereof ranges from 0.001 to 100 wt%, preferably from 0.005 to 50 wt%, based on the raw materials. The reaction temperature is preferably from -50°C to about the boiling point of the solvent, and further preferably from room temperature to 130°C.

Examples of the condensation reaction method include a method of charging (X), (Y), and a catalyst in bulk, a method of adding (Y) or a solution in which (Y) is dissolved in a reaction solvent dropwise to (X) in the presence of a catalyst, and a method of adding (X) or a solution in which (X) is dissolved in a reaction solvent dropwise to (Y) in the presence of a catalyst. When synthesizing the resin represented by the above formula (P-1) or (P-2), the amount of (Y) used at this time is preferably 0.7 to 1.2 equivalents, more preferably 0.8 to 1.05 equivalents, based on (X). When synthesizing the resin represented by the above formula (P-3) to (P-6), the amount of (Y) is preferably 5.0 to 20 equivalents, more preferably 6.0 to 15.0 equivalents, based on (X). After the end of the condensation reaction, the unreacted raw materials, catalysts, and the like present in the system can be removed by using a method of increasing temperature of the reaction kettle to 130 to 230°C and removing volatile matters at about 1 to 50 mmHg, a method of adding an appropriate poor solvent or water and reprecipitating the polymer, a method of partitioning the polymer, or the like, according to the natures of the raw materials used and the obtained reaction product. A step of dissolving the obtained condensate in methyl isobutyl ketone, ethyl acetate, or the like, and washing with water can be added.

Furthermore, the subsequent etherification can be performed at room temperature or under cooling or heating as necessary, usually using a base as a catalyst without a solvent or in a solvent. Examples of the solvent used can include alcohols such as methanol, ethanol, isopropyl alcohol, butanol, ethylene glycol, propylene glycol, diethylene glycol, glycerol, methyl cellosolve, ethyl cellosolve, butyl cellosolve, and propylene glycol monomethyl ether; ethers such as diethyl ether, dibutyl ether, diethylene glycol diethyl ether, diethylene glycol dimethyl ether, tetrahydrofuran, and 1,4-dioxane; chlorine-based solvents such as methylene chloride, chloroform, dichloroethane, and trichloroethylene; hydrocarbons such as hexane, heptane, benzene, toluene, xylene, and cumene; nitriles such as acetonitrile; ketones such as acetone, ethyl methyl ketone, and isobutyl methyl ketone; esters such as ethyl acetate, n-butyl acetate, and propylene glycol methyl ether acetate; lactones such as γ-butyrolactone; and non-protonic polar solvents such as dimethyl sulfoxide, N,N-dimethylformamide, hexamethylphosphoric triamide, and N-methylpyrrolidone. These can be used singly or in combination of two or more. These solvents can be used in the range of 0 to 2,000 parts by mass based on 100 parts by mass of the reaction raw materials.

Examples of the base catalyst used can include inorganic bases such as sodium hydroxide, potassium hydroxide, barium hydroxide, sodium carbonate, sodium bicarbonate, potassium carbonate, lithium hydride, sodium hydride, potassium hydride, and calcium hydride, alkyl metals such as methyl lithium, n-butyllithium, methyl magnesium chloride, and ethyl magnesium bromide, alkoxides such as sodium methoxide, sodium ethoxide, and potassium t-butoxide, and organic bases such as triethylamine, diisopropylethylamine, N,N-dimethylaniline, pyridine, and 4-dimethylaminopyridine. The amount used is preferably in the range of 0.5 to 1.5 equivalents, more preferably 1.0 to 1.2 equivalents based on the equivalents of the hydroxy group contained in the raw materials of the condensation reaction. The reaction temperature is preferably from -50°C to about the boiling point of the solvent, and further preferably from room temperature to 130°C.

Examples of the reaction method include a method of charging the condensate, R₂-X (Z), and a catalyst in bulk, a method of adding (Z) or a solution in which (Z) is dissolved in a reaction solvent dropwise to the condensate in the presence of a catalyst, and a method of one in which the condensate is dissolved in a reaction solvent dropwise to (Z) in the presence of a catalyst. The amount of (Z) used at this time is preferably 0.1 to 0.9 equivalents, more preferably 0.3 to 0.7 equivalents, based on the amount of the hydroxy group of the condensate.

After the etherification is completed, a step of washing via liquid-liquid extraction, a step of filtration, or the like described in [Method for Producing Polymer (B)] above can be added as in the polymer (B).

### [Method for producing aromatic ring-containing resins (P-3) to (P-6)]

The compounds represented by the above formulae (P-3) to (P-6) are synthesized by condensation reaction (STEP 1) between a compound (X) containing an aromatic ring containing a hydroxy group and a benzene ring, naphthalene ring, diphenyl ether, or the like (W) containing a methylol group or a methoxymethyl group, using a catalyst. R₁ is then introduced by an etherification reaction. Then, the resin can be synthesized by etherification (STEP 2) of the condensate obtained by the reaction of STEP 1 and an alkyl halide, alkyl tosylate, or alkyl mesylate (Z) using a catalyst. However, the resin may be finished without the reaction of STEP 2 as one in which all R₁ are hydroxy groups. When the reaction of STEP 2 is carried out, the charge ratio of (Z) used is 0.1 to 0.9 equivalents, more preferably 0.3 to 0.7 equivalents, per 1 equivalent of a hydroxy group. R, R₁, n₁, n₃, m1, and l are the same as above, and X represents a halogen group, a mesyl group, or a tosyl group. The reaction formula is described using (P-3) as an example for convenience.

### (STEP 1)

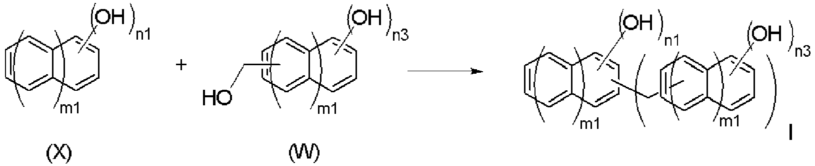

### (STEP 2)

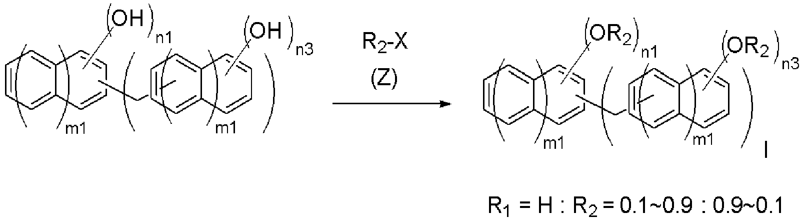

The notations of the formulae (P-3) to (P-6) of the aromatic ring-containing resin herein will be described.

Although the products in the condensation reaction of formulae (X) and (W) described above are described in a manner in which an aromatic ring containing a methylol group or a methoxymethyl group is condensed to a parent core, l represents herein a charge ratio of synthetic raw materials in a synthesis reaction of an aromatic ring-containing resin (P-3) to (P-6). For example, when a condensation reaction is carried out using 1 equivalent of 2,3-dihydroxynaphthalene as (X) and 12 equivalents of 4-hydroxybenzyl alcohol as (W), l = 12 is described.

Of the synthesis reaction of the compound of the above formula, in the reaction in which 4-hydroxybenzyl alcohol (W) is condensed to 2,3-dihydroxynaphthalene (X) (reaction formula (a)), a maximum of 6 equivalents of 4-hydroxybenzyl alcohol can be reacted because the high reaction activity positions of 2,3-dihydroxynaphthalene (X) are 6 hydrogen atoms in the aromatic ring. Concurrently with this reaction, a condensation reaction between 4-hydroxybenzyl alcohols (W) (reaction formula (b)) occurs. As a result, the product of the reaction is a complex mixture of the two reactions (a) and (b). Since the reaction amount of 4-hydroxybenzyl alcohol is equal to the charge equivalent to the product of this reaction, the charge ratio is represented by l, and the product is represented with the following formula (c).

In this synthesis reaction, 2,3-dihydroxynaphthalene plays a role similar to a capping agent in the condensation reaction between 4-hydroxybenzyl alcohols, and is believed to have an effect of adjusting Mw of the product, thereby preventing a decrease in the fluidity of the resin due to an increase in the molecular weight.

Since 2,3-dihydroxynaphthalene does not have a reactive functional group as described above, the following formula is obtained when 0.5 equivalents of propargyl bromide is reacted as a halogenated alkyl per 1 equivalent of a hydroxy group of the entire resin after condensation. In this case, since it is randomly introduced into the hydroxy groups of the resin, it becomes a mixture of different hydroxy group equivalents, and the presence ratio 0.5 : 0.5 of the hydroxy group of the entire resin and the propargyl ether means that 50% is propargyl etherified.

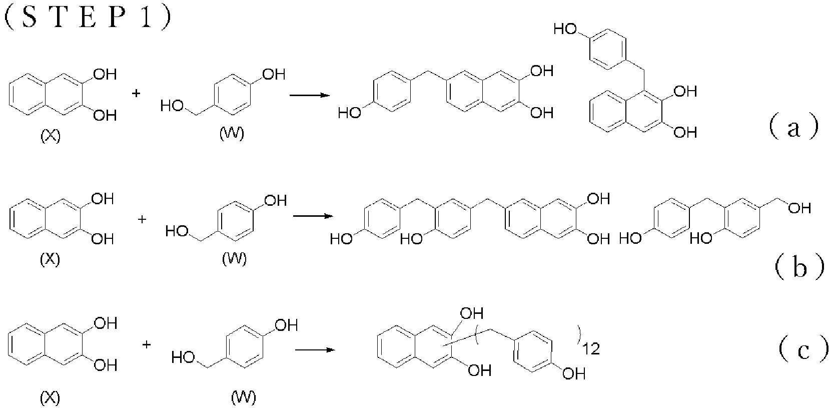

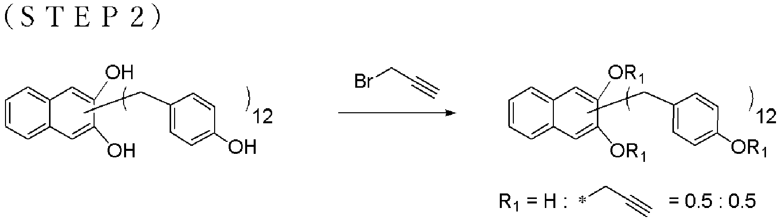

The condensation reaction using (X), (W), and the catalyst described above can be performed according to the method described in (STEP 1) above only by changing (Y) to (W).

It is preferable that the weight average molecular weight Mw of the (A) aromatic ring-containing resin obtained in this manner in terms of polystyrene by gel permeation chromatography method is 1,000 or more and 20,000 or less. When the weight average molecular weight Mw is in such a range, the resin is difficult to sublimate at high temperatures, does not cause film formation failure, and can suppress embedding failure due to too large molecular weight and deterioration of flatness due to thermal fluidity failure.

Hereinafter, components that can be contained in the composition for forming an organic film of the present invention other than the (A) aromatic ring-containing resin and the (B) polymer containing a β-diketone structure in a repeating unit will be described.

### <(C) Solvent>

The (C) solvent that can be used in the composition for forming an organic film of the present invention is not particularly limited as long as it dissolve (A) one or more of polymers containing an aromatic ring described above, (B) a polymer containing a β-diketone structure in a repeating unit, (D) a crosslinking agent, (E) a surfactant, and other additives.

Specifically, an organic solvent described in paragraphs [0091] to [0092] of JP 2007-199653 A can be added. More specifically, propylene glycol monomethyl ether acetate, propylene glycol monomethyl ether, propylene glycol monoethyl ether, propylene glycol monopropyl ether, 2-heptanone, cyclopentanone, cyclohexanone, and γ-butyrolactone, or a mixture containing one or more of these are preferably used.

The amount of the organic solvent is preferably in the range of 200 to 10,000 parts by mass, more preferably 250 to 5,000 parts by mass, based on 100 parts by mass of the (A) aromatic ring-containing resin.

### <High boiling point solvent>

In the composition for forming an organic film of the present invention, the (C) solvent may be a mixture of one or more solvents having a boiling point of lower than 180°C and one or more solvents having a boiling point of 180°C or higher (high boiling point solvents).

The high boiling point solvent is not particularly limited as long as the high boiling point solvent can dissolve each component of the aromatic ring-containing resin of the present invention, so that the solvent does not limited to hydrocarbons, alcohols, ketones, esters, ethers, chlorine-based solvents, or the like. Specific examples can include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, and dibutyl adipate. These may be used singly or in combination.

The high boiling point solvent may be appropriately selected, for example, from those described above according to the temperature of heat-treating the composition for forming an organic film of the present invention, or the like. The boiling point of the high boiling point solvent is preferably 180°C to 300°C, further preferably 200°C to 300°C. With such a boiling point, there is no risk that the volatilization during baking (heat treatment) becomes too fast, thus it is believed that sufficient thermal fluidity during film formation can be obtained, and an organic film with excellent embedding/planarization properties can be formed. With such a boiling point, it will not remain in the film without volatilizing after baking, thus there is no risk of adversely affecting the film properties such as etching resistance.

The amount of the high boiling point solvent when used is preferably 1 to 30 parts by mass based on 100 parts by mass of the organic solvent having a boiling point of lower than 180°C. Such an amount is preferable because it can impart sufficient thermal fluidity during baking, and does not lead to deterioration of film physical properties such as etching resistance because it does not remaining in the film.

The composition is a composition usable as an organic film for use in a multi-layer resist method, and can further contain one or more of (D) a crosslinking agent and (E) a surfactant.

Hereinafter, the (D) crosslinking agent and the (E) surfactant will be described.

### [(D) Crosslinking agent]

The composition for forming an organic film of the present invention can further contain (D) a crosslinking agent to increase the density of the film and further inhibit intermixing with the resist upper layer film. The crosslinking agent is not particularly limited, and various known crosslinking agents can be widely used. Examples can include melamine-based crosslinking agents, acrylate-based crosslinking agents, glycoluryl-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, phenolic-based crosslinking agents such as a methylol or alkoxymethyl-based crosslinking agents of polynuclear phenols, epoxy-based crosslinking agents, and oxetane-based crosslinking agents. The content of the (D) crosslinking agent is preferably 5 to 50 parts by mass, more preferably 10 to 40 parts by mass, based on 100 parts by mass of one or more of the (A) aromatic ring-containing polymers.

Specific examples of the melamine-based crosslinking agents can include hexamethoxymethylated melamine, hexabutoxymethylated melamine, alkoxy and/or hydroxy-substituted derivatives thereof and partially self-condensates thereof.

Specific examples of the acrylate-based crosslinking agents can include dipentaerythritol hexaacrylate.

Specific examples of the glycoluryl-based crosslinking agent can include tetramethoxymethylated glycoluryl, tetrabutoxymethylated glycoluryl, alkoxy and/or hydroxy-substituted derivatives thereof and partially self-condensates thereof.

Specific examples of the benzoguanamine-based crosslinking agents can include tetramethoxymethylated benzoguanamine, tetrabutoxymethylated benzoguanamine, alkoxy and/or hydroxy-substituted derivatives thereof and partially self-condensates thereof.

Specific examples of the urea-based crosslinking agent can include dimethoxymethylated dimethoxyethylene urea, alkoxy and/or hydroxy-substituted derivatives thereof and partially self-condensates thereof.

Specific examples of the β-hydroxyalkylamide-based crosslinking agent can include N,N,N',N'-tetra(2-hydroxyethyl)adipic acid amide.

Specific examples of the isocyanurate-based crosslinking agent can include triglycidyl isocyanurate and triallyl isocyanurate.

Specific examples of the aziridine-based crosslinking agent can include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agent include 2,2'-isopropylidenebis(4-benzyl-2-oxazoline), 2,2'-isopropylidenebis(4-phenyl-2-oxazoline), 2,2'-isopropylidenebis(4-phenyl-2-oxazoline), 2,2'-methylenebis-4,5-diphenyl-2-oxazoline, 2,2'-methylenebis-4-phenyl-2-oxazoline, 2,2'-methylenebis-4-tert-butyl-2-oxazoline, 2,2'-bis(2-oxazoline), 1,3-phenylenebis(2-oxazoline), 1,4-phenylenebis(2-oxazoline), and a 2-isopropenyloxazoline copolymer.

Specific examples of the multinuclear phenolic crosslinking agent can include a compound represented by the following formula (XL-1): 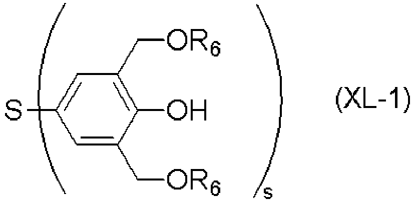 wherein S is a single bond or an s-valent hydrocarbon group having 1 to 20 carbon atoms, R₆ is a hydrogen atom or an alkyl group having 1 to 20 carbon atoms, s is an integer from 1 to 5. Here, the definition of R₆ relates to R₆ in the formula (XL-1).

S is a single bond or an s-valent hydrocarbon group having 1 to 20 carbon atoms. "s" is an integer from 1 to 5, more preferably 2 or 3. Specific examples of the S include a group excluding q hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₆ is a hydrogen atom or an alkyl group having 1 to 20 carbon atoms. Specific examples of the alkyl group having 1 to 20 carbon atoms can include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group, and preferably a hydrogen atom or a methyl group.

Specific examples of the compound represented by the above formula (XL-1) can include the following compounds. Among them, the hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene are preferred from the viewpoint of improving the curability and thickness uniformity of the organic film. R₆ is the same as described above.

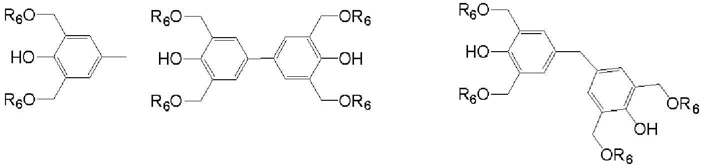

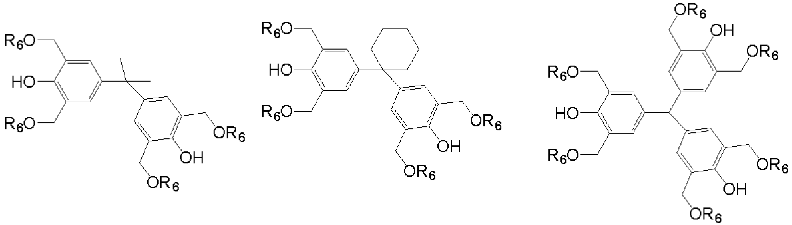

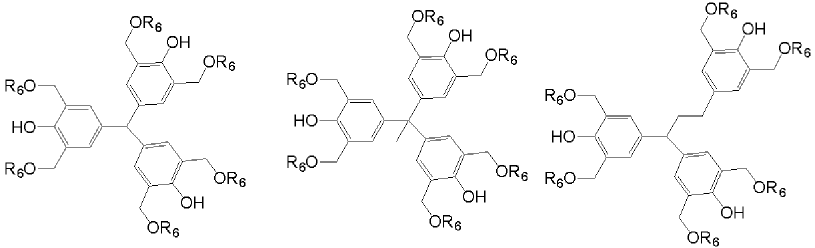

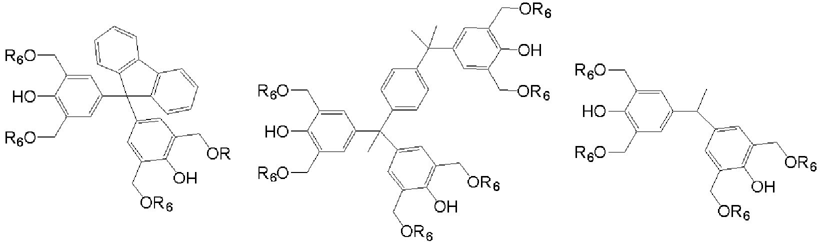

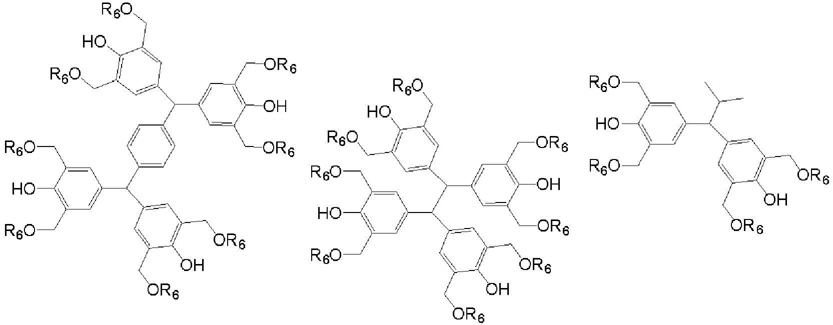

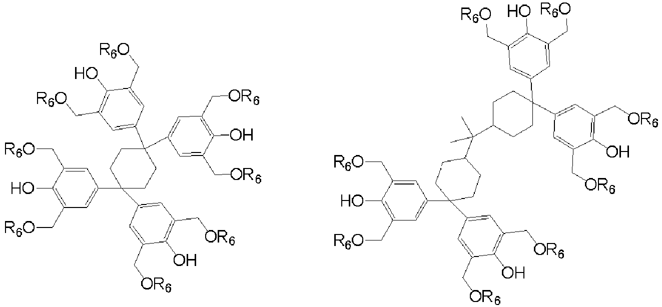

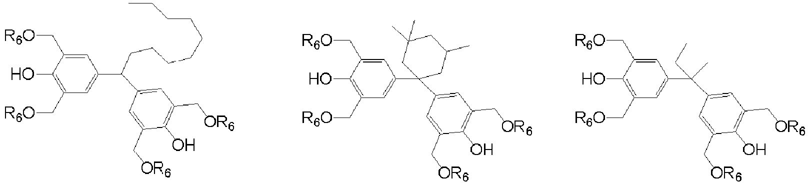

Examples of the epoxy-based crosslinking agent and the oxetane-based crosslinking agent include the monomer type and the polymer type, and specific examples of the monomer type include, but are not limited to, the following.

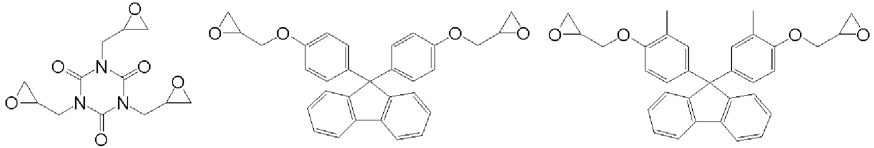

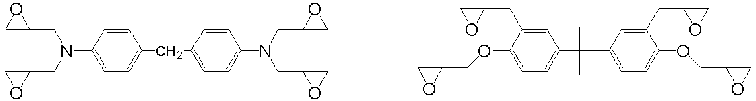

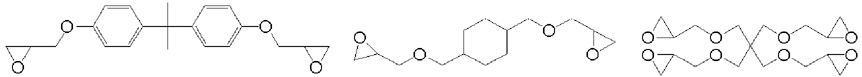

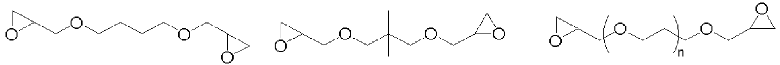

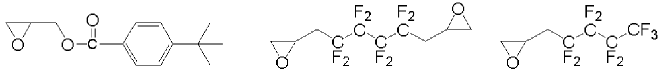

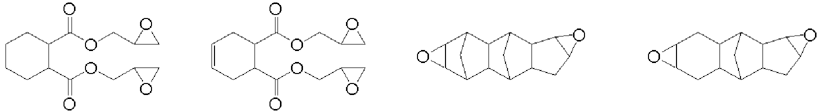

Although some of the above compounds are commercially available, the epoxy-based crosslinking agent and the oxetane-based crosslinking agent can also be obtained by reacting an epibromohydrin, 3-bromomethyloxetane or the like with a hydroxy group as follows. In the formula, R is a substituted or unsubstituted, saturated monovalent organic group having 1 to 20 carbon atoms or substituted or unsubstituted, unsaturated monovalent organic group having 2 to 20 carbon atoms, a substituted or unsubstituted aryl group having 6 to 30 carbon atoms, and a substituted or unsubstituted arylalkyl group having 7 to 31 carbon atoms. It is also possible to leave all the hydroxy groups without reacting. At this time, it is preferable that the number of epoxy + oxetane > the number of hydroxy groups, and more preferable that the number of epoxy + oxetane > the number of hydroxy groups * 2. The content of these compounds is preferably 5 to 50 parts by mass, more preferably 10 to 40 parts by mass, based on 100 parts by mass of the (A) aromatic ring-containing resin.

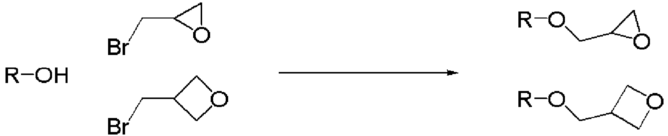

Specific examples of the compound having a hydroxy group that can be used for the above reaction include, but are not limited to, the following.

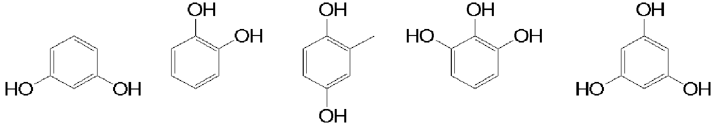

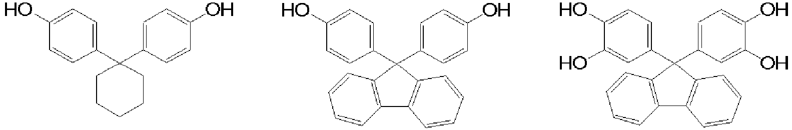

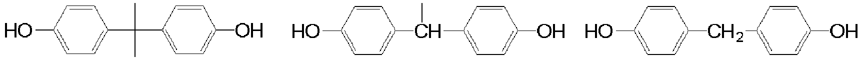

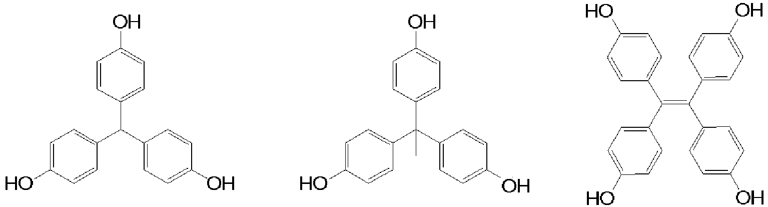

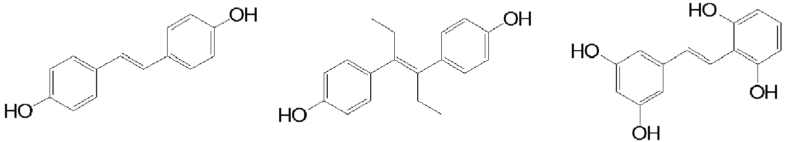

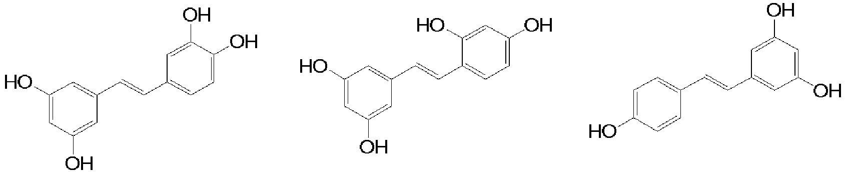

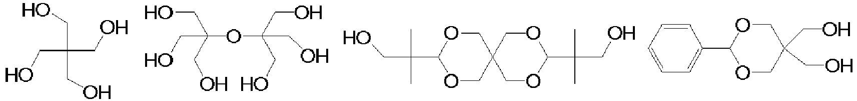

Specific examples of the polymer type include a polymer in which the molar content of the repeating unit represented by the following formula (XL-2) or (XL-3) is 20% or more. When the molar content of the structural unit represented by the formula (XL-2) or (XL-3) does not reach 100% in total, α,β-unsaturated carboxylic acid esters such as any other structural units derived from other acrylic acid esters, other methacrylic acid esters, other acrylic acid amides, other methacrylic acid amides, crotonic acid esters, maleic acid esters, and itaconic acid esters; α,β-unsaturated carboxylic acids such as methacrylic acid, acrylic acid, maleic acid, and itaconic acid; acrylonitrile; methacrylonitrile; α,β-unsaturated lactones such as 5,5-dimethyl-3-methylene-2-oxotetrahydrofuran; cyclic olefins such as norbornene derivatives and tetracyclo[4.4.0.12,5.17,10]dodecene derivatives; α,β-unsaturated carboxylic anhydrides such as maleic acid anhydride and itaconic acid anhydride; allyl ethers; vinyl ethers; vinyl esters; or vinyl silanes can be used in combination. It is preferred that these polymers have a weight average molecular weight of 1,000 to 20,000, and a GPC dispersity of 2.0 or less. The content of these compounds is preferably 5 to 50 parts by mass, more preferably 10 to 40 parts by mass, based on 100 parts by mass of the (A) aromatic ring-containing resin. 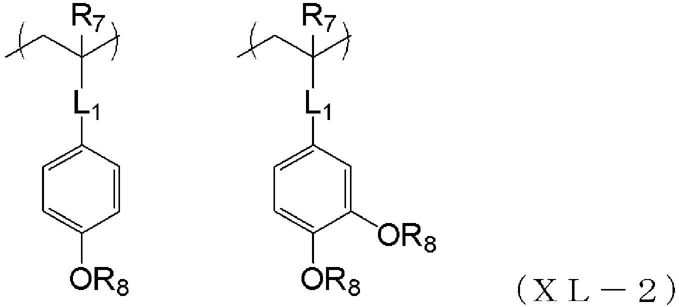 wherein R₇ is a hydrogen atom or a methyl group, R₈ is a hydrogen atom or a group selected from the formulae (2-1) to (2-3) below, and L₁ represents a single bond, - C(=O)O- or a divalent organic group containing C(=O)NH- or C(=O)NCH₃-.

For R₈ in the above formula (XL-2), it is preferable that the number of groups (2-1) to (2-3) > the number of hydrogen atoms, more preferably the number of groups (2-1) to (2-3) > the number of hydrogen atoms * 2, from the viewpoint of curability. 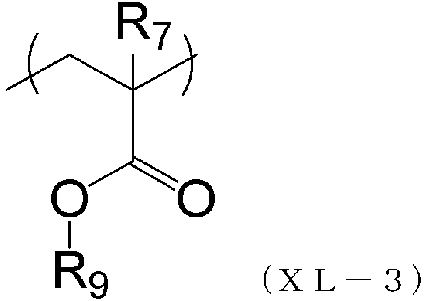 wherein R₇ is a hydrogen atom or a methyl group and R₉ is a group selected from the formulae (2-1) to (2-3) below. 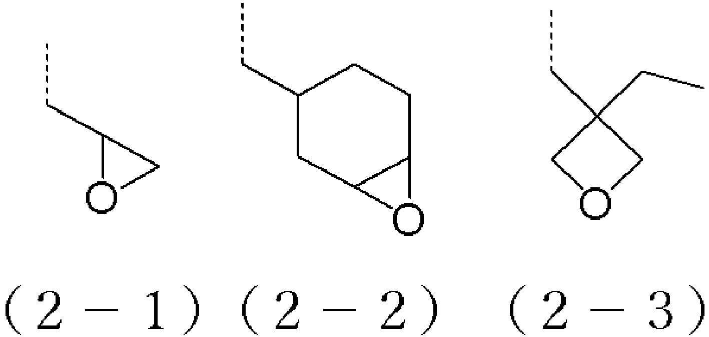 In the formula, the dashed line indicates a bonding hand.

### <(E) Surfactant>

In the composition for forming an organic film of the present invention, the (E) surfactant can be contained to improve the applicability in spin-coating. Examples of the surfactant can include those described in [0142] to [0147] of JP 2009-269953 A. The amount of the surfactant when added is preferably in the range of 0.01 to 10 parts, more preferably 0.05 to 5 parts by mass, based on 100 parts by mass of one or more of the (A) aromatic ring-containing polymers.

### <Method for Forming Organic Film>

The present invention provides a method for forming an organic film that functions as an organic flat film used in a process for manufacturing a semiconductor device, including: spin-coating a substrate to be processed with the composition for forming an organic film described above; and heat-treating the substrate coated with the composition for forming an organic film at a temperature of 100°C or higher and 600°C or lower for a period of time of 10 to 600 seconds to form a cured film.

The present invention also provides a method for forming an organic film that functions as an organic flat film used in a process for manufacturing a semiconductor device including: spin-coating a substrate to be processed with the composition for forming an organic film described above; and heat-treating the substrate coated with the composition for forming an organic film in an atmosphere having an oxygen concentration of 0.1% or more and 21% or less to form a cured film.

It is also preferable that the substrate to be processed is a substrate to be processed having a structure or step with a height of 30 nm or more.

### <Patterning Process>

### [Three-layer Resist Process Using Silicon-Containing Resist Middle layer Film]

The present invention also provides a patterning process including: forming an organic film on a body to be processed using the composition for forming an organic film described above; forming a resist middle layer film on the organic film using a resist middle layer film material containing a silicon atom; forming a resist upper layer film on the resist middle layer film using a resist upper layer film material including a photoresist composition; forming a circuit pattern on the resist upper layer film; transferring a pattern by etching to the resist middle layer film using the resist upper layer film on which the circuit pattern is formed as a mask; transferring a pattern by etching to the organic film using the resist middle layer film on which the pattern is transferred as a mask; and further transferring a pattern by etching to the body to be processed using the organic film on which the pattern is transferred as a mask.

As the body to be processed, it is preferable to use a semiconductor device substrate or one in which any of a metal film, a metal carbide film, a metal oxide film, a metal nitride film, a metal oxide carbonate film, or a metal oxide nitride film is formed on the semiconductor device substrate. More specific examples include, but are not particularly limited to, a substrate of Si, α-Si, p-Si, SiO2, SiN, SiON, W, TiN, Al, or the like, and one in which the metal film or the like described above is formed on the substrate as a layer to be processed.

Various Low-k films of Si, SiO2, SiON, SiN, p-Si, α-Si, W, W-Si, Al, Cu, Al-Si, or the like and stopper films thereof may be used as the layer to be processed. The layer is typically formed to a thickness of 50 to 10,000 nm, particularly 100 to 5,000 nm. Note that, when the layer to be processed is formed, a material of the substrate used is different from that of the layer to be processed.

The metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy of these.

When forming an organic film on the body to be processed using the composition for forming an organic film of the present invention, the above-described method for forming an organic film of the present invention may be applied.

Next, a resist middle layer film (silicon-containing resist middle layer film) is formed using a resist middle layer film material containing a silicon atom on the organic film. As the resist middle layer material containing a silicon atom, a polysiloxane-based underlayer film material is preferred. Reflection can be suppressed by using a silicon-containing resist middle layer film having an anti-reflection effect. Especially for 193 nm exposure, when a material containing a large number of aromatic groups and having a high etching selectivity with a substrate is used as the composition for forming an organic film, the k value is higher and the substrate reflection is higher, but when the material has an absorption such that the k value is appropriate for a silicon-containing resist middle layer film, it is possible to suppress the reflection and make the substrate reflection 0.5% or less. For the silicon-containing resist middle layer film having an anti-reflection effect, polysiloxanes that has anthracene for 248 nm and 157 nm exposures and a phenyl group or a light-absorbing group having a silicone-silicon bond for 193 nm exposure in a pendant structure, and is crosslinked with an acid or heat are preferably used.

Next, a resist upper layer film is formed on the resist middle layer film using a resist upper layer film material including a photoresist composition. The resist upper layer film material can be ether a positive type or a negative type, and can be the same as the commonly-used photoresist composition. After spin-coating with the resist upper layer film material, it is preferable to perform pre-baking at 60 to 180°C for 10 to 300 seconds. After that, the exposure is performed according to the normal method, and then post-exposure baking (PEB) and development are performed to obtain a resist upper layer film pattern. The thickness of the resist upper layer film is not particularly limited, but 30 to 500 nm is preferred, and 50 to 400 nm is particularly preferred.

Next, a circuit pattern (resist upper layer film pattern) is formed on the resist upper layer film. In forming a circuit pattern, it is preferable to form the circuit pattern by lithography using light with a wavelength of 10 nm or more and 300 nm or less, direct drawing by electron rays, nano-imprinting, or a combination of these.

Examples of the exposure light include high-energy rays with a wavelength of 300 nm or less, such as far-ultraviolet rays, KrF excimer laser light (248 nm), ArF excimer laser light (193 nm), F2 laser light (157 nm), Kr2 laser light (146 nm), Ar2 laser light (126 nm), 3-20 nm soft X-rays (EUV), electron beam (EB), ion beam, and X-rays.

In the formation of a circuit pattern, it is preferable to develop the circuit pattern using alkali development or an organic solvent.

Next, a pattern is transferred by etching to the resist middle layer film using the resist upper layer film on which the circuit pattern is formed as a mask. The etching of the resist middle layer film using the resist upper layer film pattern as a mask is preferably performed using a fluorocarbon-based gas. This forms a silicon-containing resist middle layer film pattern.

Next, a pattern is transferred by etching to an organic film using the resist middle layer film on which the pattern is transferred as a mask. Since the silicon-containing resist middle layer film exhibits etching resistance by oxygen gas or hydrogen gas, the etching of the organic film using the silicon-containing resist middle layer film pattern as a mask is preferably performed using an etching gas mainly composed of oxygen gas or hydrogen gas. This forms an organic film pattern.

Next, a pattern is transferred by etching to a body to be processed using the organic film on which the pattern is transferred as a mask. The next etching of the body to be processed (layer to be processed) can be performed by conventional methods. For example, etching based on fluorine-based gas is performed when the body to be processed is a SiO2, SiN, or silica-based low dielectric constant insulating film, while etching based on chlorine or bromine-based gas is performed when the body to be processed is p-Si, Al, or W. When the substrate processing is performed by etching with a fluorine-based gas, the silicon-containing resist middle layer film pattern is peeled off at the same time as the substrate processing. On the other hand, when the substrate processing is performed by etching with a chlorine-based or bromine-based gas, it is necessary to separately perform dry etching peeling with a fluorine-based gas after the substrate processing to peel off the silicon-containing resist middle layer pattern.

The organic film obtained using the composition for forming an organic film of the present invention can have excellent etching resistance during etching of the body to be processed as described above.

### [Four-layer resist process using silicon-containing resist middle layer film and organic anti-reflection film]

The present invention also provides a patterning process including: forming an organic film on a body to be processed using the composition for forming an organic film described above; forming a resist middle layer film on the organic film using a resist middle layer film material containing a silicon atom; forming an organic anti-reflection film on the resist middle layer film; forming a resist upper layer film on the organic anti-reflection film using a resist upper layer film material including a photoresist composition; forming a circuit pattern on the resist upper layer film; transferring a pattern by etching to the organic anti-reflection film and the resist middle layer film using the resist upper layer film on which the circuit pattern is formed as a mask; transferring a pattern by etching to the organic film using the resist middle layer film on which the pattern is transferred as a mask; and further transferring a pattern by etching to the body to be processed using the organic film on which the pattern is transferred as a mask.

This method can be performed in the same manner as the three-layer resist process using the silicon-containing resist middle layer film described above except that an organic anti-reflection film (BARC) is formed between the resist middle layer film and the resist upper layer film.

The organic anti-reflection film can be formed by spin-coating using a known organic anti-reflection film material.

### [Three-layer resist process using inorganic hard mask]

The present invention also provides, as a patterning process by three-layer resist process using a composition for forming an organic film, a patterning process including: forming an organic film on a body to be processed using the composition for forming an organic film described above; forming an inorganic hard mask selected from a silicon oxide film, a silicon nitride film, and a silicon oxide nitride film on the organic film; forming a resist upper layer film on the inorganic hard mask using a resist upper layer film material including a photoresist composition; forming a circuit pattern on the resist upper layer film; transferring a pattern by etching to the inorganic hard mask using the resist upper layer film on which the circuit pattern is formed as a mask; transferring a pattern by etching to the organic film using the inorganic hard mask on which the pattern is transferred as a mask; and further transferring a pattern by etching to the body to be processed using the organic film on which the pattern is transferred as a mask.

This method can be performed in the same manner as the three-layer resist process using the silicon-containing resist middle layer film described above except that an inorganic hard mask is formed on the organic film instead of the resist middle layer film.

The inorganic hard mask selected from a silicon oxide film, a silicon nitride film, and a silicon oxide nitride film (SiON film) can be formed by a CVD method, an ALD method, or the like. For example, a method of forming a silicon nitride film is described in JP 2002-334869 A, WO 2004/066377 A1, and the like. The film thickness of the inorganic hard mask is preferably 5 to 200 nm, more preferably 10 to 100 nm. As an inorganic hard mask, a SiON film having a high effect as an anti-reflection film is most preferably used. Since the substrate temperature when forming the SiON film is 300 to 500°C, it is necessary for a lower layer film to withstand a temperature of 300 to 500°C. Since the organic film formed using the composition for forming an organic film of the present invention has high heat resistance and can withstand a high temperature of 300°C to 500°C, it is possible to combine an inorganic hard mask formed by a CVD method or an AL method with an organic film formed by a spin-coating method.

### [Four-layer resist process using inorganic hard mask and organic anti-reflection film]

The present invention also provides, as a patterning process by four-layer resist process using a composition for forming an organic film, a patterning process including: forming an organic film on a body to be processed using the composition for forming an organic film described above; forming an inorganic hard mask selected from a silicon oxide film, a silicon nitride film, and a silicon oxide nitride film on the organic film; forming an organic anti-reflection film on the inorganic hard mask; forming a resist upper layer film on the organic anti-reflection film using a resist upper layer film material including a photoresist composition; forming a circuit pattern on the resist upper layer film; transferring a pattern by etching to the organic anti-reflection film and the inorganic hard mask using the resist upper layer film on which the circuit pattern is formed as a mask; transferring a pattern by etching to the organic film using the inorganic hard mask on which the pattern is transferred as a mask; and further transferring a pattern by etching to the body to be processed using the organic film on which the pattern is transferred as a mask.

This method can be performed in the same manner as the three-layer resist process using the above inorganic hard mask except that an organic anti-reflection film (BARC) is formed between the inorganic hard mask and the resist upper layer film.

In particular, when a SiON film is used as the inorganic hard mask, it is possible to suppress reflection even in a high NA immersion exposure exceeding 1.0 by a two-layer anti-reflection film of the SiON film and BARC. Another advantage of forming BARC is that it has an effect of reducing the foot formation in the resist upper layer film pattern directly above the SiON film.

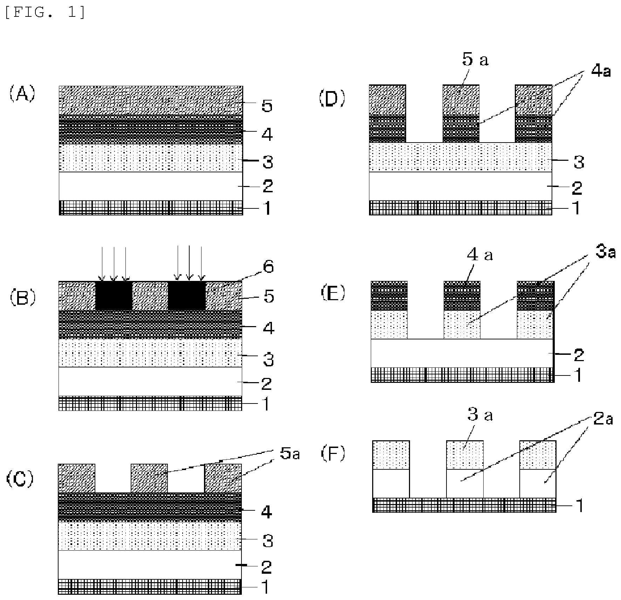

Here, an example of the patterning process by the three-layer resist process of the present invention is shown in FIGs. 1(A) to 1(F). In the case of a three-layer resist process, as shown in FIG. 1(A), an organic film 3 is formed on a layer to be processed 2 formed on a substrate 1 using the composition for forming an organic film of the present invention, and then a silicon-containing resist middle layer film 4 is formed, and a resist upper layer film 5 is formed thereon. Then, as shown in FIG. 1(B), an exposed portion 6 of the resist upper layer film 5 is exposed and post-exposure baking (PEB) is performed. Then, as shown in FIG. 1(C), a development is performed to form a resist upper layer film pattern 5a. As shown in FIG. 1(D), the silicon-containing resist middle layer film 4 is then dry etched using a fluorine-based gas with the resist upper layer film pattern 5a as a mask to form a silicon-containing resist middle layer film pattern 4a. Then, as shown in FIG. 1(E), after removing the resist upper layer film pattern 5a, an organic film 3 is etched using oxygen plasma with the silicon-containing resist middle layer film pattern 4a as a mask to form an organic film pattern 3a. Furthermore, as shown in FIG. 1(F), after removing the silicon-containing resist middle layer film pattern 4a, the layer to be processed 2 is etched with the organic film pattern 3a as a mask to form a pattern 2a.

When forming an inorganic hard mask, the silicon-containing resist middle layer film 4 is changed to an inorganic hard mask, and when forming a BARC, the BARC is formed between the silicon-containing resist middle layer film 4 and the resist upper layer film **5.** The etching of the BARC may be performed continuously prior to the etching of the silicon-containing resist middle layer film **4,** or the etching of only BARC may be performed, followed by changing the etching device or the like, and then the etching of the silicon-containing resist middle layer film 4 may be performed.

As described above, according to the patterning process of the present invention, a fine pattern is formed on a body to be processed with high accuracy by a multi-layer resist process.

### EXAMPLE

Hereinafter, the present invention will be further specifically described with reference to Synthesis Examples, Examples, and Comparative Examples. However, the present invention is not limited thereto. As the molecular weight and dispersity, the weight average molecular weight (Mw) in terms of polystyrene determined by gel permeation chromatography (GPC) using tetrahydrofuran as the eluent was determined.

### [Synthesis Example 1] Synthesis of aromatic ring-containing resin compound (A-1)

Under a nitrogen atmosphere, 1.0 g of **2,3-**dihydroxynaphthalene, **9.0** g of methanesulfonic acid, and 30 g of 1,2-dichloroethane were added to an flask and stirred at an internal temperature of 60°C. After the mixture was homogeneously dissolved, 18.8 g of 3-phenoxybenzyl alcohol was slowly added dropwise, and the reaction was carried out at an internal temperature of 70°C for 5 hours. After cooling to room temperature, the mixture was diluted with 200 g of methyl isobutyl ketone (MIBK) and washed with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-1) as a 20% solution in PGMEA.

(A-1): Mw = 2080, Mw/Mn = 2.2

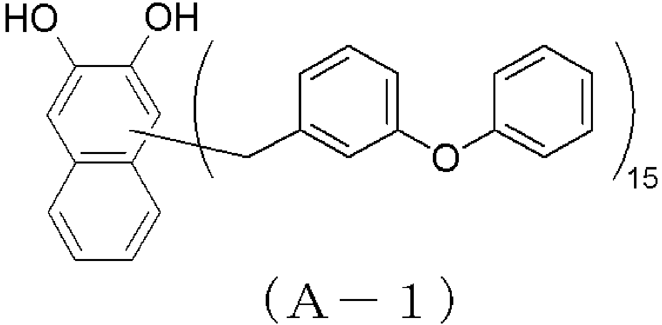

### [Synthesis Example 2] Synthesis of aromatic ring-containing resin compound (A-2)

Under a nitrogen atmosphere, 1.0 g of 2,3-dihydroxynaphthalene, 9.0 g of methanesulfonic acid, and 30 g of 1,2-dichloroethane were added to an flask and stirred at an internal temperature of 60°C. After the mixture was homogeneously dissolved, 11.6 g of 4-hydroxybenzyl alcohol was slowly added dropwise, and the reaction was carried out at an internal temperature of 70°C for 5 hours. After cooling to room temperature, the mixture was diluted with 200 g of methyl isobutyl ketone (MIBK) and washed with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-2) as a 20% solution in PGMEA.

(A-2): Mw = 1900, Mw/Mn = 2.3

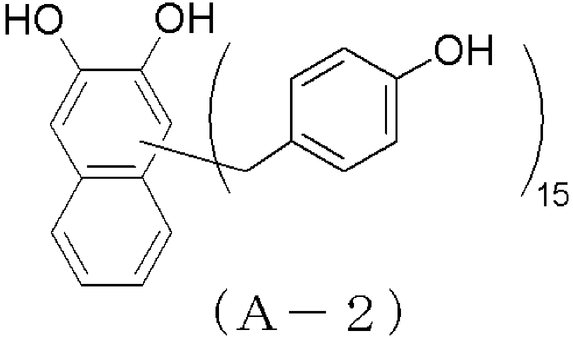

### [Synthesis Example 3] Synthesis of aromatic ring-containing resin compound (A-3)

Under a nitrogen atmosphere, 1.0 g of 4,4'-dihydroxydiphenyl ether, 5.9 g of methanesulfonic acid, and 30 g of 1,2-dichloroethane were added to a flask and stirred at an internal temperature of 60°C. After the mixture was homogeneously dissolved, 11.8 g of 3-phenoxybenzyl alcohol was slowly added dropwise, and the reaction was carried out at an internal temperature of 70°C for 5 hours. After cooling to room temperature, the mixture was diluted with 200 g of methyl isobutyl ketone (MIBK) and washed with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-3) as a 20% solution in PGMEA.

(A-3): Mw = 1880, Mw/Mn = 2.1

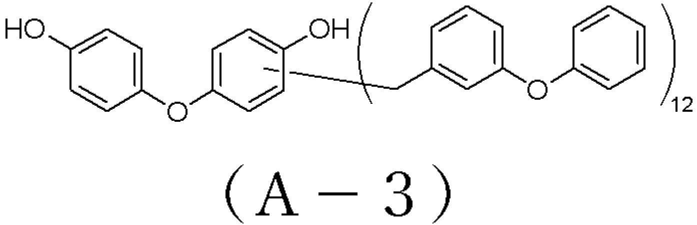

### [Synthesis Example 4] Synthesis of aromatic ring-containing resin compound (A-4)

Under a nitrogen atmosphere, 1.0 g of 4,4'-dihydroxydiphenyl ether, 5.9 g of methanesulfonic acid, and 30 g of 1,2-dichloroethane were added to a flask and stirred at an internal temperature of 60°C. After the mixture was homogeneously dissolved, a solution obtained by homogenizing 9.4 g of 2-naphthalene methanol with 30 g of 1,2-dichloroethane in advance was slowly added dropwise, and the reaction was carried out at an internal temperature of 70°C for 5 hours. After cooling to room temperature, the mixture was diluted with 200 g of methyl isobutyl ketone (MIBK) and washed with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-4) as a 20% solution in PGMEA.

(A-4): Mw = 1760, Mw/Mn = 2.4

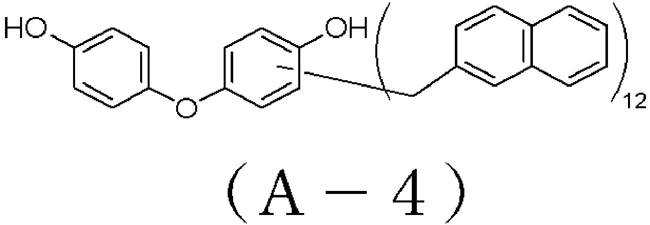

### [Synthesis Example 5] Synthesis of aromatic ring-containing resin polymer (A-5)

Under a nitrogen atmosphere, 20.0 g of 4,4'-dihydroxydiphenyl ether, 0.4 g of p-toluenesulfonic acid, and 60 g of propylene glycol monomethyl ether were added to a flask and stirred at an internal temperature of 90°C. After the mixture was homogeneously dissolved, 17.8 g of a 37% aqueous solution of formaldehyde was slowly added dropwise, and the mixture was subjected to an internal temperature of 105°C for 20 hours. After cooling to room temperature, 150 g of hexane was added with stirring to cause a pasty precipitate to settle. After standing for a while, the upper layer was decanted. To the residue, 30 g of PGME was added, and the mixture was stirred to be homogeneously dissolved. After that, the mixture was diluted with 150 g of MIBK and washed with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-5) as a 20% solution in PGMEA.

(A-5): Mw = 6030, Mw/Mn = 1.7

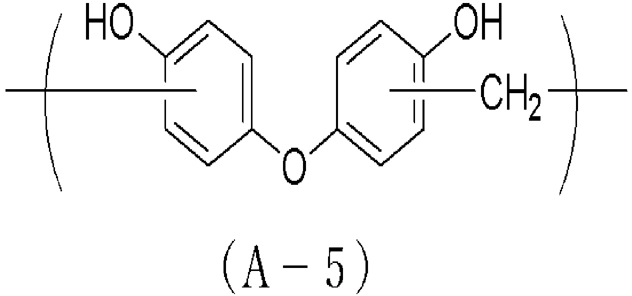

### [Synthesis Example 6] Synthesis of aromatic ring-containing resin polymer (A-6)

Under a nitrogen atmosphere, 10.0 g of polymer (A-5), 6.5 g of potassium carbonate, and 40 g of N,N-dimethylformamide were added to a flask and stirred at an internal temperature of 50°C to form a suspension. To the dispersion, 7.0 g of a toluene solution of 80% propargyl bromide was added dropwise, and the reaction was carried out at an internal temperature of 50°C for 15 hours. After the reaction, 150 g of ultrapure water and 150 g of MIBK were added and the mixture was homogeneously dissolved to stop the reaction. The mixture was transferred to a separatory funnel and the separated aqueous layer was removed. After that, the remaining layer was washed via liquid-liquid extraction twice with 100 g of 3% aqueous nitric acid solution and five times with 150 g of ultrapure water. The organic layer was recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-6) as a 20% solution in PGMEA.

(A-6): Mw = 7400, Mw/Mn = 1.9

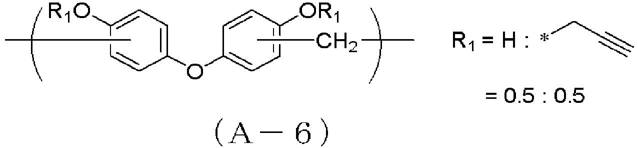

### [Synthesis Example 7] Synthesis of aromatic ring-containing resin polymer (A-7)

Under a nitrogen atmosphere, 20.0 g of catechol, 0.4 g of p-toluenesulfonic acid, and 60 g of propylene glycol monomethyl ether were added to a flask and the mixture was stirred at an internal temperature of 90°C. After the mixture was homogeneously dissolved, 11.8 g of a 37% aqueous solution of formaldehyde was slowly added dropwise, and the mixture was subjected to an internal temperature of 105°C for 20 hours. After cooling to room temperature, 150 g of ultrapure water was added with stirring to cause a pasty precipitate to settle. After standing for a while, the upper layer was decanted. To the residue, 30 g of PGME was added, and the mixture was stirred to be homogeneously dissolved. After that, the mixture was diluted with 150 g of MIBK and washed with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-7) as a 20% solution in PGMEA.

(A-7): Mw = 3900, Mw/Mn = 1.6

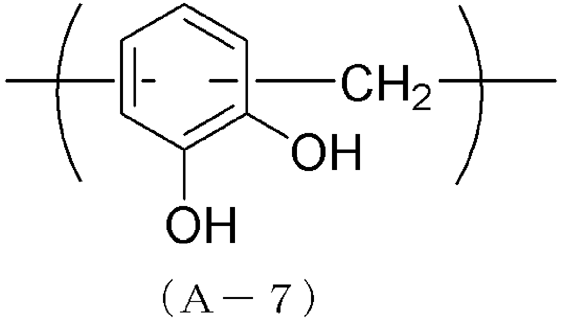

### [Synthesis Example 8] Synthesis of aromatic ring-containing resin polymer (A-8)

Under a nitrogen atmosphere, 10.0 g of polymer (A-7), 11.4 g of potassium carbonate, and 40 g of N,N-dimethylformamide were added to a flask and stirred at an internal temperature of 50°C to form a suspension. To the dispersion, 12.2 g of a toluene solution of 80% propargyl bromide was added dropwise, and the reaction was carried out at an internal temperature of 50°C for 15 hours. After the reaction, 150 g of ultrapure water and 150 g of MIBK were added and the mixture was homogeneously dissolved to stop the reaction. The mixture was transferred to a separatory funnel and the separated aqueous layer was removed. After that, the remaining layer was washed via liquid-liquid extraction twice with 100 g of 3% aqueous nitric acid solution and five times with 150 g of ultrapure water. The organic layer was recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-8) as a 20% solution in PGMEA.

(A-8): Mw = 4120, Mw/Mn = 1.7

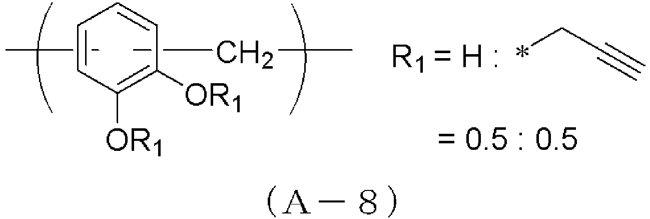

### [Synthesis Example 9] Synthesis of aromatic ring-containing resin polymer (A-9)

Under a nitrogen atmosphere, 10.0 g of p-cresol, 0.2 g of p-toluenesulfonic acid, and 40 g of propylene glycol monomethyl ether were added to a flask and the mixture was stirred at an internal temperature of 90°C. After the mixture was homogeneously dissolved, 6.0 g of a 37% aqueous solution of formaldehyde was slowly added dropwise, and the mixture was subjected to an internal temperature of 105°C for 20 hours. After cooling to room temperature, 100 g of ultrapure water was added with stirring to cause a pasty precipitate to settle. After standing for a while, the upper layer was decanted. To the residue, 20 g of PGME was added, and the mixture was stirred to be homogeneously dissolved. After that, the mixture was diluted with 100 g of MIBK and washed with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-9) as a 20% solution in PGMEA.

(A-9): Mw = 3400, Mw/Mn = 1.6

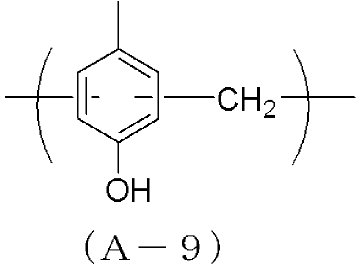

### [Synthesis Example 10] Synthesis of aromatic ring-containing resin polymer (A-10)

Under a nitrogen atmosphere, 10.0 g of 1,3,5-trihydroxybenzene, 10.0 g of 3,4-dihydroxybenzaldehyde, 0.2 g of p-toluenesulfonic acid, and 40 g of propylene glycol monomethyl ether were added to a flask and were stirred at an internal temperature of 90°C. After the mixture was homogeneously dissolved, the reaction was carried out at an internal temperature of 105°C for 5 hours. After cooling to room temperature, the mixture was diluted with 100 g of MIBK and washed via liquid-liquid extraction with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-10) as a 20% solution in PGMEA.

(A-10): Mw = 1125, Mw/Mn = 1.4

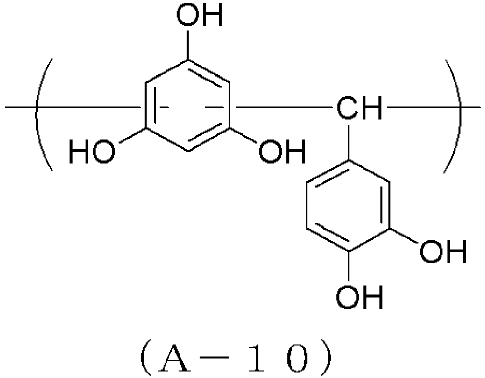

### [Synthesis Example 11] Synthesis of aromatic ring-containing resin compound (A-11)

Under a nitrogen atmosphere, 1.0 g of catechol, 21.0 g of methanesulfonic acid, and 30 g of 1,2-dichloroethane were added to a flask and stirred at an internal temperature of 60°C. After the mixture was homogeneously dissolved, 21.9 g of 3-phenoxybenzyl alcohol was slowly added dropwise, and the reaction was carried out at an internal temperature of 70°C for 5 hours. After cooling to room temperature, the mixture was diluted with 200 g of methyl isobutyl ketone (MIBK) and washed via liquid-liquid extraction with 50 g of ultrapure water for 5 times. The organic layer was then recovered, and methyl isobutyl ketone was removed under reduced pressure. After 150 g of PGMEA was added and the mixture was homogeneously dissolved, moisture and low boiling point solvents were distilled off, and the concentration was adjusted to recover the aromatic ring-containing resin compound (A-11) as a 20% solution in PGMEA.

(A-11): Mw = 1680, Mw/Mn = 2.0

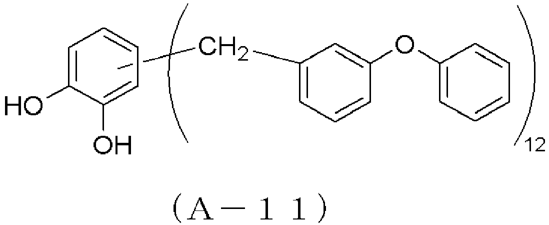

### [Synthesis Example 12] Synthesis of polymer (B-1) containing β-diketone structure in repeating unit

Under a nitrogen atmosphere, 10.0 g of di-tert-butyl malonate, 3.7 g of 1,4-butanediol, and 50 g of xylene were added to a flask, and the reaction was carried out at an internal temperature of 140°C for 2 hours while removing t-butyl alcohol generated by ester exchange reaction from the system. The mixture was then heated up to an internal temperature of 160°C while removing t-butyl alcohol and o-xylene from the system, and the reaction was carried out at an internal temperature of 160°C for 6 hours. After cooling to an internal temperature of 50°C, 200 g of hexane was added to precipitate a gum-like polymer. The precipitate was cooled to room temperature and allowed to stand at room temperature for 1 hour, then the supernatant was decanted. To the residue, 100 g of propylene glycol monomethyl ether acetate (PGMEA) was added and the mixture was homogeneously dissolved. Moisture and low boiling point solvents were distilled off, and the concentration was adjusted to recover the polymer (B-1) as a 50% solution in PGMEA.

(B-1): Mw = 11500, Mw/Mn = 1.7

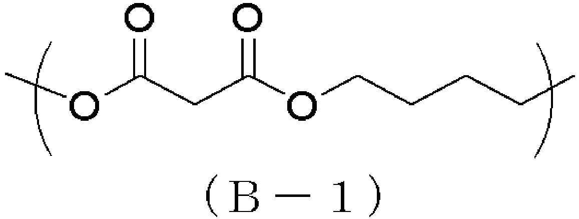

### [Synthesis Example 13] Synthesis of polymer (B-2) containing β-diketone structure in repeating unit

Under a nitrogen atmosphere, 10.0 g of di-tert-butyl malonate, 8.4 g of 1,12-dodecanediol, and 50 g of xylene were added to a flask, and the reaction was carried out at an internal temperature of 140°C for 2 hours while removing t-butyl alcohol generated by ester exchange reaction from the system. The mixture was then heated up to an internal temperature of 160°C while removing t-butyl alcohol and o-xylene from the system, and the reaction was carried out at an internal temperature of 160°C for 6 hours. After cooling to an internal temperature of 50°C, 200 g of hexane was added to precipitate a gum-like polymer. The precipitate was cooled to room temperature and allowed to stand at room temperature for 1 hour, then the supernatant was decanted. To the residue, 100 g of propylene glycol monomethyl ether acetate (PGMEA) was added and the mixture was homogeneously dissolved. Moisture and low boiling point solvents were distilled off, and the concentration was adjusted to recover the polymer (B-2) as a 50% solution in PGMEA.

(B-2): Mw = 17500, Mw/Mn = 2.2

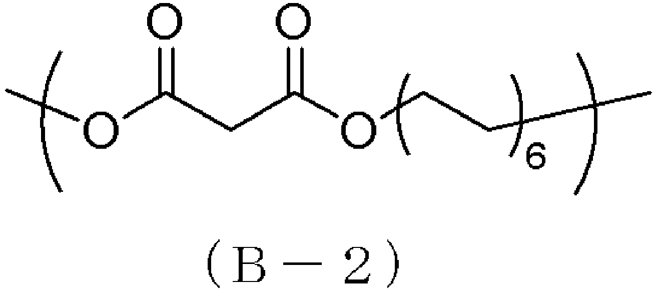

### [Synthesis Example 14] Synthesis of polymer (B-3) containing β-diketone structure in repeating unit

Under a nitrogen atmosphere, 10.0 g of di-tert-butyl malonate, 11.7 g of hexaethylene glycol, and 50 g of xylene were added to a flask, and the reaction was carried out at an internal temperature of 140°C for 2 hours while removing t-butyl alcohol generated by ester exchange reaction from the system. The mixture was then heated up to an internal temperature of 160°C while removing t-butyl alcohol and o-xylene from the system, and the reaction was carried out at an internal temperature of 160°C for 6 hours. After cooling to an internal temperature of 50°C, 200 g of hexane was added to precipitate a gum-like polymer. The precipitate was cooled to room temperature and allowed to stand at room temperature for 1 hour, then the supernatant was decanted. To the residue, 100 g of propylene glycol monomethyl ether acetate (PGMEA) was added and the mixture was homogeneously dissolved. Moisture and low boiling point solvents were distilled off, and the concentration was adjusted to recover the polymer (B-3) as a 50% solution in PGMEA.

(B-3): Mw = 14800, Mw/Mn = 2.1

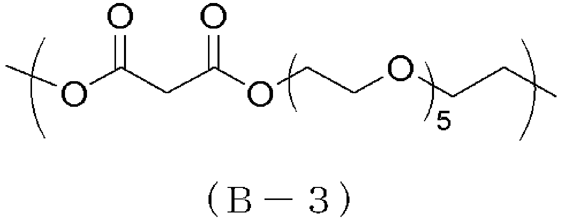

### [Synthesis Example 15] Synthesis of polymer (B-4) containing β-diketone structure in repeating unit

Under a nitrogen atmosphere, 10.0 g of di-tert-butyl malonate, 14.1 g of potassium carbonate, and 50 g of DMF were added to a flask, and 12.5 g of 1-bromopropane was added dropwise. The mixture was then heated to an internal temperature of 60°C and reacted for 15 hours. After cooling to room temperature, 200 g of methyl isobutyl ketone was added, and the mixture was washed with 150 g of ultrapure water twice, the organic layer was recovered, and methyl isobutyl ketone was removed under reduced pressure. After removing the methyl isobutyl ketone, the residue was dissolved in 50 g of xylene, 8.4 g of 1,12-dodecanediol was added, and the reaction was carried out at an internal temperature of 140°C for 2 hours while removing t-butyl alcohol generated by ester exchange reaction from the system. The mixture was then heated up to an internal temperature of 160°C while removing t-butyl alcohol and o-xylene from the system, and the reaction was carried out at an internal temperature of 160°C for 6 hours. After cooling to an internal temperature of 50°C, 200 g of hexane was added to precipitate a gum-like polymer. The precipitate was cooled to room temperature and allowed to stand at room temperature for 1 hour, then the supernatant was decanted. The residue was dissolved in 150 g of methyl isobutyl ketone, washed with 100 g of 3% nitric acid, and then washed with ultrapure water 5 times. The methyl isobutyl ketone was removed under reduced pressure, and 150 g of propylene glycol monomethyl ether acetate (PGMEA) was added and the mixture was homogeneously dissolved. Moisture and low boiling point solvents were distilled off, and the concentration was adjusted to recover the polymer (B-4) as a 50% solution in PGMEA.

(B-4): Mw = 19250, Mw/Mn = 2.2

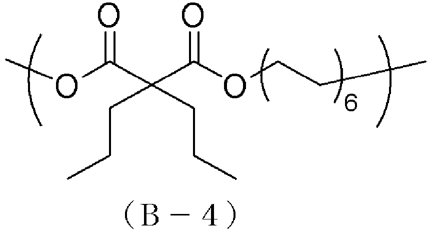

### [Composition UDL-1 for forming Organic Film]

A polymer (A-1) containing an aromatic ring and a polymer (B-1) containing a β-diketone structure in a repeating unit were dissolved in propylene glycol monomethyl ether acetate (PGMEA) containing 0.5% by mass of surfactant FC-4430 (manufactured by Sumitomo 3M Limited) in the ratio shown in Table 1 and filtered with a 0.02 µm membrane filter to prepare a composition (UDL-1) for forming an organic film.

### [Preparation of Compositions (UDL-2 to 21) for forming Organic Film and Compositions for Comparative Examples (UDL-1 to 12 for Comparative Examples) for forming Organic Film]

Each chemical solution was prepared in the same manner as UDL-1 except that the type and content of each component were set as shown in Table 1. In Table 1, "-" indicates that the relevant component was not used. The following formula (D-1) was used as a crosslinking agent, 1,6-diacetoxyhexane having a boiling point of 260°C was used as a high boiling point solvent (F-1), the following formula (G-1) was used as a thermally decomposable resin, and further polyethylene glycol methyl ether 10000 (PEGME 10000) was used as (P-1) and dimethyl malonate was used as (M-1).

### [Crosslinking agent]

The crosslinking agent (D-1) used in the composition for forming an organic film is shown below.

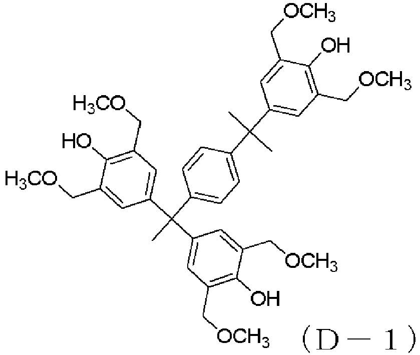

### [Thermally decomposable resin]

The thermally decomposable resin (G-1) used in the composition for forming an organic film is shown below. 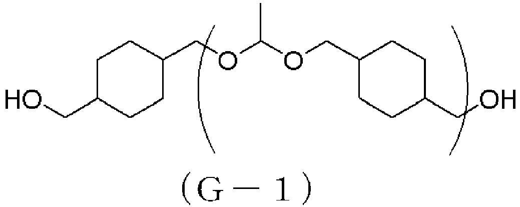 Mw = 6,400 Mw/Mn = 2.5

**[Table 1]**

| Composition for forming resist underlayer film | Aromatic ring-containing resin | Polymer containing β-diketone structure | Additive | Solvent |
|---|---|---|---|---|
| | (parts by mass) | (parts by mass) | (parts by mass) | (parts by mass) |
| UDL-1 | A-1 (15) | B-1(1) | - | PGMEA(85) |
| UDL-2 | A-2 (15) | B-1(1) | - | PGMEA(85) |
| UDL-3 | A-3 (15) | B-1(1) | - | PGMEA(85) |
| UDL-4 | A-4 (15) | B-1(1) | - | PGMEA(85) |
| UDL-5 | A-5 (15) | B-1(1) | - | PGMEA(85) |
| UDL-6 | A-6 (15) | B-1(1) | - | PGMEA(85) |
| UDL-7 | A-7 (15) | B-1(1) | - | PGMEA(85) |
| UDL-8 | A-8 (15) | B-1(1) | - | PGMEA(85) |
| UDL-9 | A-9 (15) | B-1(1) | - | PGMEA(85) |
| UDL-10 | A-10(15) | B-1(1) | - | PGMEA(85) |
| UDL-11 | A-11(15) | B-1(1) | - | PGMEA(85) |
| UDL-12 | A-5 (15) | B-2(1) | - | PGMEA(85) |
| UDL-13 | A-5 (15) | B-3(1) | - | PGMEA(85) |
| UDL-14 | A-5 (15) | B-4(1) | - | PGMEA(85) |
| UDL-15 | A-7 (15) | B-2(1) | - | PGMEA(85) |
| UDL-16 | A-7 (15) | B-3(1) | - | PGMEA(85) |
| UDL-17 | A-7 (15) | B-4(1) | - | PGMEA(85) |
| UDL-18 | A-7(15) | B-1(1.5) | - | PGMEA(85) |
| UDL-19 | A-1(10), A-6(5) | B-1(1) | - | PGMEA(85) |
| UDL-20 | A-1 | B-1(1) | D-1(3) | PGMEA(85) |
| UDL-21 | A-1 (15) | B-1(1) | F-1(1) | PGMEA(85) |
| Comparative Example UDL-1 | A-1 (15) | - | - | PGMEA(85) |
| Comparative Example UDL-2 | A-5 (15) | - | - | PGMEA(85) |
| Comparative Example UDL-3 | A-7 (15) | - | - | PGMEA(85) |
| Comparative Example UDL-4 | A-1 (15) | - | P-1(1) | PGMEA(85) |
| Comparative Example UDL-5 | A-5 (15) | - | P-1(1) | PGMEA(82) |
| Comparative Example UDL-6 | A-7 (15) | - | P-1(1) | PGMEA(85) |
| Comparative Example UDL-7 | A-1 (15) | - | G-1(1) | PGMEA(85) |
| Comparative Example UDL-8 | A-5 (15) | - | G-1(1) | PGMEA(85) |
| Comparative Example UDL-9 | A-7 (15) | - | G-1(1) | PGMEA(85) |
| Comparative Example UDL-10 | A-1 (15) | - | M-1(1) | PGMEA(85) |
| Comparative Example UDL-11 | A-5 (15) | - | M-1(1) | PGMEA(85) |
| Comparative Example UDL-12 | A-7 (15) | - | M-1(1) | PGMEA(85) |

### [Solvent resistance evaluation]

The compositions (UDL-1 to 21, Comparative Examples UDL-1 to 12) for forming an organic film prepared above were applied on a silicon substrate, baked at 180°C for 60 seconds, followed by baked at 350°C for 60 seconds, and then the film thickness (a [nm]) was measured. The film thickness from the center of the substrate to the outer periphery was measured, and the film thickness difference between the maximum film thickness and the minimum film thickness, Range (b [nm]), was calculated, and in-plane uniformity ((b/a) × 100) was determined.

PGMEA was then dispensed thereon, then the coating was left for 30 seconds, spin-dried, and baked at 100°C for 60 seconds to evaporate PGMEA, and the film thickness (c [nm]) was measured. The film thickness difference (residual film rate: (c/a) × 100) before and after PGMEA treatment was determined. The results are shown in Table 2 below.

**[Table 2]**

| Example | Composition for forming resist underlayer film | Film thickness a | Range b | In-plane uniformity b/a | Film thickness after rinse c | (c/a) x100 |
|---|---|---|---|---|---|---|
| | | nm | nm | % | nm | % |
| Example 1-1 | UDL-1 | 112.0 | 5.0 | 4% | 110.8 | 98.9% |
| Example 1-2 | UDL-2 | 105.0 | 3.4 | 3% | 104.9 | 99.9% |
| Example 1-3 | UDL-3 | 108.5 | 3.2 | 3% | 107.5 | 99.1% |
| Example 1-4 | UDL-4 | 109.1 | 4.3 | 4% | 107.7 | 98.7% |
| Example 1-5 | UDL-5 | 100.9 | 2.2 | 2% | 100.9 | 100.0% |
| Example 1-6 | UDL-6 | 102.0 | 2.9 | 3% | 102.0 | 100.0% |
| Example 1-7 | UDL-7 | 103.8 | 1.4 | 1 % | 103.9 | 100.1% |
| Example 1-8 | UDL-8 | 99.1 | 1.9 | 2% | 99.1 | 100.0% |
| Example 1-9 | UDL-9 | 114.3 | 2.8 | 2% | 114.2 | 99.9% |
| Example 1-10 | UDL-10 | 107.3 | 1.1 | 1 % | 107.5 | 100.2% |
| Example 1-11 | UDL-11 | 111.2 | 4.1 | 4% | 110.8 | 99.6% |
| Example 1-12 | UDL-12 | 100.3 | 2.5 | 2% | 100.2 | 99.9% |
| Example 1-13 | UDL-13 | 102.3 | 3.1 | 3% | 102.3 | 100.0% |
| Example 1-14 | UDL-14 | 101.8 | 2.3 | 2% | 101.8 | 100.0% |
| Example 1-15 | UDL-15 | 104.9 | 1.7 | 2% | 104.9 | 100.0% |
| Example 1-16 | UDL-16 | 108.1 | 2.0 | 2% | 108.3 | 100.2% |
| Example 1-17 | UDL-17 | 106.3 | 2.1 | 2% | 106.3 | 100.0% |
| Example 1-18 | UDL-18 | 114.8 | 2.1 | 2% | 114.6 | 99.8% |
| Example 1-19 | UDL-19 | 113.1 | 3.3 | 3% | 113.4 | 100.3% |
| Example 1-20 | UDL-20 | 120.2 | 4.2 | 3% | 120.2 | 100.0% |
| Example 1-21 | UDL-21 | 107.3 | 5.3 | 5% | 105.7 | 98.5% |
| Comparative Example 1-1 | Comparative UDL-1 | 110.2 | 4.7 | 4% | 109.2 | 99.1 % |
| Comparative Example 1-2 | Comparative UDL-2 | 99.8 | 2.6 | 3% | 99.8 | 100.0% |
| Comparative Example 1-3 | Comparative UDL-3 | 100.4 | 1.1 | 1% | 100.5 | 100.1% |
| Comparative Example 1-4 | Comparative UDL-4 | 104.2 | 12.3 | 12% | 102.8 | 98.7% |
| Comparative Example 1-5 | Comparative UDL-5 | 101.8 | 15.6 | 15% | 100.9 | 99.1 % |
| Comparative Example 1-6 | Comparative UDL-6 | 105.3 | 9.1 | 9% | 105.2 | 99.9% |
| Comparative Example 1-7 | Comparative UDL-7 | 105.0 | 9.2 | 9% | 103.8 | 98.9% |
| Comparative Example 1-8 | Comparative UDL-8 | 100.0 | 8.8 | 9% | 100.0 | 100.0% |
| Comparative Example 1-9 | Comparative UDL-9 | 102.0 | 13.0 | 13% | 102.0 | 100.0% |
| Comparative Example 1-10 | Comparative UDL-10 | 103.1 | 12.1 | 12% | 102.2 | 99.1 % |
| Comparative Example 1-11 | Comparative UDL-11 | 99.6 | 8.1 | 8% | 99.6 | 100.0% |
| Comparative Example 1-12 | Comparative UDL-12 | 101.0 | 9.2 | 9% | 101.0 | 100.0% |

As shown in Table 2, the compositions (Examples 1-1 to 1-21) for forming an organic film of the present invention had a residual film rate after baking ((c/a) × 100) of 98.5% or more, thus it was confirmed that the composition of the present invention has sufficient thermal curability required for a resist underlayer film. In addition, since the compositions (Examples 1-1 to 1-21) had good in-plane uniformity, it was confirmed that the composition of the present invention is difficult to cause sublimation and compatibility failure, and thus difficult to cause film formation and application failures. Since Comparative Examples 1-1 to 1-3, which were compositions excluding the polymer (B) containing a β-diketone structure in the main chain of the polymer from the present invention, had the same results, it was confirmed that the addition of the component (B) does not adversely affect the film curability and the film-forming property. On the other hand, Comparative Examples 1-4 to 1-6, which did not contain the β-diketone structure and contained simple polyethylene glycol (P-1), Comparative Examples 1-7 to 1-9, which contained a thermally decomposable resin (G-1), and Comparative Examples 1-10 to 1-12, which contained a monomolecular compound containing the β-diketone structure (M-1), resulted in significant deterioration in in-plane uniformity. When (P-1) is contained, this result is believed to be caused by unevenness during application due to poor compatibility with the main resin. When (G-1) is contained, it is believed to be caused by the sublimation of low molecular weight components generated by thermal decomposition, and when (M-1) is contained, it is believed to be caused by unevenness in the film generated by sublimation due to the low molecular weight of (M-1) itself.

### [Evaluation of embedding and planarization properties]

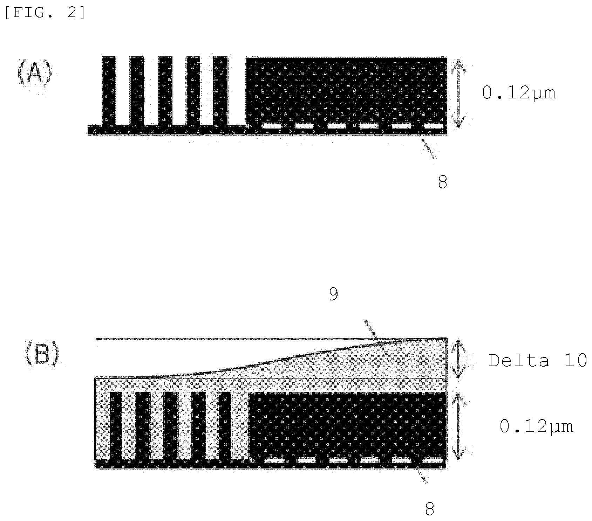

The compositions (UDL-1 to 21 and Comparative Examples UDL-1 to 9) for forming an organic film prepared above were respectively applied on a SiO2 wafer substrate having a dense line & space pattern (line width 60 nm, line depth 100 nm, and distance 120 nm between the centers of two adjacent lines), and heated at 350°C for 60 seconds using a hot plate to form an organic film with a film thickness of about 150 nm. The substrate used was a base substrate 8 (SiO₂ wafer substrate) having a dense line & space pattern as shown in FIG. 2. The cross-sectional shape of each obtained wafer substrate was observed using an electron microscope (S-4700) manufactured by Hitachi, Ltd., and the feasibility of embedding in a step substrate was confirmed. The results are shown in Table 3. When a composition for forming an organic film with poor embedding property is used, the step substrate cannot be successfully embedded in this evaluation. When a composition for forming an organic film with good embedding property is used in this evaluation, filling between lines having a dense line & space pattern can be achieved without gaps as shown in FIG. 2. A indicates that embedding is possible without a large void, B indicates that voids are visually observed, and C indicates that embedding is not possible. The cross-sectional shape of each wafer substrate obtained from the embedding property evaluation above was observed using a scanning electron microscope (SEM), and the step difference (Delta 10 in FIG. 2(B)) between the line pattern dense portion and the filling film (coating film) 9 of the non-line pattern formed portion was observed using an electron microscope (S-4700) manufactured by Hitachi, Ltd. The results are shown in Table 3. In this evaluation, it can be said that the smaller the step, the better the planarization property.

**[Table 3]**

| Example | Composition for forming resist underlayer film | Embedding property | Flatness |
|---|---|---|---|
| | | | nm |
| Example 2-1 | UDL-1 | A | 42 |
| Example 2-2 | UDL-2 | A | 45 |
| Example 2-3 | UDL-3 | A | 35 |
| Example 2-4 | UDL-4 | A | 50 |
| Example 2-5 | UDL-5 | A | 40 |
| Example 2-6 | UDL-6 | A | 36 |
| Example 2-7 | UDL-7 | A | 38 |
| Example 2-8 | UDL-8 | A | 43 |
| Example 2-9 | UDL-9 | A | 49 |
| Example 2-10 | UDL-10 | A | 47 |
| Example 2-11 | UDL-11 | A | 34 |
| Example 2-12 | UDL-12 | A | 36 |
| Example 2-13 | UDL-13 | A | 38 |
| Example 2-14 | UDL-14 | A | 35 |
| Example 2-15 | UDL-15 | A | 36 |
| Example 2-16 | UDL-16 | A | 39 |
| Example 2-17 | UDL-17 | A | 38 |
| Example 2-18 | UDL-18 | A | 33 |
| Example 2-19 | UDL-19 | A | 37 |
| Example 2-20 | UDL-20 | A | 44 |
| Example 2-21 | UDL-21 | A | 38 |
| Comparative Example 2-1 | Comparative Example UDL-1 | A | 52 |
| Comparative Example 2-2 | Comparative Example UDL-2 | A | 64 |
| Comparative Example 2-3 | Comparative Example UDL-3 | A | 62 |
| Comparative Example 2-4 | Comparative Example UDL-4 | C | - |
| Comparative Example 2-5 | Comparative Example UDL-5 | C | - |
| Comparative Example 2-6 | Comparative Example UDL-6 | B | - |
| Comparative Example 2-7 | Comparative Example UDL-7 | B | - |
| Comparative Example 2-8 | Comparative Example UDL-8 | B | - |
| Comparative Example 2-9 | Comparative Example UDL-9 | B | - |
| Comparative Example 2-10 | Comparative Example UDL-10 | B | - |
| Comparative Example 2-11 | Comparative Example UDL-11 | B | - |
| Comparative Example 2-12 | Comparative Example UDL-12 | B | - |

As shown in Table 3, in Examples 2-1 to 2-21 using the composition (UDL-1 to 21) for forming an organic film of the present invention and Comparative Examples 2-1 to 2-3 using Comparative Examples UDL-1 to 3 without an additive, it was possible to fill the dense line & space pattern without generating a void, and good embedding property was confirmed. On the other hand, in Comparative Examples 2-4 to 2-6 containing simple polyethylene glycol (P-1), embedding was not possible and something like voids was observed, and it was not possible to fill the dense line & space pattern. This is believed to be caused by the failure of filling the space during spin-coating as well as the poor film-forming property due to poor compatibility. In Comparative Examples 2-7 to 2-9 containing a thermally decomposable resin (G-1) and Comparative Examples 2-10 to 2-12 containing a β-diketone compound (M-1), embedding was possible, but voids were generated. This is believed to be because the thermally decomposable resin was decomposed and sublimated and the β-diketone compound itself was sublimated to form a gap in the filled space.

Regarding the flatness, when comparing Examples 2-1 to 2-19 using the composition (UDL-1 to 21) for forming an organic film using a polymer (B) containing a repeating unit containing a β-diketone structure of the present invention with Comparative Examples 2-1 to 2-3 using Comparative Examples UDL 1 to 3 without the (B) polymer of the present invention, it was confirmed that Examples 2-1 to 2-19 containing the polymer (B) of the present invention all improved by 10 nm or more compared to Comparative Examples 2-1 to 2-3. This is believed to be the result of being able to ensure thermal fluidity by adding a polymer containing a β-diketone structure in a repeating unit. Good results were also obtained for other compositions for forming an organic film of the present invention.

### [Evaluation of etching resistance]

The compositions for forming an organic film of the present invention (UDL-1, 5, and 7) containing the same (A) aromatic ring-containing resin (A-1), (A-5), (A-7)), and a polymer (B) containing a repeating unit containing a β-diketone structure, and Comparative Examples UDL 1-1 to 1-3 without containing the polymer (B) of the present invention were applied to a silicon substrate, heated at 350°C for 60 seconds using a hot plate, and subjected to the following plasma treatment conditions, respectively, to form an organic film, and the film thickness "a" was measured. Next, etching was performed using CF4 gas under the following conditions using an etching device Telius manufactured by Tokyo Electron Ltd., and the film thickness "b" was measured. With the film thickness (film thickness "a" - film thickness "b") etched using CF4 gas during a specified time, the film thickness etched for 1 minute was calculated as the etching rate B (nm/min). A smaller numerical value for the etching rate indicates higher etching resistance to CF4 gas.

### Dry etching conditions with CF4 gas

Chamber pressure: 100 mT
RF power (top): 500 W
RF power (bottom): 400 W
CF4 gas flow rate: 300 sccm
Time: 30 sec

**[Table 4]**

| Example | Composition for forming resist underlayer film | Etching resistance |
|---|---|---|
| | | CF4 |
| Example 3-1 | UDL-1 | 82 |
| Example 3-2 | UDL-5 | 72 |
| Example 3-3 | UDL-7 | 75 |
| Comparative Example 3-1 | Comparative Example UDL-1 | 84 |
| Comparative Example 3-2 | Comparative Example UDL-2 | 73 |
| Comparative Example 3-3 | Comparative Example UDL-3 | 75 |

As shown in Table 4, Examples 3-1 to 3-3 using the compositions for forming a resist underlayer film of the present invention (UDL-1, 5, and 7) and Comparative Examples 3-1 to 3-3 using Comparative UDL 1-1 to 1-3 excluding the polymer containing a β-diketone structure showed similar etching resistance for any gas species, and it was confirmed that there was no adverse effect on etching resistance by the polymer containing a β-diketone structure.

From the above, the composition for forming an organic film of the present invention achieves high compatibility between thermal fluidity and thermal curability, and is capable of forming an organic film having high film-forming property, embedding property, and planarization property without compromising the etching resistance of the original main resin, and is extremely useful as a resist underlayer film material for use in a multi-layer resist method and an inverting agent for use in a tone inversion etching method.

This specification encompasses the following inventions:
[1]: A composition for forming an organic film, comprising:
   (A) an aromatic ring-containing resin;
   (B) a polymer containing a repeating unit containing a β-diketone structure represented by the following formula (1): 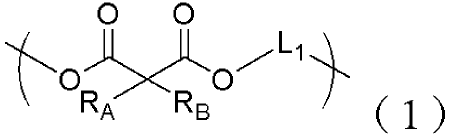 wherein L₁ is a saturated or unsaturated, linear or branched divalent hydrocarbon group having 2 to 20 carbon atoms, where the hydrocarbon group may be interrupted one or more times by an atom selected from oxygen, nitrogen and sulfur, R_{A} and R_{B} are the same or different from each other and each are a hydrogen atom, a substituted or unsubstituted linear alkyl group having 1 to 20 carbon atoms, a substituted or unsubstituted branched or cyclic alkyl group having 3 to 20 carbon atoms, a substituted or unsubstituted aliphatic unsaturated hydrocarbon group having 2 to 20 carbon atoms and containing one or more double or triple bonds, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen group; and
   (C) a solvent.
[2]: The composition for forming an organic film according to [1], wherein the aromatic ring-containing resin (A) contains hydrogen at a position in diaryl methylene or hydrogen at a position in trityl.
[3]: The composition for forming an organic film according to [2], wherein an aromatic ring in the (A) aromatic ring-containing resin contains a hydroxy group as a substituent.
[4]: The composition for forming an organic film according to any one of [1] to [3], wherein the (A) aromatic ring-containing resin is a resin containing any one selected from polymers having a repeating unit represented by the following formula (P-1) or (P-2) and compounds represented by any of formulae (P-3) to (P-6): 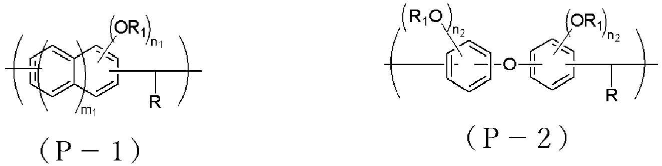 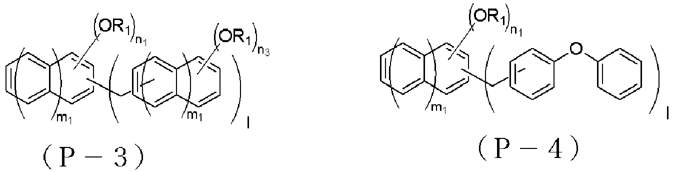 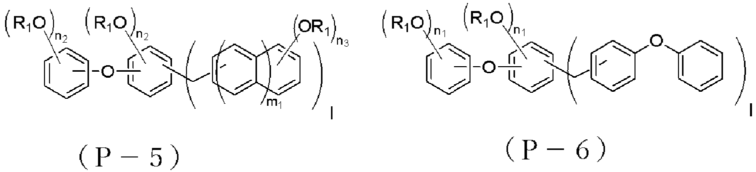 wherein R is a hydrogen atom or a substituted or unsubstituted benzene ring or naphthalene ring, R₁ is a hydrogen atom or a saturated or unsaturated hydrocarbon group having 1 to 20 carbon atoms; m₁ is an integer of 0 or 1; n₁ is an integer from 1 to 4; n₂ is an integer of 1 or 2; n₃ is an integer from 0 to 2; and l is an integer from 5 to 20, provided that l represents a charge ratio.
[5]: The composition for forming an organic film according to any one of [1] to [4], wherein R_{A} and R_{B} each are a hydrogen atom, a substituted or unsubstituted linear alkyl group having 1 to 20 carbon atoms, a substituted or unsubstituted branched or cyclic alkyl group having 3 to 20 carbon atoms, or a substituted or unsubstituted aliphatic unsaturated hydrocarbon group having 2 to 20 carbon atoms and containing one or more double or triple bonds.
[6]: The composition for forming an organic film according to any one of [1] to [5], wherein R_{A} and R_{B} each are a hydrogen atom.
[7]: The composition for forming an organic film according to any one of [1] to [6], wherein L₁ is a saturated or unsaturated linear or branched hydrocarbon group having 2 to 20 carbon atoms and containing no heteroatoms.
[8]: The composition for forming an organic film according to any one of [1] to [7], wherein the composition comprises 0.5 to 30 parts by mass of the (B) polymer containing a repeating unit containing a β-diketone structure based on 100 parts by mass of the (A) aromatic ring-containing resin.
[9]: The composition for forming an organic film according to any one of [1] to [8], wherein the (C) solvent is a mixture of a solvent having a high boiling point and a solvent having a low boiling point.
[10]: The composition for forming an organic film according to any one of [1] to [9], wherein the composition further comprises one or more of (D) a crosslinking agent and (E) a surfactant.
[11]: A method for forming an organic film that functions as an organic flat film used in a process for manufacturing a semiconductor device, comprising:
   spin-coating a substrate to be processed with the composition for forming an organic film according to any one of [1] to [10]; and
   heat-treating the substrate coated with the composition for forming an organic film at a temperature of 100°C or higher and 600°C or lower for a period of time of 10 to 600 seconds to form a cured film.
[12]: A method for forming an organic film that functions as an organic flat film used in a process for manufacturing a semiconductor device, comprising:
   spin-coating a substrate to be processed with the composition for forming an organic film according to any one of [1] to [10]; and
   heat-treating the substrate coated with the composition for forming an organic film in an atmosphere having an oxygen concentration of 0.1% or more and 21% or less to form a cured film.
[13]: The method for forming an organic film according to [11] or [12], wherein the substrate to be processed is a substrate to be processed having a structure or step with a height of 30 nm or more.
[14]: A patterning process comprising:
   forming an organic film on a body to be processed using the composition for forming an organic film according to any one of [1] to [10];
   forming a resist middle layer film on the organic film using a resist middle layer film material containing a silicon atom;
   forming a resist upper layer film on the resist middle layer film using a resist upper layer film material comprising a photoresist composition;
   forming a circuit pattern on the resist upper layer film;
   transferring a pattern by etching to the resist middle layer film using the resist upper layer film on which the circuit pattern is formed as a mask;
   transferring a pattern by etching to the organic film using the resist middle layer film on which the pattern is transferred as a mask; and
   further transferring a pattern by etching to the body to be processed using the organic film on which the pattern is transferred as a mask.
[15]: A patterning process comprising:
   forming an organic film on a body to be processed using the composition for forming an organic film according to any one of [1] to [10];
   forming a resist middle layer film on the organic film using a resist middle layer film material containing a silicon atom;
   forming an organic anti-reflection film on the resist middle layer film;
   forming a resist upper layer film on the organic anti-reflection film using a resist upper layer film material comprising a photoresist composition;
   forming a circuit pattern on the resist upper layer film;
   transferring a pattern by etching to the organic anti-reflection film and the resist middle layer film using the resist upper layer film on which the circuit pattern is formed as a mask;
   transferring a pattern by etching to the organic film using the resist middle layer film on which the pattern is transferred as a mask; and
   further transferring a pattern by etching to the body to be processed using the organic film on which the pattern is transferred as a mask.
[16]: A patterning process comprising:
   forming an organic film on a body to be processed using the composition for forming an organic film according to any one of [1] to [10];
   forming an inorganic hard mask selected from a silicon oxide film, a silicon nitride film, and a silicon oxide nitride film on the organic film;
   forming a resist upper layer film on the inorganic hard mask using a resist upper layer film material comprising a photoresist composition;
   forming a circuit pattern on the resist upper layer film;
   transferring a pattern by etching to the inorganic hard mask using the resist upper layer film on which the circuit pattern is formed as a mask;
   transferring a pattern by etching to the organic film using the inorganic hard mask on which the pattern is transferred as a mask; and
   further transferring a pattern by etching to the body to be processed using the organic film on which the pattern is transferred as a mask.
[17]: A patterning process comprising:
   forming an organic film on a body to be processed using the composition for forming an organic film according to any one of [1] to [10];
   forming an inorganic hard mask selected from a silicon oxide film, a silicon nitride film, and a silicon oxide nitride film on the organic film;
   forming an organic anti-reflection film on the inorganic hard mask;
   forming a resist upper layer film on the organic anti-reflection film using a resist upper layer film material comprising a photoresist composition;
   forming a circuit pattern on the resist upper layer film;
   transferring a pattern by etching to the organic anti-reflection film and the inorganic hard mask using the resist upper layer film on which the circuit pattern is formed as a mask;
   transferring a pattern by etching to the organic film using the inorganic hard mask on which the pattern is transferred as a mask; and
   further transferring a pattern by etching to the body to be processed using the organic film on which the pattern is transferred as a mask.
[18]: A patterning process according to [16] or [17], wherein the inorganic hard mask is formed by a CVD method or an ALD method.

It should be noted that the present invention is not limited to the above-described embodiments. The embodiments are just examples, and any examples that substantially have the same features and demonstrate the same functions and effects as those in the technical concept described in claims of the present invention are included in the technical scope of the present invention.

## Claims

1. A composition for forming an organic film, comprising:
(A) an aromatic ring-containing resin;
(B) a polymer containing a repeating unit containing a β-diketone structure represented by the following formula (1): 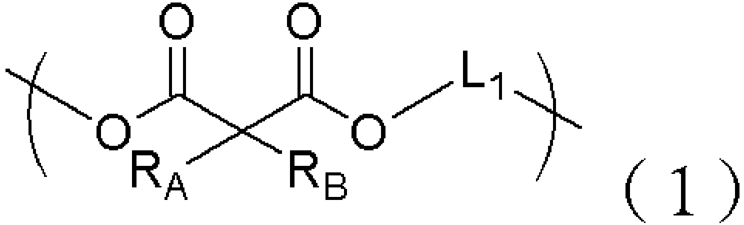 wherein L₁ is a saturated or unsaturated, linear or branched divalent hydrocarbon group having 2 to 20 carbon atoms, where the hydrocarbon group may be interrupted one or more times by an atom selected from oxygen, nitrogen and sulfur, R_{A} and R_{B} are the same or different from each other and each are a hydrogen atom, a substituted or unsubstituted linear alkyl group having 1 to 20 carbon atoms, a substituted or unsubstituted branched or cyclic alkyl group having 3 to 20 carbon atoms, a substituted or unsubstituted aliphatic unsaturated hydrocarbon group having 2 to 20 carbon atoms and containing one or more double or triple bonds, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen group; and
(C) a solvent.

2. The composition for forming an organic film according to claim 1, wherein the aromatic ring-containing resin (A) contains hydrogen at a position in diaryl methylene or hydrogen at a position in trityl.

3. The composition for forming an organic film according to claim 2, wherein an aromatic ring in the (A) aromatic ring-containing resin contains a hydroxy group as a substituent.

4. The composition for forming an organic film according to any one of claims 1 to 3, wherein the (A) aromatic ring-containing resin is a resin containing any one selected from polymers having a repeating unit represented by the following formula (P-1) or (P-2) and compounds represented by any of formulae (P-3) to (P-6): 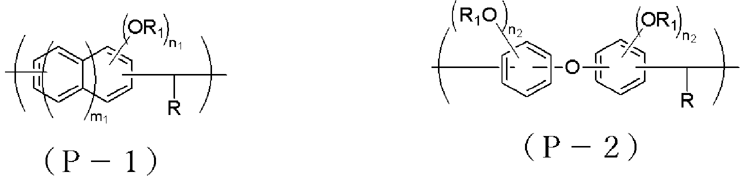 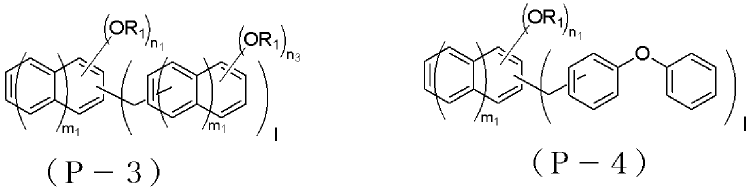 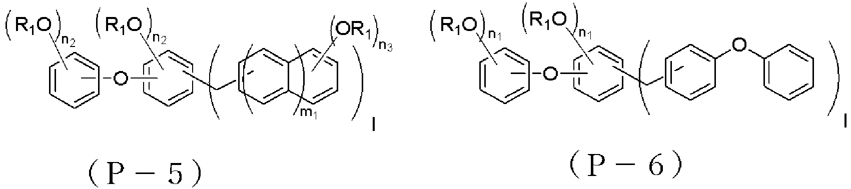 wherein R is a hydrogen atom or a substituted or unsubstituted benzene ring or naphthalene ring, R₁ is a hydrogen atom or a saturated or unsaturated hydrocarbon group having 1 to 20 carbon atoms; m₁ is an integer of 0 or 1; n₁ is an integer from 1 to 4; n₂ is an integer of 1 or 2; n₃ is an integer from 0 to 2; and l is an integer from 5 to 20, provided that l represents a charge ratio.

5. The composition for forming an organic film according to any one of claims 1 to 4, wherein R_{A} and R_{B} each are a hydrogen atom, a substituted or unsubstituted linear alkyl group having 1 to 20 carbon atoms, a substituted or unsubstituted branched or cyclic alkyl group having 3 to 20 carbon atoms, or a substituted or unsubstituted aliphatic unsaturated hydrocarbon group having 2 to 20 carbon atoms and containing one or more double or triple bonds.

6. The composition for forming an organic film according to any one of claims 1 to 5, wherein R_{A} and R_{B} each are a hydrogen atom.

7. The composition for forming an organic film according to any one of claims 1 to 6, wherein L₁ is a saturated or unsaturated linear or branched hydrocarbon group having 2 to 20 carbon atoms and containing no heteroatoms.

8. The composition for forming an organic film according to any one of claims 1 to 7, wherein the composition comprises 0.5 to 30 parts by mass of the (B) polymer containing a repeating unit containing a β-diketone structure based on 100 parts by mass of the (A) aromatic ring-containing resin.

9. The composition for forming an organic film according to any one of claims 1 to 8, wherein the (C) solvent is a mixture of a solvent having a high boiling point and a solvent having a low boiling point.

10. The composition for forming an organic film according to any one of claims 1 to 9, wherein the composition further comprises one or more of (D) a crosslinking agent and (E) a surfactant.

11. A method for forming an organic film that functions as an organic flat film used in a process for manufacturing a semiconductor device, comprising:
spin-coating a substrate to be processed with the composition for forming an organic film according to any one of claims 1 to 10; and
heat-treating the substrate coated with the composition for forming an organic film at a temperature of 100°C or higher and 600°C or lower for a period of time of 10 to 600 seconds to form a cured film.

12. A method for forming an organic film that functions as an organic flat film used in a process for manufacturing a semiconductor device, comprising:
spin-coating a substrate to be processed with the composition for forming an organic film according to any one of claims 1 to 10; and
heat-treating the substrate coated with the composition for forming an organic film in an atmosphere having an oxygen concentration of 0.1% or more and 21% or less to form a cured film.

13. The method for forming an organic film according to claims 11 or 12, wherein the substrate to be processed is a substrate to be processed having a structure or step with a height of 30 nm or more.

14. A patterning process comprising:
forming an organic film on a body to be processed using the composition for forming an organic film according to any one of claims 1 to 10;
forming a resist middle layer film on the organic film using a resist middle layer film material containing a silicon atom;
forming a resist upper layer film on the resist middle layer film using a resist upper layer film material comprising a photoresist composition;
forming a circuit pattern on the resist upper layer film;
transferring a pattern by etching to the resist middle layer film using the resist upper layer film on which the circuit pattern is formed as a mask;
transferring a pattern by etching to the organic film using the resist middle layer film on which the pattern is transferred as a mask; and
further transferring a pattern by etching to the body to be processed using the organic film on which the pattern is transferred as a mask, or
a patterning process comprising:
forming an organic film on a body to be processed using the composition for forming an organic film according to any one of claims 1 to 10;
forming a resist middle layer film on the organic film using a resist middle layer film material containing a silicon atom;
forming an organic anti-reflection film on the resist middle layer film;
forming a resist upper layer film on the organic anti-reflection film using a resist upper layer film material comprising a photoresist composition;
forming a circuit pattern on the resist upper layer film;
transferring a pattern by etching to the organic anti-reflection film and the resist middle layer film using the resist upper layer film on which the circuit pattern is formed as a mask;
transferring a pattern by etching to the organic film using the resist middle layer film on which the pattern is transferred as a mask; and
further transferring a pattern by etching to the body to be processed using the organic film on which the pattern is transferred as a mask, or
a patterning process comprising:
forming an organic film on a body to be processed using the composition for forming an organic film according to any one of claims 1 to 10;
forming an inorganic hard mask selected from a silicon oxide film, a silicon nitride film, and a silicon oxide nitride film on the organic film;
forming a resist upper layer film on the inorganic hard mask using a resist upper layer film material comprising a photoresist composition;
forming a circuit pattern on the resist upper layer film;
transferring a pattern by etching to the inorganic hard mask using the resist upper layer film on which the circuit pattern is formed as a mask;
transferring a pattern by etching to the organic film using the inorganic hard mask on which the pattern is transferred as a mask; and
further transferring a pattern by etching to the body to be processed using the organic film on which the pattern is transferred as a mask, or
a patterning process comprising:
forming an organic film on a body to be processed using the composition for forming an organic film according to any one of claims 1 to 10;
forming an inorganic hard mask selected from a silicon oxide film, a silicon nitride film, and a silicon oxide nitride film on the organic film;
forming an organic anti-reflection film on the inorganic hard mask;
forming a resist upper layer film on the organic anti-reflection film using a resist upper layer film material comprising a photoresist composition;
forming a circuit pattern on the resist upper layer film;
transferring a pattern by etching to the organic anti-reflection film and the inorganic hard mask using the resist upper layer film on which the circuit pattern is formed as a mask;
transferring a pattern by etching to the organic film using the inorganic hard mask on which the pattern is transferred as a mask; and
further transferring a pattern by etching to the body to be processed using the organic film on which the pattern is transferred as a mask.

15. A patterning process according to claim 14, wherein the inorganic hard mask is formed by a CVD method or an ALD method.
